(19) Europäisches Patentamt
European Patent Office
Office européen des brevets

(11) EP 2 980 876 B1

(12) **EUROPEAN PATENT SPECIFICATION**

(45) Date of publication and mention of the grant of the patent:
**08.05.2019 Bulletin 2019/19**

(21) Application number: **14772912.3**

(22) Date of filing: **28.03.2014**

(51) Int Cl.:
***H01L 51/50*** *(2006.01)*

(86) International application number:
**PCT/JP2014/059096**

(87) International publication number:
**WO 2014/157610 (02.10.2014 Gazette 2014/40)**

(54) **ORGANIC ELECTROLUMINESCENT ELEMENT, LIGHTING DEVICE AND DISPLAY DEVICE**

ORGANISCHES ELEKTROLUMINESZENZELEMENT, BELEUCHTUNGSVORRICHTUNG UND ANZEIGEVORRICHTUNG

ÉLÉMENT ÉLECTROLUMINESCENT ORGANIQUE, DISPOSITIF D'ÉCLAIRAGE ET DISPOSITIF D'AFFICHAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2013 JP 2013072376**

(43) Date of publication of application:
**03.02.2016 Bulletin 2016/05**

(73) Proprietor: **Konica Minolta, Inc.**
**Tokyo 100-7015 (JP)**

(72) Inventors:
- **IKEMIZU, Dai**
  **Tokyo 100-7015 (JP)**
- **TANAKA, Tatsuo**
  **Tokyo 100-7015 (JP)**
- **TAKA, Hideo**
  **Tokyo 100-7015 (JP)**
- **KITA, Hiroshi**
  **Tokyo 100-7015 (JP)**

(74) Representative: **Henkel, Breuer & Partner**
**Patentanwälte**
**Maximiliansplatz 21**
**80333 München (DE)**

(56) References cited:

| | |
|---|---|
| **WO-A1-2009/116414** | **WO-A1-2012/064987** |
| **JP-A- 2004 111 379** | **JP-A- 2010 114 070** |
| **JP-A- 2010 114 429** | **JP-A- 2012 023 127** |
| **JP-A- 2012 144 528** | **JP-A- 2013 008 806** |

- **QISHENG ZHANG ET AL: "Triplet Exciton Confinement in Green Organic Light-Emitting Diodes Containing Luminescent Charge-Transfer Cu(I) Complexes", ADVANCED FUNCTIONAL MATERIALS, WILEY - V C H VERLAG GMBH & CO. KGAA, DE, vol. 22, no. 11, 6 June 2012 (2012-06-06), pages 2327-2336, XP001576526, ISSN: 1616-301X, DOI: 10.1002/ADFM.201101907 [retrieved on 2012-03-19]**
- **DONGDONG ZHANG ET AL: "Highly efficient hybrid warm white organic light-emitting diodes using a blue thermally activated delayed fluorescence emitter: exploiting the external heavy-atom effect", LIGHT: SCIENCE & APPLICATIONS, vol. 4, no. 1, 14 November 2014 (2014-11-14), page e232, XP055303079, DOI: 10.1038/lsa.2015.5**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 980 876 B1

## Description

TECHNICAL FIELD

The present invention relates to an organic electroluminescent element, a lighting device and a display device. In particular, the present invention relates to an organic electroluminescent element, a lighting device and a display device which exhibit improved emission quantum yield, external quantum efficiency, and lifetime.

BACKGROUND ART

Organic electroluminescent (hereinafter referred to as "EL") elements (also referred to as "organic electroluminescence light emitting devices"), which are based on electroluminescence of organic materials, have already been put into practice as a new generation of light-emitting systems capable of planar light emission. Organic EL elements have recently been applied to electronic displays and also to lighting devices. Thus, a demand has arisen for further development of organic EL elements.

A prototype of such an organic EL element, which was composed from a fluorescent material, was published in 1987. In 1998, an organic EL element was published which was formed from a phosphorescent material, and which achieved high emission efficiency by electroluminescence resulting from all singlet excitons and triplet excitons.

Green or red light-emitting phosphorescent organic EL elements have been used in, for example, electronic displays or lighting devices, and materials and techniques used for the elements have been developed in consideration of both emission efficiency and emission lifetime.

Compared to emission of red or green light, emission of blue light requires an increase in triplet energy of a light-emitting material used for the organic EL element; i. e. , an increase in energy level gap between the ground state and the excited state. Thus, the lifetime of the light-emitting element is shortened due to weakening of the molecular structure of the light-emitting material (see, for example, NPL 1).

In addition, the energy gap must be further increased for achieving emission of pure blue light or blue-violet light. Unfortunately, current techniques fail to achieve both shortening of the emission wavelength and prolongation of the lifetime of the light-emitting element, which are in a trade-off relationship.

Traditional light-emitting materials for use in organic EL elements include phosphorescent materials and fluorescent materials. In recent years, new techniques relevant to fluorescent materials have been proposed.

For example, PTL 1 discloses a technique which is focused on a triplet-triplet fusion (TTF) phenomenon wherein singlet excitons are generated by collision and fusion of two triplet excitons, and which improves the emission efficiency of a fluorescent element by allowing the TTF phenomenon to occur effectively. Although this technique can increase power efficiency of a blue-light fluorescent material to two to three times that of a conventional fluorescent material, the emission efficiency is not as high as that of the aforementioned phosphorescent material due to a principle limitation, because the rate of conversion of the excited triplet energy level to the excited singlet energy level is originally 50%.

PTL 2 discloses a technique for improving emission efficiency through use of a copper complex as a delayed fluorescent compound. Unfortunately, the compound exhibits an emission efficiency much lower than that of the aforementioned phosphorescent material, although the compound emits green to red light and provides improved emission efficiency as compared with a conventional fluorescent material.

Recent studies have shown that a thermally activated delayed fluorescent compound (hereinafter also referred to as "TADF compound"), which has an emission mechanism different from that of another delayed fluorescent compound, can be applied to organic EL elements (see, for example, NPLs 2 to 7 and PTLs 3 to 4).

Specifically, PTL 4 discloses an organic EL element capable of emitting white light and comprising a pair of electrodes and a number of organic layers disposed therebetween, wherein said organic layers comprise a green light-emitting layer comprising a thermally activated delayed fluorescent compound, a red light-emitting layer contacting the green light-emitting layer and comprising a phosphorescent metal complex, and a blue light-emitting layer contacting the red light-emitting layer.

The emission mechanism of the TADF compound is characterized by its unique energy diagram illustrated in Fig. 1; i.e., the difference between singlet excited energy level and triplet excited energy level is smaller than that in a common fluorescent material (i.e., $\Delta$Est (TADF) is smaller than $\Delta$Est (F) in Fig. 1). This small energy difference allows fluorescence to occur. Specifically, triplet excitons generated at a probability of 75% upon electrical excitation, which would otherwise fail to contribute to light emission, are transferred to the singlet excited state by heat during operation of the organic EL element. Fluorescence occurs by radiation deactivation (also referred to as "radiation transition" or "radiative deactivation") during transfer from the singlet excited state to the ground state.

Even in this case, some or most of the triplet excitons generated at a probability of 75% would probably be thermally deactivated without intersystem crossing to the singlet, because the triplet excitation energy $T_1$(TADF) is necessarily lower (more stable) than the singlet excitation energy $S_1$(TADF).

As described above, in an organic EL element prepared from such a TADF compound, which is characterized by containing no rare metal (e.g., Ir or Pt), some triplet excitons necessarily remain in principle. Thus, the organic EL element may fail to achieve an emission efficiency comparable to that of a highly efficient organic EL element prepared from a phosphorescent metal complex.

CITATION LIST

Patent Literature

PTL 1: International Patent Application Publication No. WO 2012/133188 A1
PTL 2: International Patent Application Publication No. WO 2011/161425 A1
PTL 3: Japanese Patent Application Publication No. 2011-213643 A
PTL 4: Japanese Patent Application Publication No. 2010-114070 A


Non Patent Literature

NPL 1: "Syoumei ni Muketa Rinkou Yuki EL Gizyutu no Kaihatsu (Development of phosphorescent organic EL technology for lighting)", Oyo Butsuri (Applied Physics), Vol. 80, No. 4, 2011
NPL 2: H. Uoyama, et al., Nature, 2012, 492, 234-238
NPL 3: S. Y. Lee, et al., Applied Physics Letters, 2012, 101, 093306-093309
NPL 4: Q. Zhang, et al., J. Am. Chem. Soc., 2012, 134, 14706-14709
NPL 5: T. Nakagawa, et al., Chem. Commun. , 2012, 48, 9580-9582
NPL 6: A. Endo, et al., Adv. Mater., 2009, 21, 4802-4806
NPL 7: Proceedings of Organic EL Symposium of Japan 10th Meeting, pp. 11-12, 2010


SUMMARY OF INVENTION

PROBLEMS TO BE SOLVED BY INVENTION

The present invention has been attained in consideration of the problems and circumstances described above. An object of the present invention is to provide an organic electroluminescent element exhibiting improved emission efficiency. Another object of the present invention is to provide a lighting device and a display device, each of which includes the organic electroluminescent element.

MEANS FOR SOLVING PROBLEMS

In order to solve the aforementioned problems, the present inventors have studied on a technique for reducing non-radiation deactivation of triplet excitons of a thermally activated delayed fluorescent compound (TADF compound), thereby utilizing the triplet excitons as effective as possible. The present inventors have consequently found that a metal such as iridium or platinum exhibits an external heavy-atom effect on the intersystem crossing of the TADF compound from the triplet excitation state to the singlet excitation state, to enhance fluorescence emission. The present invention has been accomplished on the basis of this finding, and is defined by the claims.

EFFECTS OF INVENTION

The present invention can provide an organic electroluminescent element exhibiting improved emission efficiency. The present invention can also provide a lighting device and a display device, each of which includes the organic electroluminescent element. Further disclosed are a thin light-emitting film for an organic luminescent element, a composition for an organic luminescent element, and a method of emitting light.

The mechanism by which the advantageous effects of the present invention are expressed or operate has not yet been elucidated, but is presumed as follows:

Specifically, the organic electroluminescent element of the present invention includes one or more organic layers, and any of the organic layers contains a thermally activated delayed fluorescent compound (TADF compound) and/or a heavy atom compound which exhibits an external heavy-atom effect of promoting the intersystem crossing of the thermally

activated delayed fluorescent compound from the triplet excitation state to the singlet excitation state and enhancing fluorescence emission. The present inventors have understood that the heavy atom compound exhibits an external heavy-atom effect on the intersystem crossing of the TADF compound from the triplet excitation state to the singlet excitation state, whereby fluorescence emission can be enhanced by triplet excitons remaining in the triplet excitation state, resulting in improvement of emission efficiency.

BRIEF DESCRIPTION OF THE DRAWINGS

Fig. 1 schematically illustrates an energy diagram of a TADF compound used in combination with a phosphorescent metal complex.
Fig. 2 schematically illustrates activation of a TADF compound with a phosphorescent metal complex.
Fig. 3 schematically illustrates energy transfer from a TADF compound to a phosphorescent metal complex.
Fig. 4 conceptually illustrates an increase in emission intensity caused by activation of a TADF compound with a phosphorescent metal complex.
Fig. 5 is a schematic view of a display device including an organic EL element.
Fig. 6 is a schematic view of an active matrix display device.
Fig. 7 is a schematic view of a pixel circuit.
Fig. 8 is a schematic view of a passive matrix display device.
Fig. 9 is a schematic view of a lighting device.
Fig. 10 is a schematic view of a lighting device.

MODES FOR CARRYING OUT THE INVENTION

The organic electroluminescent element of the present invention includes a pair of electrodes and one or more organic layers disposed between the paired electrodes, wherein each of a thermally activated delayed fluorescent compound and a heavy atom compound which exhibits an external heavy-atom effect of promoting the intersystem crossing of the thermally activated delayed fluorescent compound from the triplet excitation state to the singlet excitation state and enhancing fluorescence emission is contained in any of the organic layers.
In an embodiment of the present invention, the thermally activated delayed fluorescent compound and the heavy atom compound are preferably in proximity to each other within a range of a distance in which the external heavy-atom effect is achieved. This configuration enables the external heavy-atom effect of the heavy atom compound to effectively promote the intersystem crossing of the thermally activated delayed fluorescent compound from the triplet excitation state to the singlet excitation state, to enhance fluorescence emission.
In the present invention, the heavy atom compound is a phosphorescent metal complex. This compound enhances the heavy-atom effect on the thermally activated delayed fluorescent compound.
In the present invention, the thermally activated delayed fluorescent compound preferably emits fluorescence, and the phosphorescent metal complex preferably emits phosphorescence. In this case, the organic electroluminescent element can emit light having different wavelengths attributed to fluorescence and phosphorescence.
In the present invention, each of at least one thermally activated delayed fluorescent compound and at least one phosphorescent metal complex is preferably contained in any of the organic layers, and the lowest excited triplet energy level of the thermally activated delayed fluorescent (TADF) compound ($T_1$(TADF)) and the lowest excited triplet energy level of the phosphorescent metal complex (P) ($T_1$(P)) preferably fall within a range in which energy or electrons can be transferred between these levels. In this case, the phosphorescent metal complex (P) can exhibit a heavy-atom effect on the thermally activated delayed fluorescent (TADF) compound, and the phosphorescent metal complex can effectively capture energy of triplet excitons generated at a probability of 75% from the TADF compound, which would otherwise be thermally deactivated.
In the present invention, the difference between the lowest excited singlet energy level of the thermally activated delayed fluorescent compound ($S_1$(TADF)) and the lowest excited triplet energy level of the phosphorescent metal complex ($T_1$(P)) preferably satisfies Expression (1):

$$\text{Expression (1)}: -0.2\ \text{eV} \leq [S_1(\text{TADF}) - T_1(\text{P})] \leq 1.0\ \text{eV}.$$

In this case, the phosphorescent metal complex can exhibit a heavy-atom effect on the thermally activated delayed fluorescent compound without causing dominant energy transfer from the thermally activated delayed fluorescent

compound to the phosphorescent metal complex.

In the present invention, the difference between the lowest excited singlet energy level of the thermally activated delayed fluorescent compound ($S_1$(TADF)) and the lowest excited triplet energy level of the phosphorescent metal complex ($T_1$(P)) preferably satisfies Expression (2):

$$\text{Expression (2): } 0 \text{ eV} \leq [S_1(\text{TADF}) - T_1(\text{P})] \leq 0.2 \text{ eV.}$$

In this case, the phosphorescent metal complex can further exhibit a heavy-atom effect on the thermally activated delayed fluorescent compound without causing dominant energy transfer from the thermally activated delayed fluorescent compound to the phosphorescent metal complex.

In the present invention, the difference between the lowest excited triplet energy level of the thermally activated delayed fluorescent compound ($T_1$(TADF)) and the lowest excited triplet energy level of the phosphorescent metal complex ($T_1$(P)) preferably satisfies Expression (3):

$$\text{Expression (3): } -0.2 \text{ eV} \leq [T_1(\text{TADF}) - T_1(\text{P})] \leq 0.5 \text{ eV.}$$

In this case, the phosphorescent metal complex can exhibit a heavy-atom effect on the thermally activated delayed fluorescent compound without causing dominant energy transfer from the thermally activated delayed fluorescent compound to the phosphorescent metal complex. In addition, the phosphorescent metal complex can effectively capture energy of triplet excitons generated at a probability of 75% from the TADF compound, which would otherwise be thermally deactivated.

In the present invention, the difference between the lowest excited triplet energy level of the thermally activated delayed fluorescent compound ($T_1$(TADF)) and the lowest excited triplet energy level of the phosphorescent metal complex ($T_1$(P)) preferably satisfies Expression (4):

$$\text{Expression (4): } 0 \text{ eV} \leq [T_1(\text{TADF}) - T_1(\text{P})] \leq 0.1 \text{ eV.}$$

In this case, the phosphorescent metal complex can exhibit a heavy-atom effect on the thermally activated delayed fluorescent compound without causing dominant energy transfer from the thermally activated delayed fluorescent compound to the phosphorescent metal complex. In addition, the phosphorescent metal complex can further effectively capture energy of triplet excitons generated at a probability of 75% from the thermally activated delayed fluorescent compound, which would otherwise be thermally deactivated.

In the present invention, the lowest excited triplet energy level of the thermally activated delayed fluorescent compound ($T_1$(TADF)) preferably falls within a range of 2.4 to 3.5 eV. In this case, the phosphorescent metal complex, which is represented by Formula (I), can exhibit a heavy-atom effect on the thermally activated delayed fluorescent compound, which emits blue to blue-green light. In addition, the phosphorescent metal complex can effectively capture energy of triplet excitons generated at a probability of 75% from the thermally activated delayed fluorescent compound, which would otherwise be thermally deactivated.

In the present invention, the thermally activated delayed fluorescent compound and the phosphorescent metal complex are contained in a single light-emitting layer. By this means, the phosphorescent metal complex can further exhibit an external heavy-atom effect of promoting the intersystem crossing of the thermally activated delayed fluorescent compound from the triplet excitation state to the singlet excitation state and enhancing fluorescence emission.

In the present invention, the phosphorescent metal complex preferably has a structure represented by Formula (I):

[F2]

Formula(I)

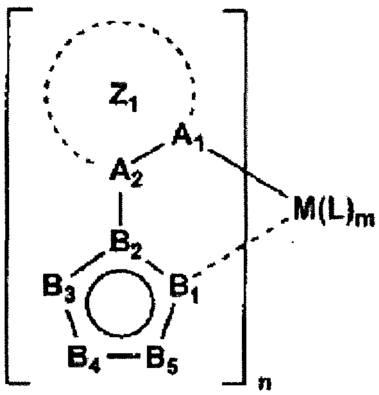

wherein M represents Ir, Pt, Rh, Ru, Ag, Cu, or Os, $A_1$ and $A_2$ each represent a carbon or nitrogen atom, $Z_1$ represents a 6-membered aromatic hydrocarbon ring or 5- or 6-membered aromatic heterocyclic ring including $A_1$ and $A_2$, $B_1$ to $B_5$ are atoms forming a 5-membered aromatic heterocyclic group, each of which represents a carbon, nitrogen, oxygen, or sulfur atom optionally having a substituent, the ring $Z_1$ optionally has one or more substituents optionally forming a condensed ring structure, ligands are optionally linked together through bonding of substituents of the ligands, L represents a monoanionic bidentate ligand coordinating to M, m represents an integer of 0 to 2, n represents an integer of 1 to 3, m+n is 2 or 3, and, if m or n is 2 or more, the ring $Z_1$, the aromatic heterocyclic group represented by $B_1$ to $B_5$, and L are identical to or different from one another.

The phosphorescent metal complex has a relatively high quantum yield and excellent stability. If the phosphorescent metal complex is in proximity to the TADF compound, the phosphorescent metal complex exhibits a heavy-atom effect on the TADF compound, and can effectively capture energy of triplet excitons generated at a probability of 75% from the TADF compound, which would otherwise be thermally deactivated.

The organic electroluminescent element of the present invention is preferably provided in a lighting device. The resultant lighting device exhibits improved emission efficiency.

The organic electroluminescent element of the present invention is preferably provided in a display device. The resultant display device exhibits improved emission efficiency.

The thin light-emitting film for an organic luminescent element disclosed herein contains two or more light-emitting materials having different emission modes. The light-emitting materials preferably include a thermally activated delayed fluorescent compound and a phosphorescent metal complex. Even if the thin light-emitting film is used not in an organic EL element, but in a photoluminescent element, the phosphorescent metal complex exhibits an external heavy-atom effect on the TADF compound, and thus the TADF compound probably exhibits a high quantum yield.

The composition for an organic luminescent element disclosed herein contains two or more light-emitting materials having different emission modes. The light-emitting materials preferably include a thermally activated delayed fluorescent compound and a phosphorescent metal complex. In this composition, the phosphorescent metal complex exhibits a heavy-atom effect on the thermally activated delayed fluorescent compound, and can effectively capture energy of triplet excitons generated at a probability of 75% from the thermally activated delayed fluorescent compound, which would otherwise be thermally deactivated. The composition can be used for preparation of a thin film or light emitting layer exhibiting a high quantum yield or external extraction quantum yield.

The method of emitting light disclosed herein preferably includes causing a thermally activated delayed fluorescent compound to emit fluorescence and causing a phosphorescent metal complex to emit phosphorescence in a single organic luminescent element by physical or chemical action. This method can generally increase a quantum yield and an external extraction quantum yield by phosphorescence emitted from the phosphorescent metal complex in addition to fluorescence emitted from the thermally activated delayed fluorescent compound.

The present invention, the contexture thereof, and embodiments and aspects for implementing the present invention will now be described in detail.

As used herein, the term "to" between two numerical values indicates that the numeric values before and after the term are inclusive as the lower limit value and the upper limit value, respectively.

<Principle and energy level of thermally activated delayed fluorescence>

Now will be described the relationship between the energy level of a TADF compound and that of a phosphorescent metal complex.

In a fluorescent compound, such as a TADF compound, singlet-singlet transition or triplet-triplet transition is allowed, and the rate constant thereof is generally large, whereas singlet-triplet transition or triplet-singlet transition is forbidden, and the rate constant thereof is small; i.e., the transition is less likely to occur.

In contrast, in a phosphorescent metal complex, radiation deactivation from the singlet excitation state to the ground state (i.e., fluorescence) is not observed, and radiation deactivation from the triplet excitation state to the ground state (i.e., phosphorescence) occurs at high efficiency and high rate. This phenomenon is attributed to the heavy-atom effect of a transition metal (e.g., iridium or platinum) present at the center of the complex.

This heavy-atom effect is observed not only in a single molecule (internal heavy-atom effect), but also in proximate molecules (external heavy-atom effect).

Specifically, as schematically illustrated in Fig. 2, the presence of a phosphorescent metal complex in proximity to a TADF compound accelerates inverse intersystem crossing ($T_1$(TADF) $\rightarrow$ $S_1$(TADF)) by thermal activation (i.e., the main mechanism of the TADF compound), leading to promotion of thermally activated delayed fluorescence (TADF).

In the absence of the phosphorescent metal complex, the residual triplet excitons which have not undergone inverse intersystem crossing or radiation deactivation undergo non-radiation deactivation accompanied with heat release. The presence of the phosphorescent metal complex causes energy transfer from $T_1$(TADF) to $T_1$(P), resulting in phosphorescence. This energy transfer, which corresponds to allowed triplet-triplet transition, occurs quickly unless the energy levels of $T_1$(TADF) and $T_1$(P) are inverted.

In this case, $T_1$(P) is not required to be lower than $T_1$(TADF), because the triplet-triplet transition is allowed. Even if $T_1$(P) is equal to or slightly higher than $T_1$(TADF), this energy transfer occurs, and the phosphorescent metal complex emits phosphorescence. The difference between $T_1$(P) and $T_1$(TADF) is preferably 0 to 0.5 eV, particularly preferably 0 to 0.2 eV. An energy difference falling within this range can achieve both fluorescence from the TADF compound and phosphorescence from the phosphorescent metal complex, which is an essential feature of the present invention.

The material capable of exhibiting the external heavy-atom effect may be any phosphorescent metal complex containing an element of the sixth and subsequent periods of the periodic table. Preferred is a phosphorescent metal complex containing at least one of Ir, Pt, Rh, Ru, Ag, Cu, and Os. Particularly preferred is a phosphorescent metal complex containing at least one of Os, Pt, Ir, and Au.

The phosphorescent metal complex is most preferably a complex which emits phosphorescence at room temperature (about 25°C) . The use of an organic compound which readily interacts with the TADF compound is important for achieving the external heavy-atom effect. Another important factor is coupling of spins in the singlet excitation state and the triplet excitation state (spin orbit interaction) by the internal heavy-atom effect. Phosphorescence at room temperature is still another important factor for effective conversion of the thermal deactivation energy from the excited triplet state of the TADF compound into phosphorescence.

The phosphorescent metal complex, which is used in combination with the TADF compound, may have any emission wavelength within the aforementioned preferred range as long as the emission wavelength longer than that of the TADF compound, from the viewpoint of the energy transfer from $T_1$(TADF) to $T_1$(P). For example, substantially white light may be obtained through simultaneous emission of both blue fluorescence from the TADF compound and orange phosphorescence from the phosphorescent metal complex. Also, blue light may be generally obtained through emission of pure blue light (shorter wavelength) from the TADF compound and emission of light-blue light (longer wavelength) from the phosphorescent metal complex. Thus, causing the thermally activated delayed fluorescent compound to emit fluorescence and causing the phosphorescent metal complex to emit phosphorescence by physical or chemical action in a single organic luminescent element is one method of emitting light.

If the energy level $T_1$ of the phosphorescent metal complex falls within the aforementioned preferred range, the TADF compound and the phosphorescent metal complex may be used in any combination. In particular, current technology requires emission of blue light having high intensity and long lifetime and containing a short-wavelength component for increasing the color reproduction area of an electronic display or enhancing the color temperature of a lighting device. From the industrial viewpoint, the most effective technique for satisfying such a requirement involves emission of pure blue to violet-blue light from the TADF compound and emission of light-blue light from the phosphorescent metal complex, which is present together with the TADF compound.

[Lowest excited singlet energy $S_1$(TADF)]

In the present invention, the lowest excited singlet energy S1 of the TADF compound may be determined by a common technique. Specifically, a target compound is deposited onto a quartz substrate to prepare a sample, and an absorption spectrum of the sample is measured at ambient temperature (300 K) (vertical axis: absorbance, horizontal axis: wavelength). A tangential line is drawn at the rising point of the absorption spectrum on the longer wavelength side, and the lowest excited singlet energy is calculated by a specific conversion expression on the basis of the wavelength at the point of intersection of the tangential line with the horizontal axis. The TADF compound used in the present

invention is likely to cause molecular aggregation, and thus a thin film prepared from the compound may cause a measurement error due to molecular aggregation. In the present invention, the lowest excited singlet energy is determined from, as an approximation, the peak wavelength of emission of a solution of the TADF compound at room temperature (about 25°C) in consideration of a relatively small Stokes shift of the TADF compound and a very small change in structure of the compound between the excited state and the ground state. This determination process may use a solvent which is less likely to affect the molecular aggregation of the TADF compound; for example, a non-polar solvent, such as cyclohexane or toluene.

In order to achieve thermally activated delayed fluorescence (TADF) from the TADF compound, the absolute value of $\Delta$Est ($S_1$(TADF) - $T_1$(TADF)) is preferably 1.0 eV or less, more preferably 0.5 eV or less. The value $\Delta$Est is a very significant factor for thermally activated delayed fluorescence, because it is directly linked to the probability of inverse intersystem crossing ($T_1$(TADF) $\rightarrow$ $S_1$(TADF)) by thermal activation, which is the main mechanism of the TADF compound.

Because the lowest excited singlet energy of the TADF compound is necessarily higher than the lowest excited triplet energy thereof, the difference between the lowest excited singlet energy of the TADF compound and the lowest excited triplet energy of the phosphorescent metal complex [$S_1$(TADF) - $T_1$(P)] is necessarily larger than [$T_1$(TADF) - $T_1$(P)]. [$S_1$(TADF) - $T_1$(P)]is defined as the sum of $\Delta$Est [$S_1$(TADF) - $T_1$(TADF)] and [$T_1$(TADF) - $T_1$(P)].

Thus, if $\Delta$Est is preferably 0.5 eV or less and [$T_1$(TADF) - $T_1$(P)]is preferably 0.5 eV or less, [$S_1$(TADF) - $T_1$(P)] is preferably 1.0 eV or less. [$S_1$(TADF) - $T_1$(P)]preferably satisfies the following expression: -0.2 eV $\leq$ [$S_1$(TADF) - $T_1$(P)]$\leq$ 1.0 eV, particularly preferably the following expression: 0 eV $\leq$ [$S_1$(TADF) - $T_1$(P)] $\leq$ 0.2 eV. If [$S_1$(TADF) - $T_1$(P)] falls within the above range, the presence of the phosphorescent metal complex in proximity to the TADF compound accelerates inverse intersystem crossing ($T_1$(TADF) $\rightarrow$ $S_1$(TADF)) by thermal activation (i.e., the main mechanism of the TADF compound), leading to promotion of thermally activated delayed fluorescence.

[Lowest excited triplet energy $T_1$(TADF)]

The lowest excited triplet energy of the TADF compound is determined on the basis of the photoluminescent (PL) properties of a solution or thin film of the compound. For example, a thin film is prepared from a dilute dispersion of the TADF compound, and the transient PL properties of the thin film are determined with a streak camera for separation of a fluorescent component and a phosphorescent component, to determine the energy difference $\Delta$Est therebetween. The lowest excited triplet energy of the TADF compound can be calculated on the basis of the lowest excited singlet energy. The temperature dependence of the TADF compound may also be used. For example, the lowest excited triplet energy can be determined directly on the basis of main luminescence at a low temperature (8.5 K) because luminescence occurs mainly from the lowest excited triplet energy at the low temperature.

[Lowest excited triplet energy $T_1$(P)]

In the present invention, the lowest excited triplet energy $T_1$(P) of the phosphorescent metal complex is determined as follows . Specifically, a target compound is dissolved in a solvent to prepare a sample, and a phosphorescence spectrum of the sample is measured at a low temperature (77 K) (vertical axis: phosphorescence intensity, horizontal axis: wavelength). A tangential line is drawn at the rising point of the phosphorescence spectrum on the shorter wavelength side, and the lowest excited triplet energy level is calculated by a specific conversion expression ($E \approx 1240/\lambda$ [eV], where $\lambda$ represents a wavelength [nm]) on the basis of the wavelength at the point of intersection of the tangential line with the horizontal axis.

For determination of the lowest excited triplet energy level, the absolute PL quantum yield was determined with an absolute PL Quantum yield measuring apparatus C9920-02 (manufactured by Hamamatsu Photonics K.K.). The emission lifetime was determined with a streak camera C4334 (manufactured by Hamamatsu Photonics K.K.) under excitation of the sample with a laser beam.

Now will be described the lower limit of the energy $T_1$ of the phosphorescent metal complex. Fig. 3 schematically illustrates energy transfer from the TADF compound to the phosphorescent metal complex.

As described above, the lowest excited triplet energy ($T_1$(P)) has no lower limit in principle, because energy transfer necessarily occurs if the lowest excited triplet energy ($T_1$(P)) of the phosphorescent metal complex is lower than the lowest excited triplet energy ($T_1$(TADF)) of the coexisting TADF compound. In practice, if the difference ($\Delta$Et($P_1$)) is 0.5 eV or less, energy transfer occurs from the TADF compound to the phosphorescent metal complex at an optimal rate. Thus, all the triplet excitons of the TADF compound are transferred to the phosphorescent metal complex without intersystem crossing to the singlet excitons, to facilitate the original TADF phenomenon.

For the above-described reasons, the lowest excited triplet energy levels ($T_1$) of the TADF compound and the phosphorescent metal complex preferably satisfy the following expression:

$$-0.2\ eV \leq [T_1(TADF) - T_1(P)] \leq 0.5\ eV$$

in view of simultaneous emission from both these compounds.

On the basis of studies, the present inventors have found that the lowest excited triplet energy levels ($T_1$) of the TADF compound and the phosphorescent metal complex preferably satisfy the following expression:

$$0\ eV \leq [T_1(TADF) - T_1(P)] \leq 0.1\ eV$$

for simultaneous emission of both short-wavelength blue light from the TADF compound and light-blue light from the phosphorescent metal complex.

In order to effectively achieve the aforementioned emission mechanism, the TADF compound and the phosphorescent metal complex are provided in proximity to each other. Specifically, the TADF compound and the phosphorescent metal complex are provided within a distance required for energy transfer (external heavy-atom effect) therebetween. For the case of energy transfer by the Dexter mechanism, the TADF compound and the phosphorescent metal complex are preferably provided within a distance of 0.3 to 1 nm. For the case of energy transfer by the Foerster mechanism, the TADF compound and the phosphorescent metal complex are preferably provided within a distance of 1 to 10 nm. In the former case, the TADF compound and the phosphorescent metal complex must be incorporated in a single layer. In the latter case, the TADF compound and the phosphorescent metal complex are preferably incorporated in two adjacent layers, respectively, or in a single layer.

In the present invention, the TADF compound and the phosphorescent metal complex are incorporated in a single layer, so that they are in proximity to each other within a range of a distance in which the external heavy-atom effect is achieved.

In the present invention, the phosphorescent metal complex is used in an amount such that the phosphorescent metal complex is in proximity to the TADF compound for exhibiting an external heavy-atom effect on the TADF compound. In view of the probability of energy transfer attributed to the difference between the triplet energy of the TADF compound and that of the phosphorescent metal complex, the phosphorescent metal complex is used in an amount of 0.05 mass% to 25 mass%, preferably 0.05 mass% to 5.0 mass%, most preferably 0.05 mass% to 1.0 mass%, relative to the entire amount of the TADF compound. In particular, the phosphorescent metal complex is preferably used in an amount A or less represented by the following expression with respect to ($T_1$(TADF) - $T_1$(P)):

$$\text{A (amount (mass\%) of the phosphorescent metal complex relative to that of the TADF compound)} = 17-\{20\times(T_1(TADF) - T_1(P))\}.$$

Specifically, if the difference [$T_1$(TADF) - $T_1$(P)] is large; i.e., the difference between the lowest excited triplet energy of the TADF compound and that of the phosphorescent metal complex is large, energy transfer easily occurs from the lowest excited triplet energy level of the TADF compound to that of the phosphorescent metal complex. In this case, the amount of the phosphorescent metal complex is preferably small so as not to inhibit the intersystem crossing of the TADF compound. In contrast, if the difference ($T_1$(TADF) - $T_1$(P)) is large; i.e., the difference between the lowest excited triplet energy of the TADF compound and that of the phosphorescent metal complex is small, the amount of the phosphorescent metal complex is preferably relatively large, because the lowest excited triplet energy level of the TADF compound easily mixes with that of the phosphorescent metal complex.

In the case of preparation of an organic EL element containing the TADF compound and the phosphorescent metal complex, the amount of the phosphorescent metal complex may be represented by "vol%" for the sake of convenience.

Fig. 4 conceptually illustrates an increase in emission intensity caused by activation of the TADF compound with the phosphorescent metal complex. Fig. 4 illustrates a mechanism by which the emission intensity increases in the case where the TADF compound and the phosphorescent metal complex are present in appropriate amounts such that energy or electrons are transferrable therebetween, and these compounds satisfy the following expression: -0.2 eV ≤ [$S_1$(TADF) - $T_1$(P)] ≤ 1.0 eV or -0.2 eV ≤ [$T_1$(TADF) - $T_1$(P)] ≤ 0.5 eV.

Specifically, the intersystem crossing from the excited triplet energy level to the excited singlet energy level of the TADF compound (shown by a broken line) is enhanced by the phosphorescent metal complex (see Fig. 2).

If the phosphorescent metal complex compensates for a component thermally deactivated from the excited triplet energy level of the TADF compound, the intensity of fluorescence from the TADF compound is higher than that

of light emitted only by the TADF compound, and both fluorescence and phosphorescence can be obtained.

Although the embodiments described above correspond to the case where the present invention is applied to an organic EL element, electric field excitation is not a necessary condition for the present invention. For example, the present invention is a phenomenon which appears also by photoexcitation, electromagnetic excitation, or thermal excitation.

Incorporation of the TADF compound and the phosphorescent metal complex in a single system is preferred for achieving both fluorescence from the TADF compound and phosphorescence from the phosphorescent metal complex. Thus, the present invention includes the case of using a composition for an organic luminescent element containing both the TADF compound and the phosphorescent metal complex.

Each of the TADF compound and the phosphorescent metal complex may aggregate to generate a new stable energy level lower than the original energy level both in the triplet states and singlet states. In such a case, the present invention may fail to exhibit its advantageous effects. Thus, the composition may optionally contain an additional component, such as a binder or a host compound, in combination with the TADF compound and the phosphorescent metal complex. In a preferred embodiment, the composition contains such an additional component.

<TADF compound>

The thermally activated delayed fluorescent compound (TADF compound) used in the present invention is characterized as follows:

(1) the TADF compound has an emission lifetime on the order of microseconds at room temperature (298 K);
(2) the TADF compound has an emission wavelength at room temperature (298 K) shorter than that at a low temperature (77 K) ;
(3) the TADF compound has an emission lifetime at room temperature (298 K) significantly shorter than that at a low temperature (77 K); and
(4) the TADF compound exhibits an enhanced emission intensity with an increase in temperature.

As described in NPLs 2 to 7, the TADF compound is also characterized by a very small difference $\Delta$Est (TADF) between the lowest excited singlet energy level and the lowest excited triplet energy level. The energy level difference falls within an acceptable range of 0 to 1.0 eV, and preferably satisfies the following expression: 0 eV $\leq$ $\Delta$Est (TADF) $\leq$ 0.5 eV. Optimization of the structure of the TADF compound can minimize a conformational change between the ground state and the excited state or between the singlet excitation state and the triplet excitation state, leading to a reduction in non-radiation deactivation (Knr), resulting in an improvement in quantum yield.

A TADF compound, whose lowest excited energy varies with wavelength, can be appropriately selected depending on the intended use. For example, if a phosphorescent metal complex emitting lights together with a TADF compound emits sky-blue light, a TADF compound which emits light-green to deep-blue light; i.e., a TADF compound having a lowest excited energy level ($S_1$(TADF)) of 2.4 to 3.5 eV, is preferably used.

Examples of preferred thermally activated delayed fluorescent compounds used in the present invention include, but are not limited to, the following compounds.

[F3]

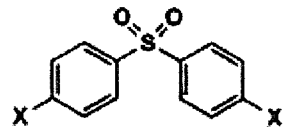

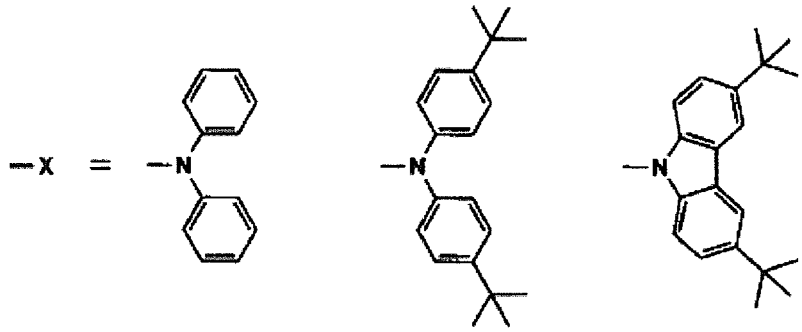

TADF−1 TADF−2 TADF−3

[F4]

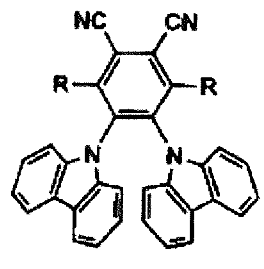

4CzPN : R=carbazolyl
2CzPN : R=H

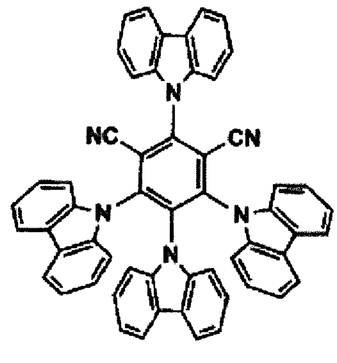

4CzIPN

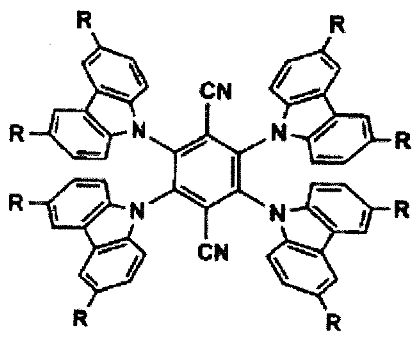

4CzTPN : R=H
4CzTPN−Me : R=Me
4CzTPN−Ph : R=Ph

[F5]

**[spiro−CN]**

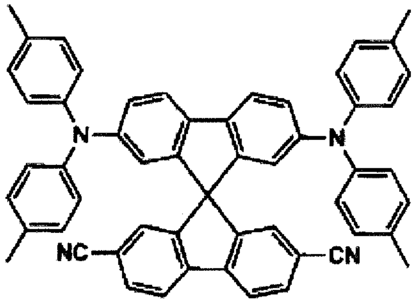

**$[Cu(\mu\text{-}I)dppb]_2$**

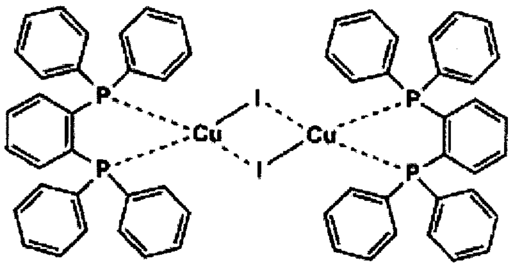

**$[Cu(dnbp)(DPEPhos)]BF_4$**

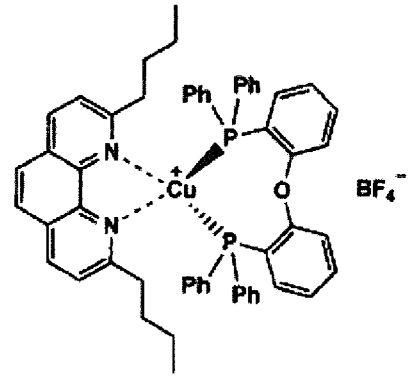

[F6]

**[CC2TA]**

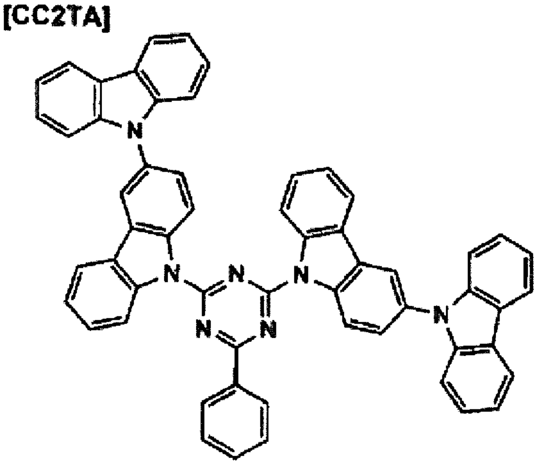

[F7]

$SnF_2$—Copro III

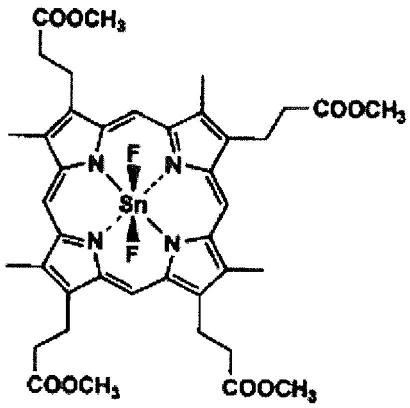

$SnF_2$—Meso IX

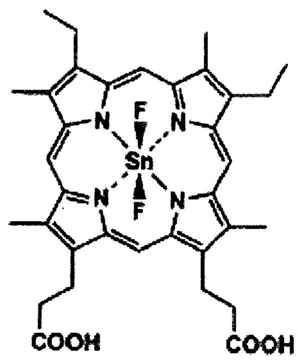

$SnF_2$—Hemato IX

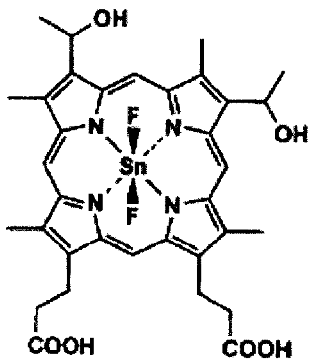

$SnF_2$—Proto IX

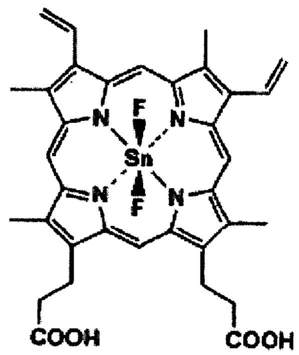

$SnF_2$—OEP

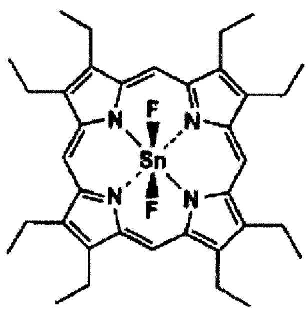

$SnF_2$—Etio I

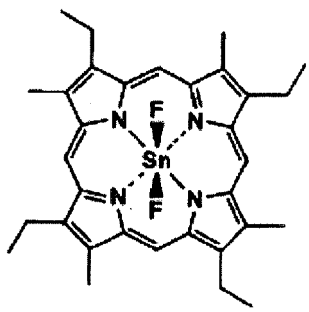

<Phosphorescent metal complex>

The phosphorescent metal complex preferably used in the present invention is represented by Formula (I).

[F8]

Formula(I)

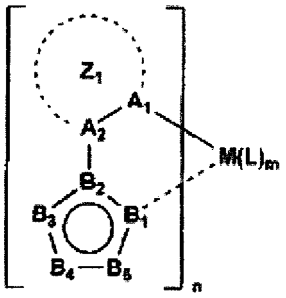

In Formula (I), M represents Ir, Pt, Rh, Ru, Ag, Cu, or Os. $A_1$ and $A_2$ each represent a carbon or nitrogen atom. $Z_1$ represents a 6-membered aromatic hydrocarbon ring or 5- or 6-membered aromatic heterocyclic ring including $A_1$ and $A_2$. $B_1$ to $B_5$ are atoms forming a 5-membered aromatic heterocyclic group, each of which represents a carbon, nitrogen, oxygen, or sulfur atom optionally having a substituent. The ring $Z_1$ optionally has one or more substituents optionally forming a condensed ring structure. Ligands are optionally linked together through bonding of substituents of the ligands. L represents a monoanionic bidentate ligand coordinating to M. In Formula (I), m represents an integer of 0 to 2, n represents an integer of 1 to 3, and m+n is 2 or 3. If m or n is 2 or more, the ring $Z_1$, the aromatic heterocyclic group represented by $B_1$ to $B_5$, and L are identical to or different from one another.

In Formula (I), $Z_1$ represents a 6-membered aromatic hydrocarbon ring or 5- or 6-membered aromatic heterocyclic ring including $A_1$ and $A_2$. Examples of the 5- or 6-membered aromatic heterocyclic ring formed by Z include rings of benzene, naphthalene, pyridine, pyrimidine, pyrrole, thiophene, pyrazole, imidazole, oxazole, and thiazole. Of these, preferred is a benzene ring.

The ring $Z_1$ may have one or more substituents, and the two substituents may together form a condensed ring structure.

In the phosphorescent metal complex represented by Formula (I), the ring $Z_1$ may have a substituent. Examples of the substituent include alkyl groups (e.g., methyl, ethyl, propyl, isopropyl, tert-butyl, pentyl, hexyl, octyl, dodecyl, tridecyl, tetradecyl, and pentadecyl), cycloalkyl groups (e.g., cyclopentyl and cyclohexyl), alkenyl groups (e.g., vinyl and allyl), alkynyl groups (e.g., ethynyl and propargyl), aromatic hydrocarbon groups (also referred to as aromatic carbon groups or aryl groups, such as phenyl, p-chlorophenyl, mesityl, tolyl, xylyl, naphthyl, anthryl, azulenyl, acenaphthenyl, fluorenyl, phenanthryl, indenyl, pyrenyl, and biphenylyl), aromatic heterocyclic groups (e.g., pyridyl, pyrimidinyl, furyl, pyrrolyl, imidazolyl, benzimidazolyl, pyrazolyl, pyrazinyl, and triazolyl (e.g., 1,2,4-triazol-1-yl and 1,2,3-triazol-1-yl), oxazolyl, benzoxazolyl, thiazolyl, isoxazolyl, isothiazolyl, furazanyl, thienyl, quinolyl, benzofuryl, dibenzofuryl, benzothienyl, dibenzothienyl, indolyl, carbazolyl, carbolinyl, diazacarbazolyl (a group wherein one of the carbon atoms forming the carboline ring of the carbolinyl group is substituted by a nitrogen atom), quinoxalinyl, pyridazinyl, triazinyl, quinazolinyl, and phthalazinyl), heterocyclic groups (e.g., pyrrolidyl, imidazolidyl, morpholyl, and oxazolidyl), alkoxy groups (e.g., methoxy, ethoxy, propyloxy, pentyloxy, hexyloxy, octyloxy, and dodecyloxy), cycloalkoxy groups (e.g., cyclopentyloxy and cyclohexyloxy), aryloxy groups (e.g., phenoxy and naphthyloxy), alkylthio groups (e.g., methylthio, ethylthio, propylthio, pentylthio, hexylthio, octylthio, and dodecylthio), cycloalkylthio groups (e.g., cyclopentylthio and cyclohexylthio), arylthio groups (e.g., phenylthio and naphthylthio), alkoxycarbonyl groups (e.g., methyloxycarbonyl, ethyloxycarbonyl, butyloxycarbonyl, octyloxycarbonyl, and dodecyloxycarbonyl), aryloxycarbonyl groups (e.g., phenyloxycarbonyl and naphthyloxycarbonyl), sulfamoyl groups (e.g., aminosulfonyl, methylaminosulfonyl, dimethylaminosulfonyl, butylaminosulfonyl, hexylaminosulfonyl, cyclohexylaminosulfonyl, octylaminosulfonyl, dodecylaminosulfonyl, phenylaminosulfonyl, naphthylaminosulfonyl, and 2-pyridylaminosulfonyl), acyl groups (e.g., acetyl, ethylcarbonyl, propylcarbonyl, pentylcarbonyl, cyclohexylcarbonyl, octylcarbonyl, 2-ethylhexylcarbonyl, dodecylcarbonyl, phenylcarbonyl, naphthylcarbonyl, and pyridylcarbonyl), acyloxy groups (e.g., acetyloxy, ethylcarbonyloxy, butylcarbonyloxy, octylcarbonyloxy, dodecylcarbonyloxy, and phenylcarbonyloxy), amido groups (e.g., methylcarbonylamino, ethylcarbonylamino, dimethylcarbonylamino, propylcarbonylamino, pentylcarbonylamino, cyclohexylcarbonylamino, 2-ethyhexylcarbonylamino, octylcarbonylamino, dodecylcarbonylamino, phenylcarbonylamino, and naphthylcarbonylamino), carbamoyl groups (e.g., aminocarbonyl, methylaminocarbonyl, dimethylaminocarbonyl, propylaminocarbonyl, pentylaminocarbonyl, cyclohexylaminocarbonyl, octylaminocarbonyl, 2-ethylhexylaminocarbonyl, dodecylaminocarbonyl, phenylaminocarbonyl, naphthylaminocarbonyl, and 2-pyridylaminocarbonyl), ureido groups (e.g., methylureido, ethylureido, pentylureido, cyclohexylureido, octylureido, dodecylureido, phenylureido, naphthylureido, and 2-pyridylaminoureido), sulfinyl groups (e.g., methylsulfinyl, ethylsulfinyl, butylsulfinyl, cyclohexylsulfinyl, 2-ethylhexylsulfinyl, dodecylsulfinyl, phenylsulfinyl, naphthylsulfinyl, and 2-pyridylsulfinyl), alkylsulfonyl groups (e.g., methylsulfonyl, ethylsulfonyl, butylsulfonyl, cyclohexylsulfonyl, 2-ethylhexylsulfonyl, and dodecylsulfonyl), arylsulfonyl and heteroarylsulfonyl groups (e.g., phenylsulfonyl, naphthylsulfonyl, and 2-pyridylsulfonyl), amino groups (e.g., amino, ethylamino, dimethylamino, butylamino, cyclopentylamino, 2-ethylhexylamino,

dodecylamino, anilino, naphthylamino, and 2-pyridylamino), a cyano group, a nitro group, a hydroxy group, a mercapto group, and silyl groups (e.g., trimethylsilyl, triisopropylsilyl, triphenylsilyl, and phenyldiethylsilyl). Of these substituents, preferred are alkyl groups and aryl groups.

$B_1$ to $B_5$ each represent a carbon, nitrogen, oxygen, or sulfur atom, and at least one of $B_1$ to $B_5$ represents a nitrogen atom. These five atoms preferably form a nitrogen-containing aromatic heteromonocyclic ring. Examples thereof include rings of pyrrole, pyrazole, imidazole, triazole, tetrazole, oxazole, isoxazole, thiazole, isothiazole, oxadiazole, and thiadiazole. Of these, preferred are a pyrazole ring and an imidazole ring, and particularly preferred is an imidazole ring in which $B_2$ and $B_5$ are nitrogen atoms. Such a ring may further have any of the aforementioned substituents. The substituent is preferably an alkyl group or an aryl group, more preferably an aryl group.

L represents a monoanionic bidentate ligand coordinating to M. Specific examples of the monoanionic bidentate ligand represented by L include substituted or unsubstituted phenylpyridine, phenylpyrazole, phenylimidazole, phenyltriazole, phenyltetrazole, pyrazabole, picolinic acid and acetylacetone. Such a ligand may further have any of the aforementioned substituents.

In Formula (I), m represents an integer of 0 to 2, n represents an integer of 1 to 3, and m+n is 2 or 3. In particular, m is preferably 0.

Examples of the metal element represented by M include transition metal elements (also referred to simply as "transition metals") belonging to Groups 8 to 10 of the periodic table, such as Ir, Pt, Rh, Ru, Ag, Cu, and Os. Of these, preferred are iridium and platinum, and more preferred is iridium.

The aromatic heterocyclic ring formed by $B_1$ to $B_5$ in Formula (I) is preferably any of the following rings represented by Formulae (Ia), (Ib), and (Ic).

[F9]

Formula(Ia)

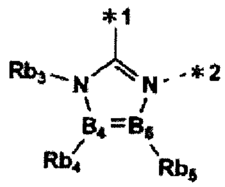

Formula(Ib)

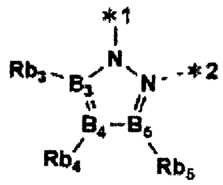

Formula(Ic)

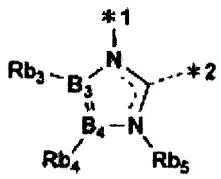

In Formula (Ia), (Ib), or (Ic), *1 represents a site at which the ring is bonded to $A_2$, and *2 represents a site at which the ring is bonded to M.

$Rb_3$ to $Rb_5$ each represent a hydrogen atom or a substituent. Examples of the substituent represented by $Rb_3$ to $Rb_5$ include those which may be provided on the ring $Z_1$ in Formula (I) .

In Formula (Ia), $B_4$ and $B_5$ each represent a carbon or nitrogen atom, and at least one of $B_4$ and $B_5$ is more preferably a carbon atom.

In Formula (Ic), $B_3$ and $B_4$ each represent a carbon or nitrogen atom, and at least one of $B_3$ and $B_4$ is more preferably a carbon atom.

Examples of the phosphorescent metal complex used in the present invention and represented by Formulae (I), (Ia), (Ib), and (Ic) include, but are not limited to, the following compounds.

[F10]

P-1

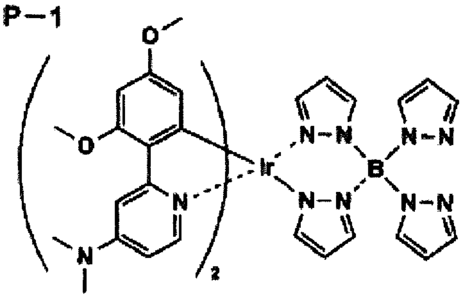

P-2

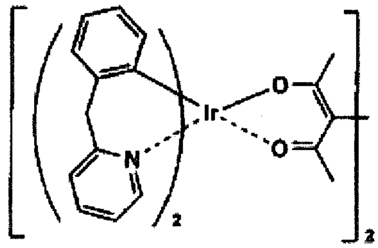

P-3

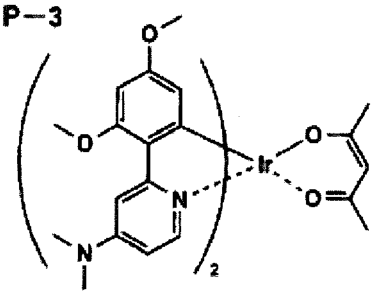

P-4

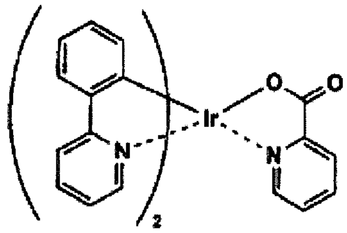

P-5

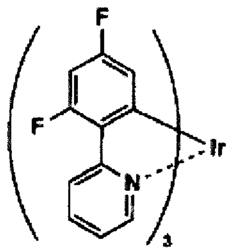

P-6

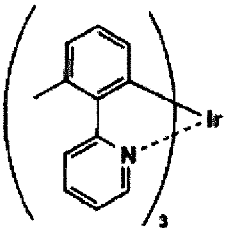

P-7 (FIr(pic))

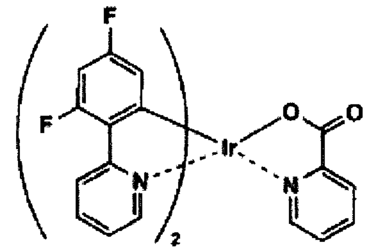

P-8

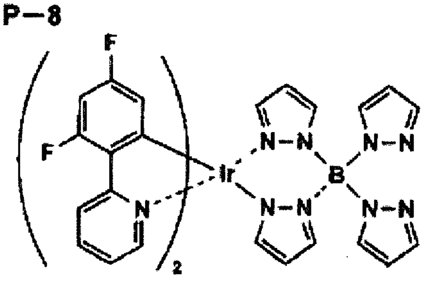

P-9 ($Ir(piq)_3$)

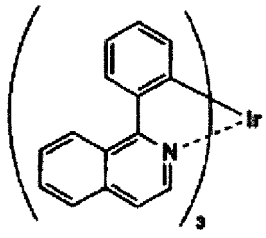

P-10 ($Ir(ppy)_3$)

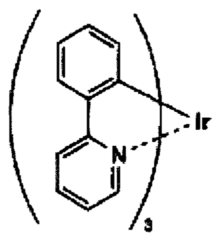

[F11]

P-11

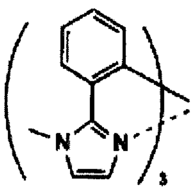

P-12

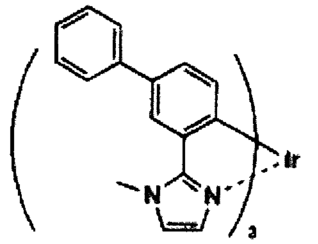

P-13

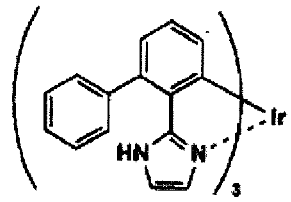

P-14

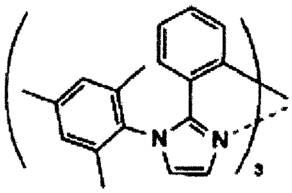

P-15

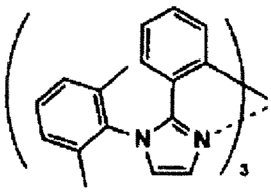

P-16

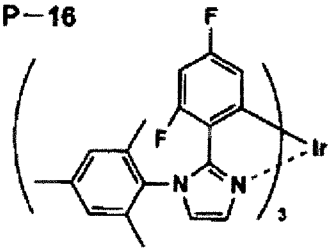

P-17

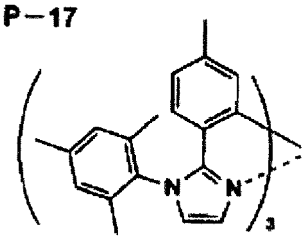

P-18

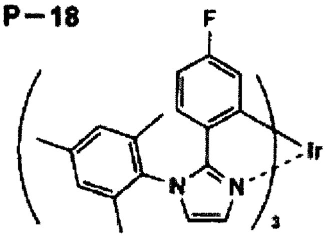

P-19

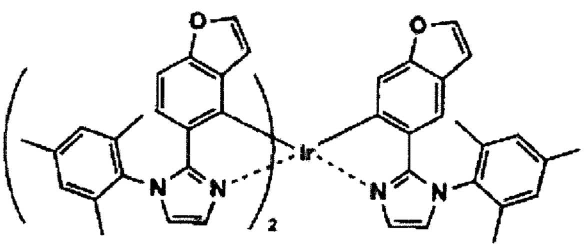

P-20

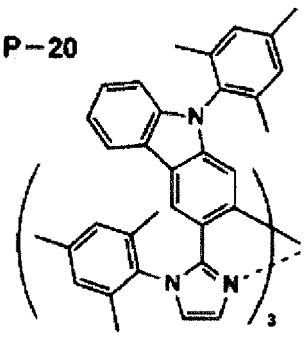

P-21

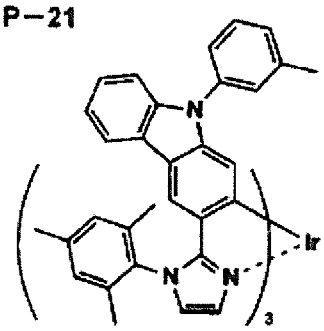

P-22

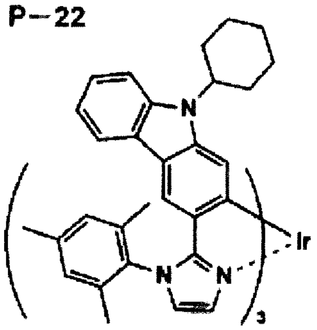

P-23

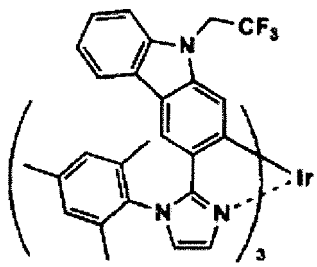

[F12]

P-24

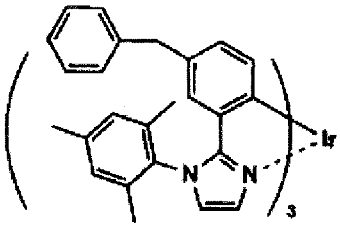

P-25

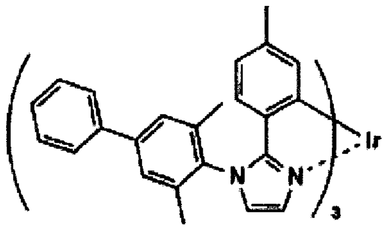

P-26

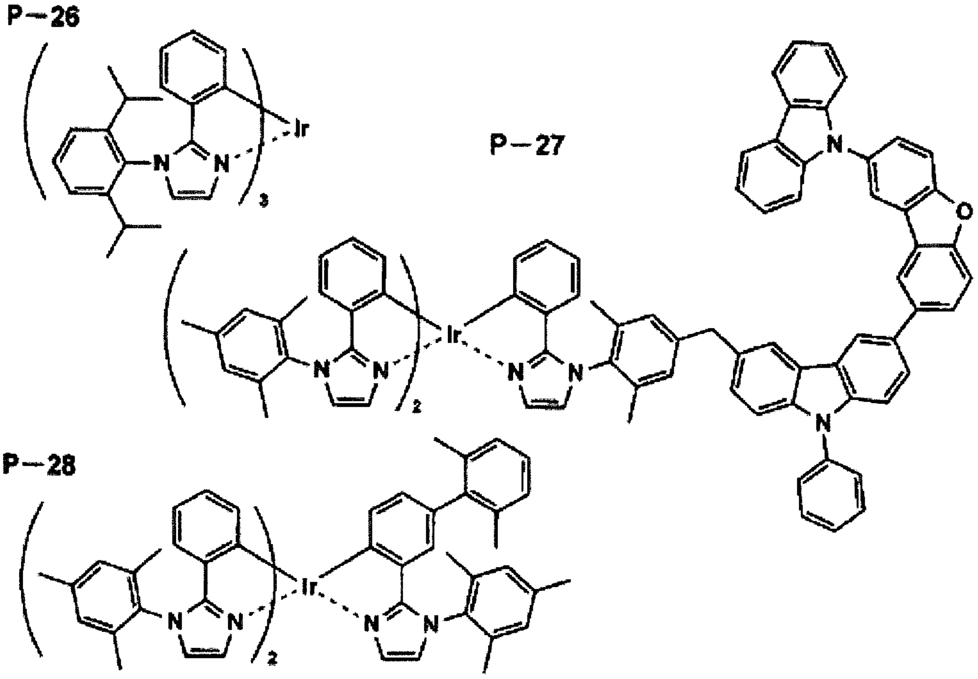

P-27

P-28

P-29

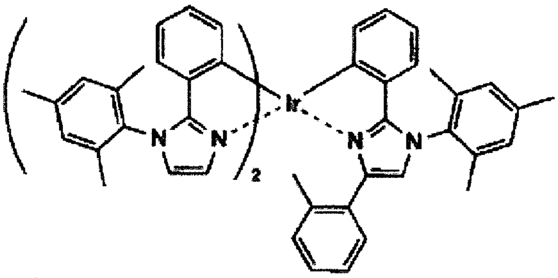

P-30

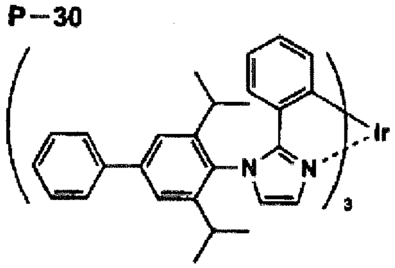

P-31

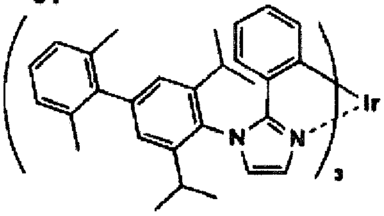

P-32

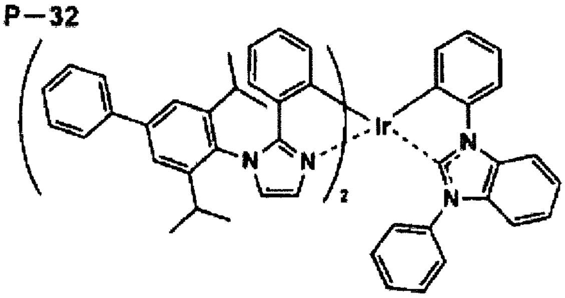

[F13]

P-33

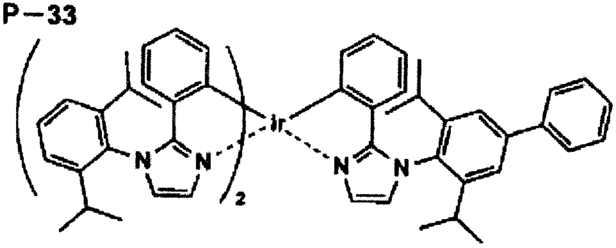

P-34

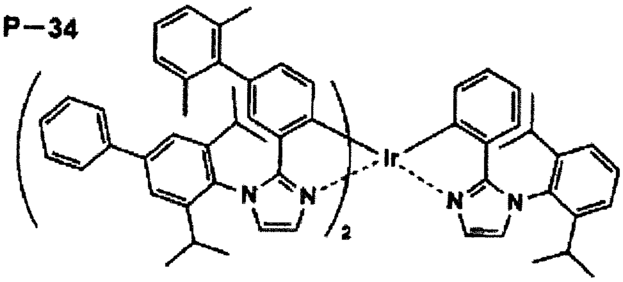

P-35

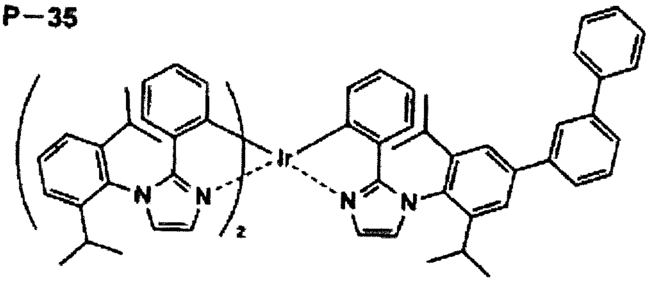

P-36

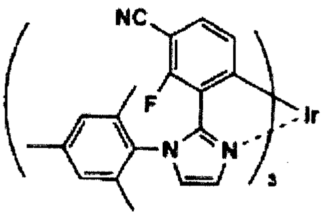

P-37

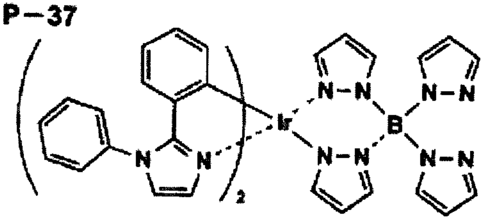

P-38

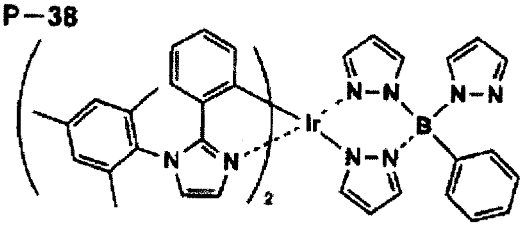

P-39

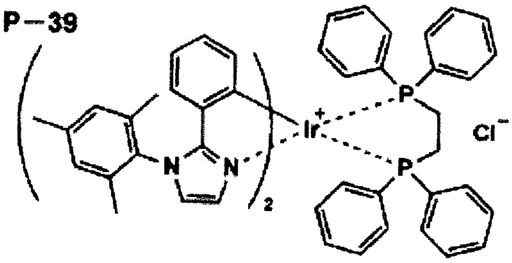

P-40

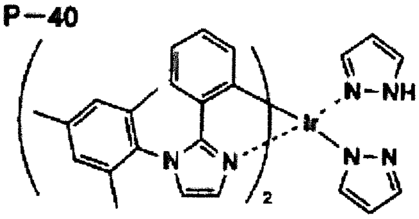

[F14]

P-41

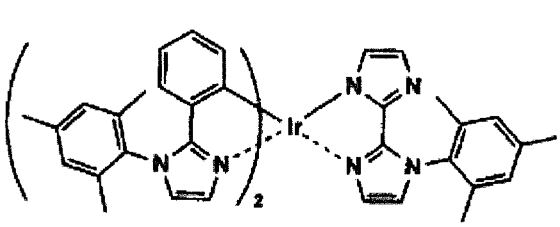

P-42

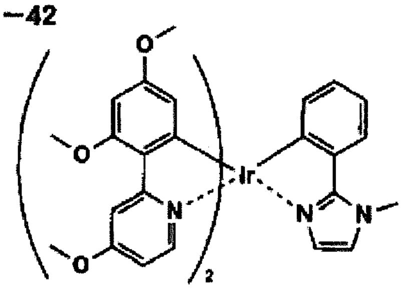

P-43

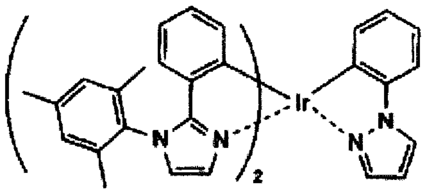

P-44

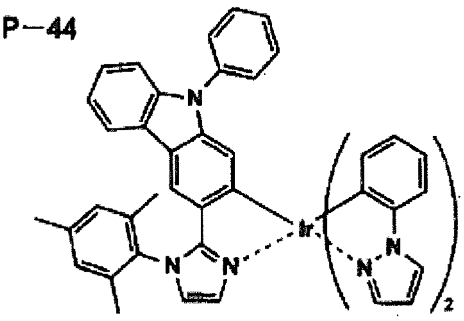

P-45

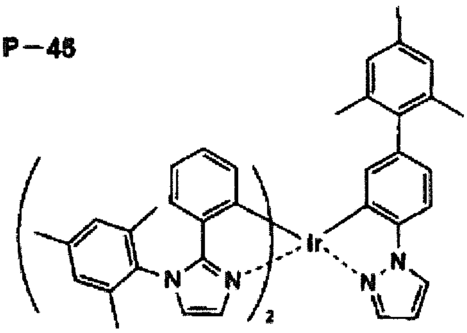

P-46

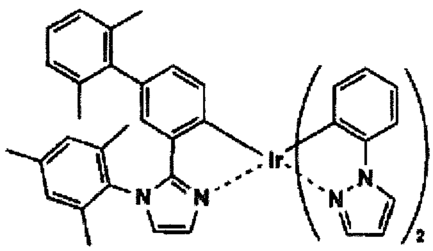

P-47

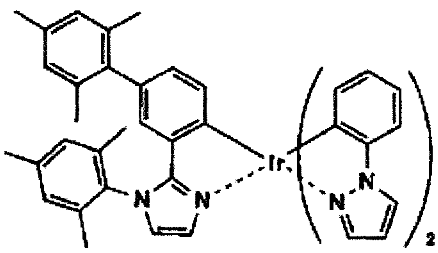

P-48

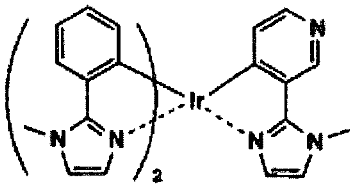

P-49

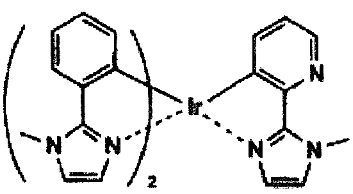

P-50

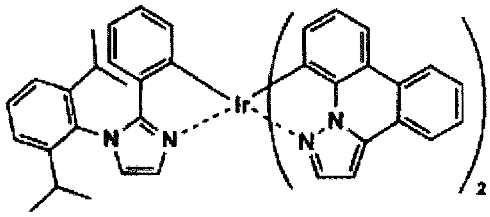

[F15]

P-51

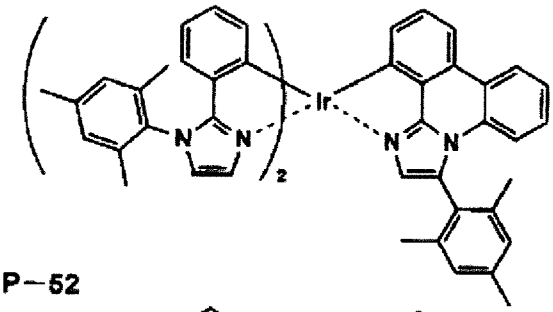

P-52

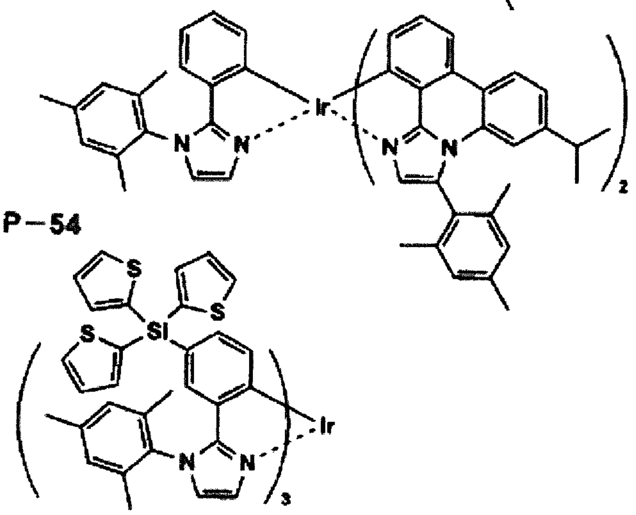

P-53

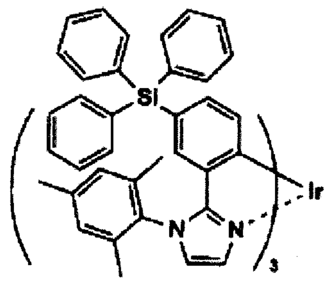

P-54

P-55

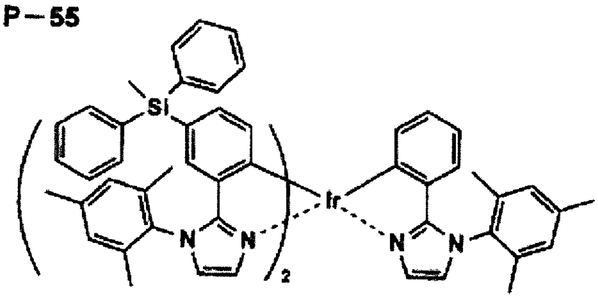

P-56

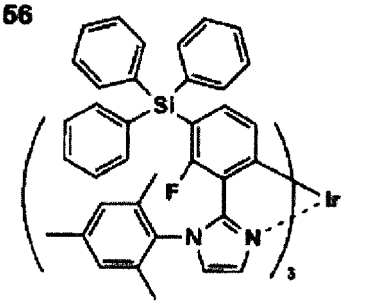

P-57

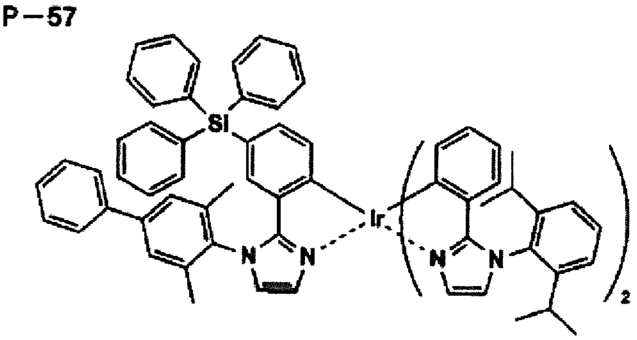

[F16]

P-58

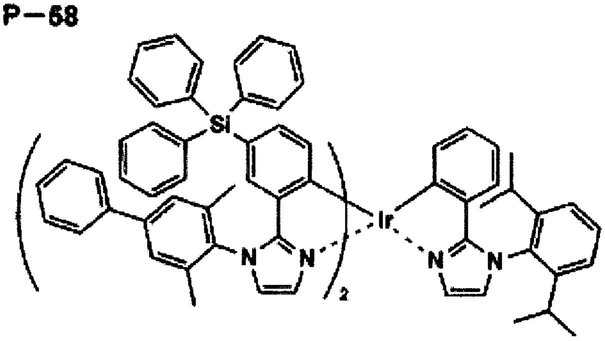

P-59

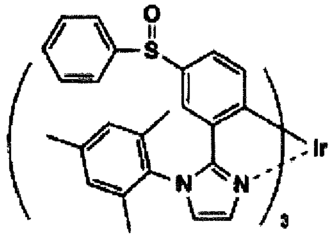

P-60

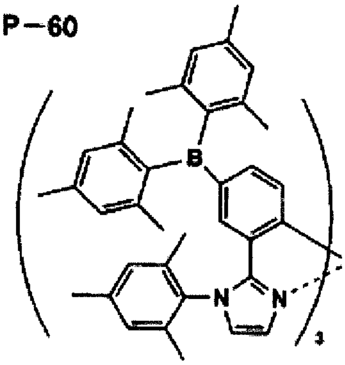

P-61

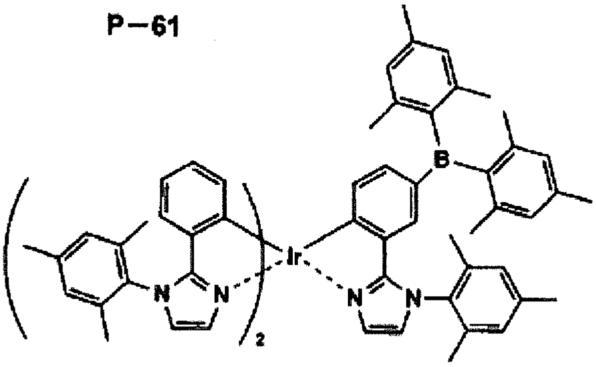

P-62

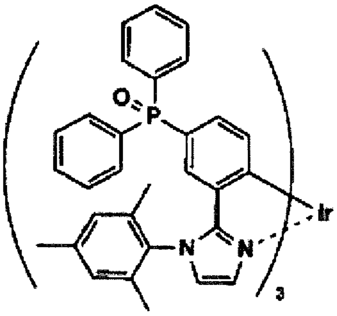

P-63

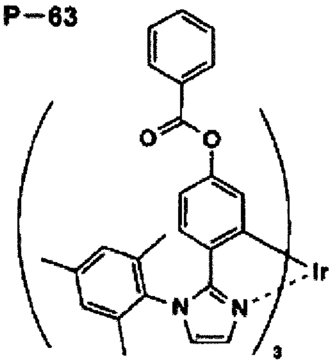

P-64

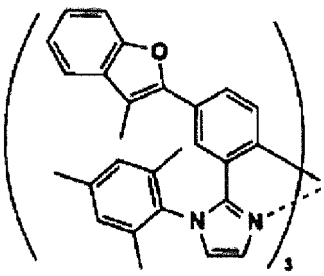

P-65

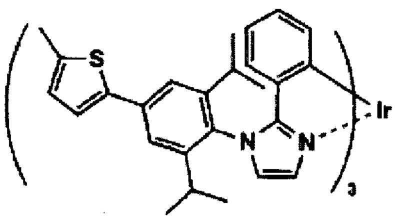

[F17]

P-66

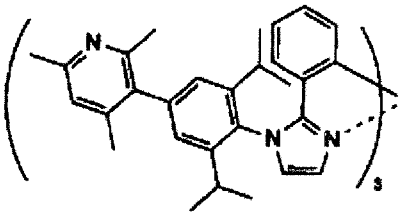

P-67

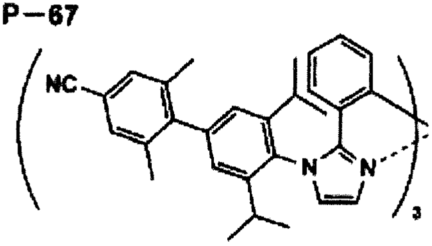

P-68

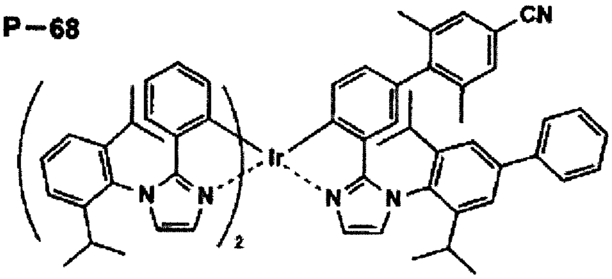

P-69

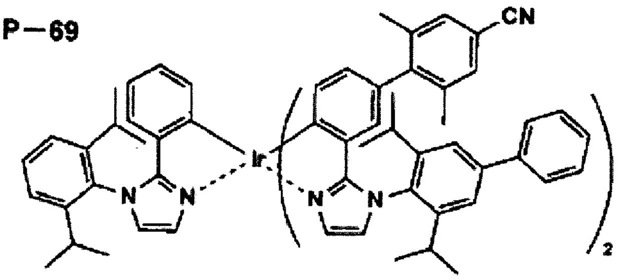

P-70

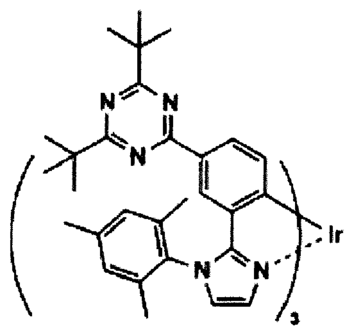

P-71

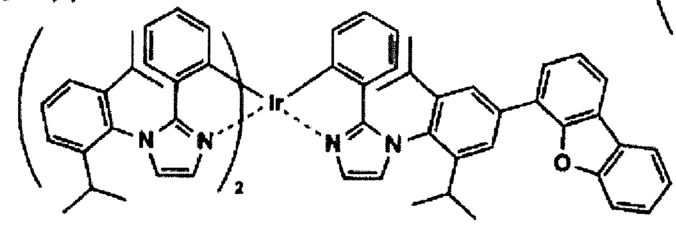

P-72

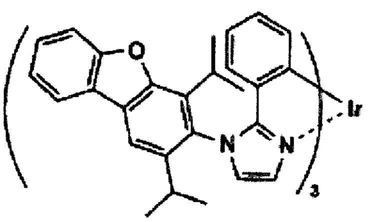

P-73

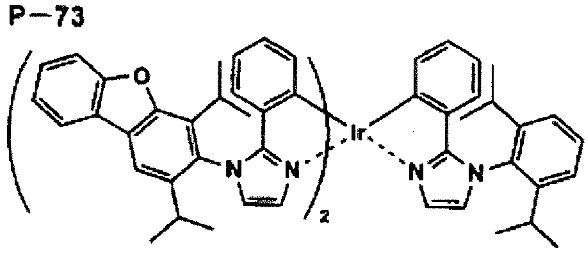

[F18]

P-74

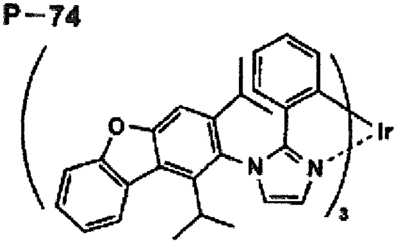

P-75

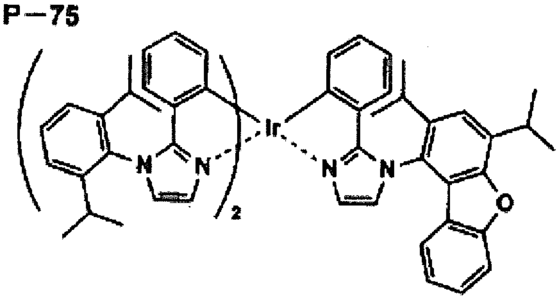

P-76

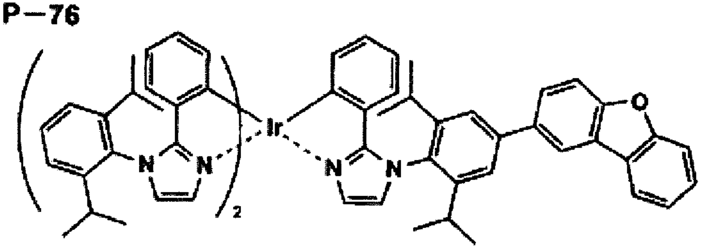

P-77

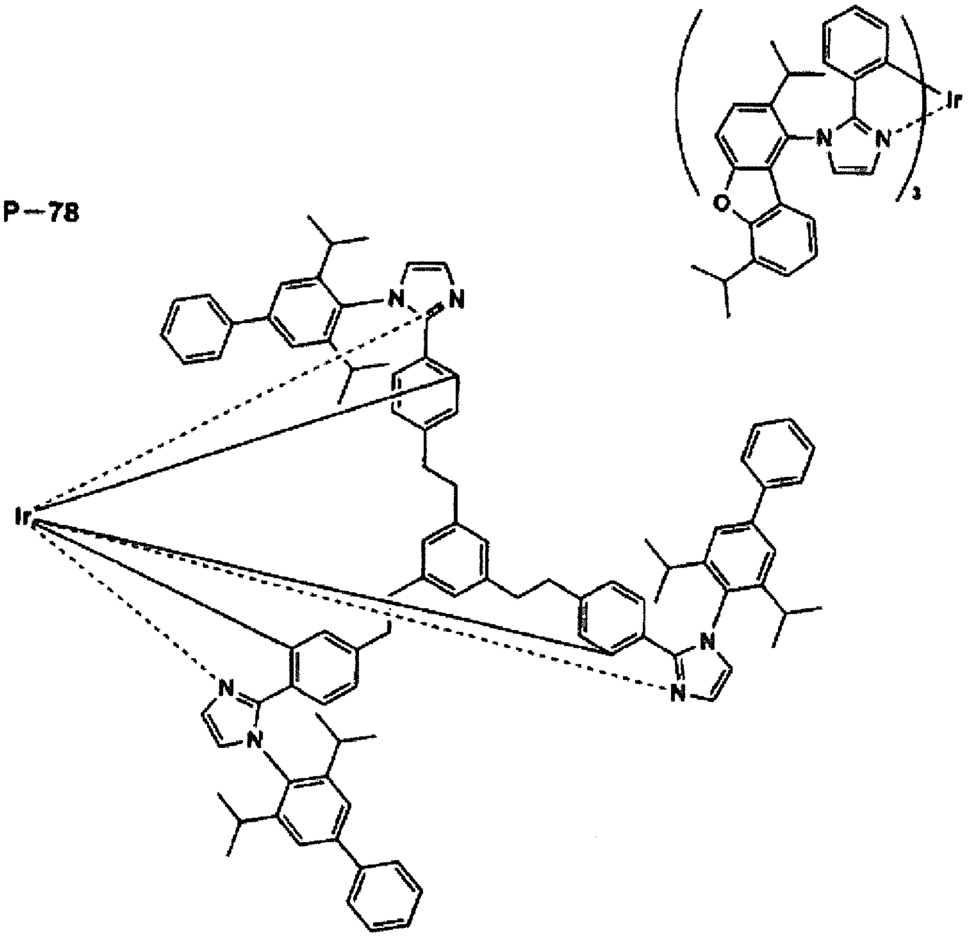

P-78

[F19]

P-79

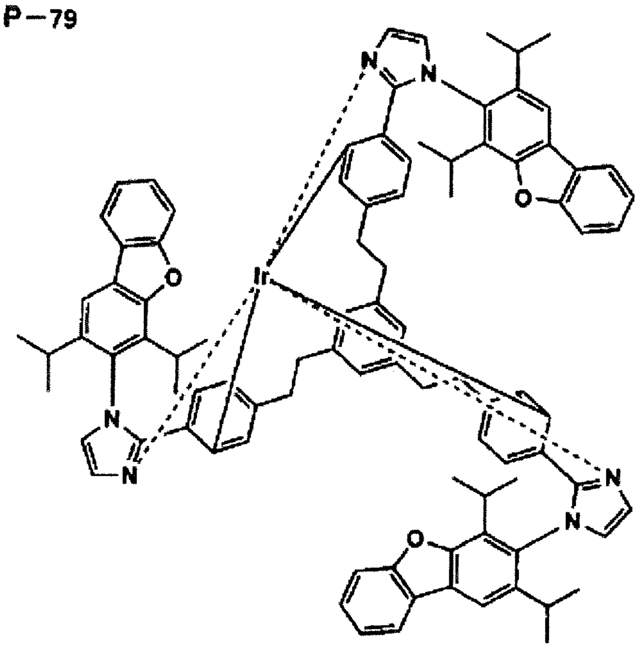

P-80

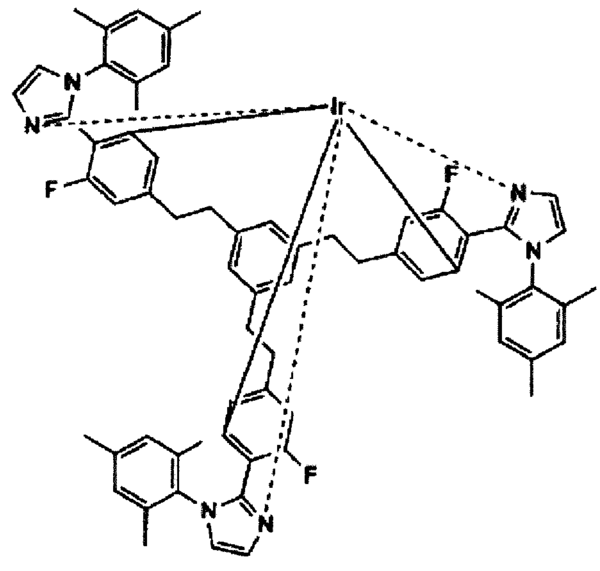

[F20]

P-81

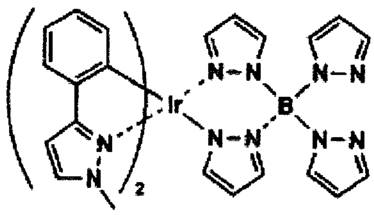

P-82

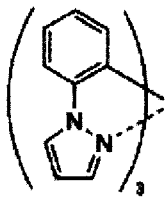

P-83

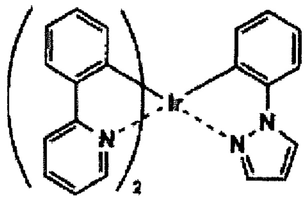

P-84

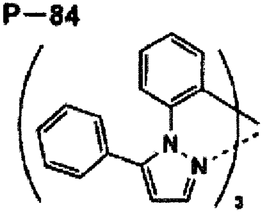

P-85

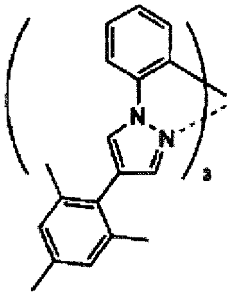

P-86

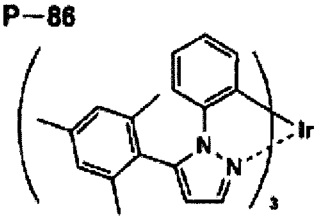

P-87

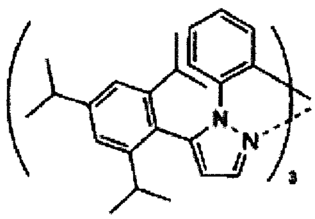

P-88

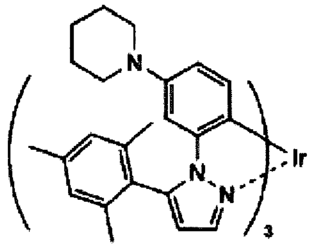

P-89

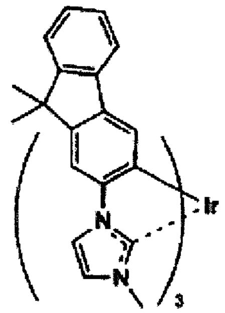

P-90

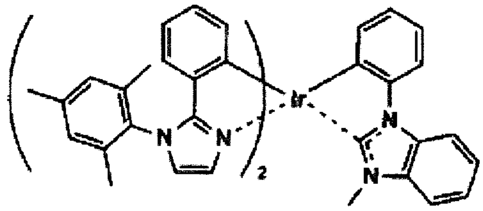

P-91

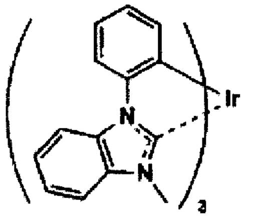

P-92

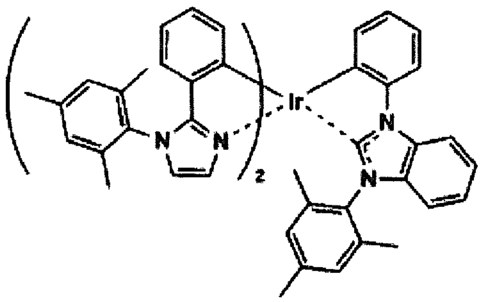

P-93

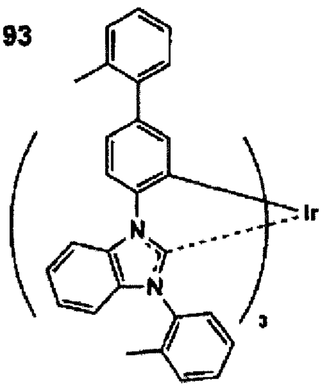

[F21]

P-94

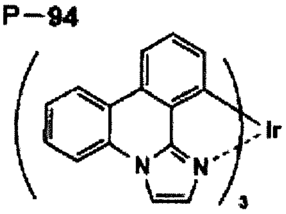

P-95

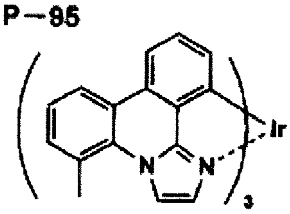

P-96

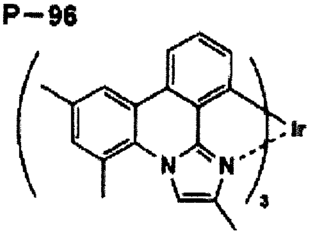

P-97

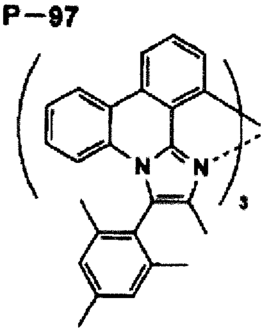

P-99

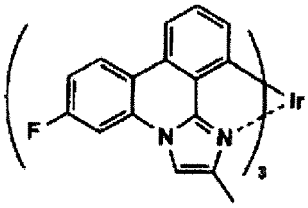

P-100

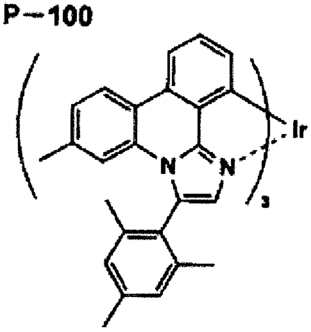

P-101

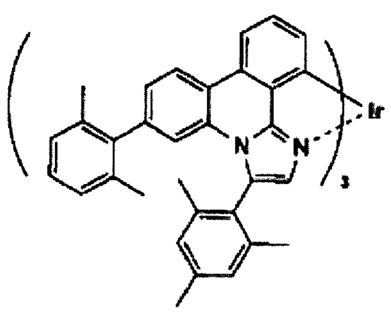

P-102

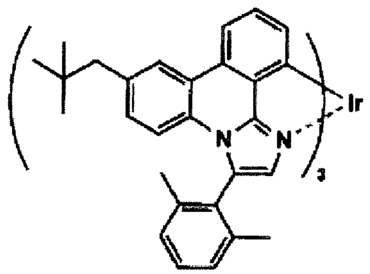

P-103

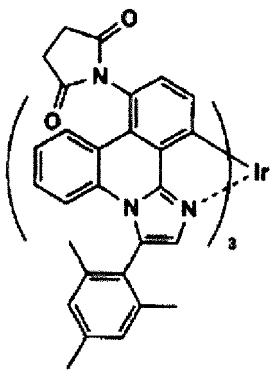

P-104

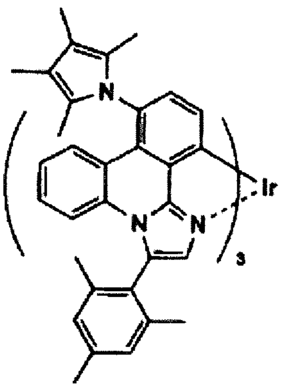

P-105

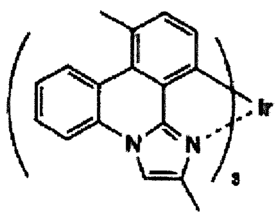

[F22]

P-106

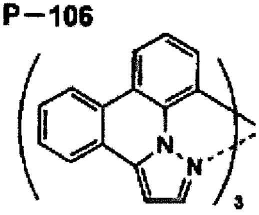

P-107

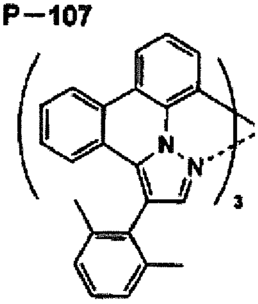

P-108

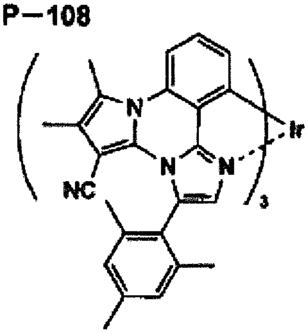

P-109

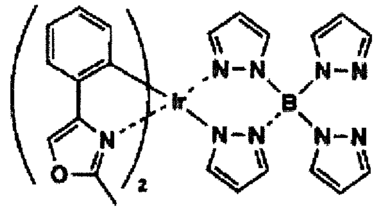

P-110

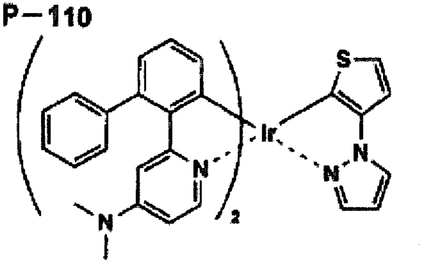

P-111

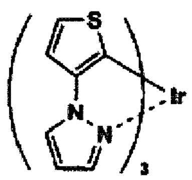

P-112

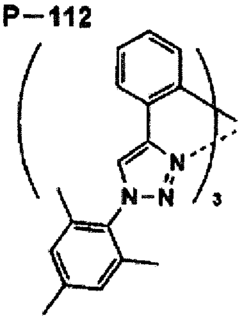

P-113

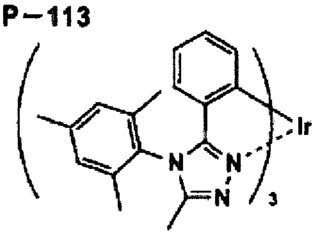

P-114

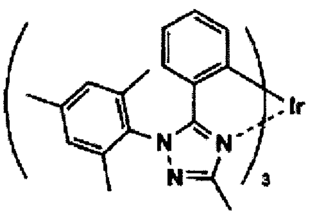

P-115

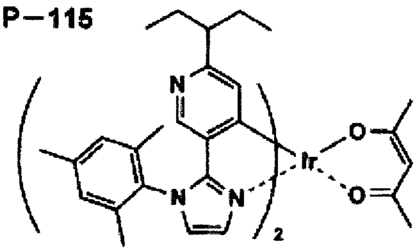

P-116

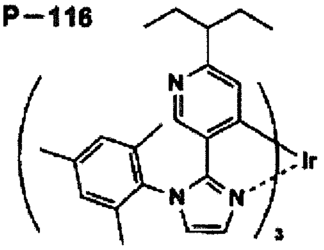

[F23]

P−117

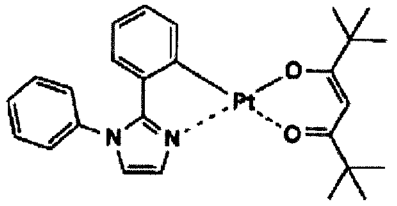

P−118

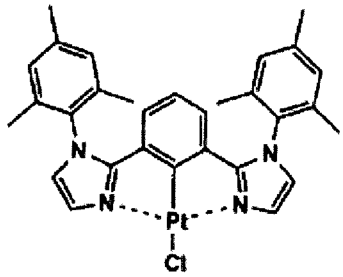

P−119

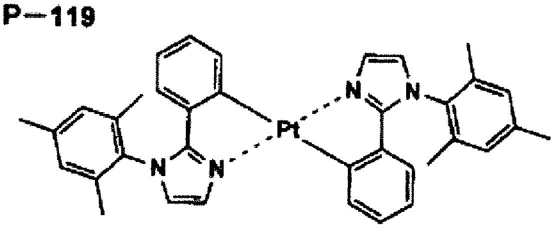

P−120

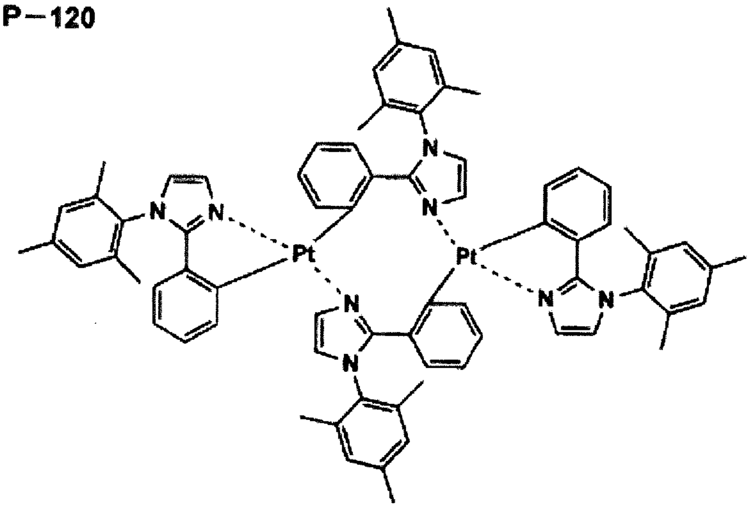

P−121

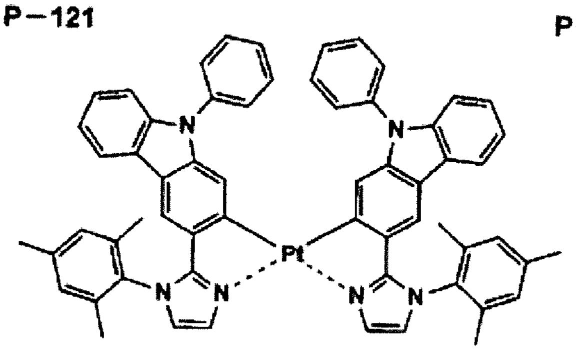

P−122

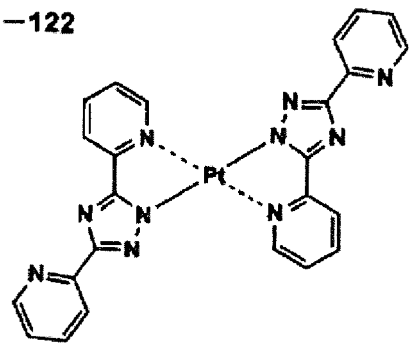

[F24]

P－123

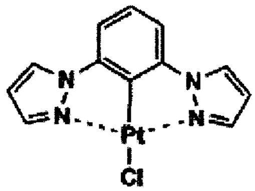

P－124

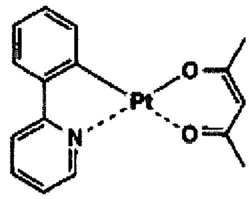

P－125

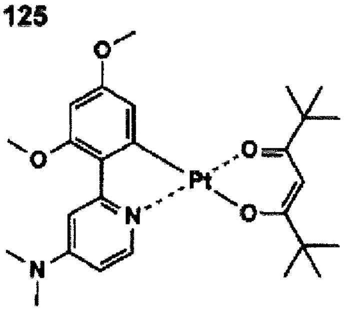

P－126

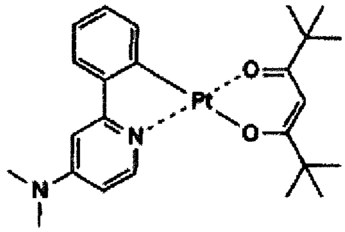

P－127

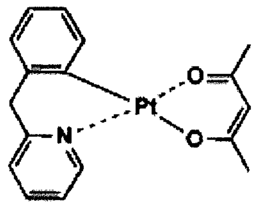

P－128

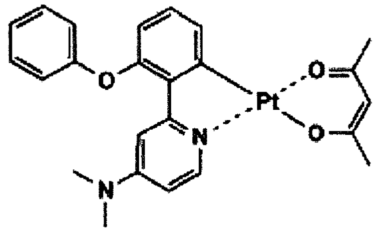

P－129

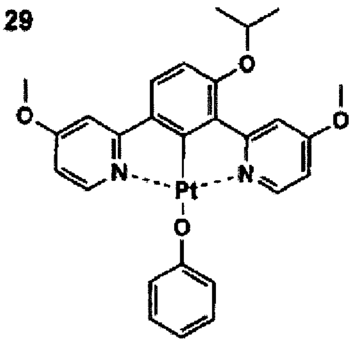

P－130

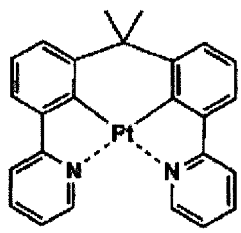

[F25]

P-131

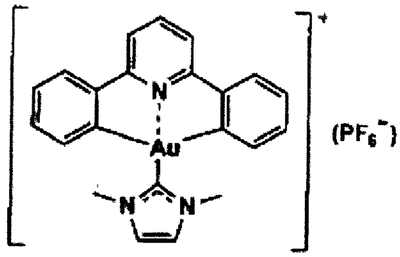

P-132

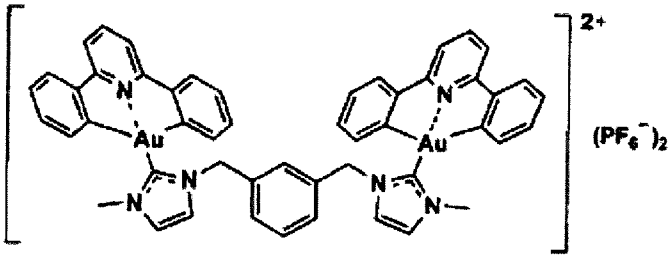

P-133

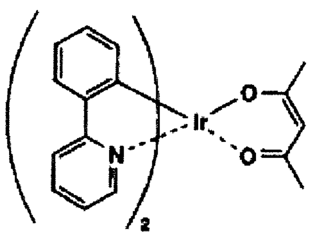

P-134

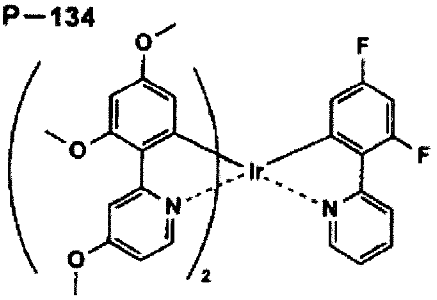

P-135

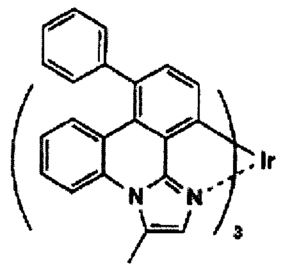

Tables 1 to 3 show the maximum emission wavelengths (nm) and triplet excitation energy (eV) of these phosphorescent metal complexes.

[Table 1]

| Phosphorescent metal complex | Maximum emission wavelength [nm] | $T_1$(P) [eV] |
|---|---|---|
| P−1 | 446.0 | 2.78 |
| P−2 | 432.0 | 2.87 |
| P−3 | 466.0 | 2.66 |
| P−4 | 489.0 | 2.54 |
| P−5 | 459.0 | 2.70 |
| P−6 | 501.0 | 2.48 |
| P−7 | 458.0 | 2.71 |
| P−8 | 453.0 | 2.74 |
| P−9 | 615.0 | 2.01 |
| P−10 | 495.0 | 2.51 |
| P−11 | 459.0 | 2.70 |
| P−12 | 472.0 | 2.63 |
| P−13 | 565.0 | 2.19 |
| P−14 | 466.0 | 2.66 |
| P−15 | 466.2 | 2.66 |
| P−16 | 445.8 | 2.78 |
| P−17 | 464.0 | 2.67 |
| P−18 | 448.4 | 2.77 |
| P−19 | 448.4 | 2.77 |
| P−20 | 467.8 | 2.65 |
| P−21 | 463.2 | 2.68 |
| P−22 | 464.0 | 2.67 |
| P−23 | 458.2 | 2.71 |
| P−24 | 475.4 | 2.61 |
| P−25 | 466.8 | 2.66 |
| P−26 | 467.0 | 2.66 |
| P−27 | 473.0 | 2.62 |
| P−28 | 470.0 | 2.64 |
| P−29 | 468.0 | 2.65 |
| P−30 | 467.0 | 2.66 |
| P−31 | 466.0 | 2.66 |
| P−32 | 457.0 | 2.71 |
| P−33 | 467.0 | 2.66 |
| P−34 | 473.0 | 2.62 |
| P−35 | 467.0 | 2.66 |
| P−36 | 457.0 | 2.71 |
| P−37 | 469.0 | 2.64 |
| P−38 | 465.4 | 2.66 |
| P−39 | 444.8 | 2.79 |
| P−40 | 461.6 | 2.69 |
| P−41 | 460.0 | 2.70 |
| P−42 | 467.0 | 2.66 |
| P−43 | 461.0 | 2.69 |
| P−44 | 453.2 | 2.74 |
| P−45 | 463.2 | 2.68 |

[Table 2]

| Phosphorescent metal complex | Maximum emission wavelength [nm] | $T_1(P)$ [eV] |
|---|---|---|
| P-46 | 459.8 | 2.70 |
| P-47 | 459.4 | 2.70 |
| P-48 | 473.0 | 2.62 |
| P-49 | 509.0 | 2.44 |
| P-50 | 457.0 | 2.71 |
| P-51 | 464.0 | 2.67 |
| P-52 | 464.0 | 2.67 |
| P-53 | 458.0 | 2.71 |
| P-54 | 456.0 | 2.72 |
| P-55 | 464.0 | 2.67 |
| P-56 | 461.0 | 2.69 |
| P-57 | 466.0 | 2.66 |
| P-58 | 465.0 | 2.67 |
| P-59 | 468.0 | 2.65 |
| P-60 | 514.0 | 2.41 |
| P-61 | 525.0 | 2.36 |
| P-62 | 472.0 | 2.63 |
| P-63 | 463.0 | 2.68 |
| P-64 | 523.0 | 2.37 |
| P-65 | 514.0 | 2.41 |
| P-66 | 467.0 | 2.66 |
| P-67 | 468.0 | 2.65 |
| P-68 | 470.0 | 2.64 |
| P-69 | 470.0 | 2.64 |
| P-70 | 487.0 | 2.55 |
| P-71 | 467.0 | 2.66 |
| P-72 | 468.0 | 2.65 |
| P-73 | 468.0 | 2.65 |
| P-74 | 466.0 | 2.66 |
| P-75 | 467.0 | 2.66 |
| P-76 | 467.0 | 2.66 |
| P-77 | 467.0 | 2.66 |
| P-78 | 465.0 | 2.67 |
| P-79 | 466.0 | 2.66 |
| P-80 | 458.0 | 2.71 |
| P-81 | 435.0 | 2.85 |
| P-82 | 415.0 | 2.99 |
| P-83 | 489.0 | 2.54 |
| P-84 | 521.0 | 2.38 |
| P-85 | 419.8 | 2.95 |
| P-86 | 456.8 | 2.71 |
| P-87 | 463.0 | 2.68 |
| P-88 | 505.0 | 2.46 |
| P-89 | 465.0 | 2.67 |
| P-90 | 456.6 | 2.72 |

[Table 3]

| Phosphorescent metal complex | Maximum emission wavelength [nm] | $T_1(P)$ [eV] |
|---|---|---|
| P-91 | 380.8 | 3.26 |
| P-92 | 450.8 | 2.75 |
| P-93 | 441.0 | 2.81 |
| P-94 | 452.2 | 2.74 |
| P-95 | 452.0 | 2.74 |
| P-96 | 455.0 | 2.73 |
| P-97 | 460.0 | 2.70 |
| P-99 | 456.0 | 2.72 |
| P-100 | 460.0 | 2.70 |
| P-101 | 464.0 | 2.67 |
| P-102 | 456.0 | 2.72 |
| P-103 | 461.0 | 2.69 |
| P-104 | 466.0 | 2.66 |
| P-105 | 467.0 | 2.66 |
| P-106 | 452.2 | 2.74 |
| P-107 | 454.0 | 2.73 |
| P-108 | 469.0 | 2.64 |
| P-109 | 439.0 | 2.82 |
| P-110 | 490.0 | 2.53 |
| P-111 | 470.0 | 2.64 |
| P-112 | 415.0 | 2.99 |
| P-113 | 457.0 | 2.71 |
| P-114 | 452.0 | 2.74 |
| P-115 | 448.2 | 2.77 |
| P-116 | 440.4 | 2.82 |
| P-117 | 468.0 | 2.65 |
| P-118 | 472.4 | 2.62 |
| P-119 | 467.6 | 2.65 |
| P-120 | 468.2 | 2.65 |
| P-121 | 469.0 | 2.64 |
| P-122 | 463.0 | 2.68 |
| P-123 | 424.0 | 2.92 |
| P-124 | 479.0 | 2.59 |
| P-125 | 448.0 | 2.77 |
| P-126 | 452.0 | 2.74 |
| P-127 | 459.0 | 2.70 |
| P-128 | 451.0 | 2.75 |
| P-129 | 472.0 | 2.63 |
| P-130 | 515.0 | 2.41 |
| P-131 | 471.0 | 2.63 |
| P-132 | 474.0 | 2.62 |
| P-133 | 507.0 | 2.45 |
| P-134 | 518.0 | 2.39 |
| P-135 | 515.8 | 2.40 |

Although a process of synthesizing a compound represented by Formula (I) will now be described, the present invention is not limited thereto. Specifically, a process of synthesizing compound P-14 will be described below.

[Synthesis of compound P-14]

Compound P-14 can be synthesized by the following process.

Iridium chloride trihydrate (8.1 g, 0.02297 mol) and water (100 mL) were added to a solution of 2-phenyl-(2,3,6-trimethylphenyl)-1H-imidazole (18 g, 0.06861mol) in 2-ethoxyethanol (350 mL) in a nitrogen atmosphere, and the mixture

was refluxed in a nitrogen atmosphere for five hours. The resultant reaction mixture was cooled, methanol (500 mL) was added to the mixture, and the precipitated crystals were recovered through filtration. The crystals were further washed with methanol and dried, to prepare complex A (15.2 g, yield: 88.4%).

Complex A (14.5 g, 0.009662 mol) and sodium carbonate (14.5 g) were suspended in 2-ethoxyethanol (350 mL) in a nitrogen atmosphere. Acetylacetone (3.9 g, 0.03895 mol) was added to the suspension, and the mixture was refluxed in a nitrogen atmosphere for two hours. The resultant reaction mixture was cooled, and sodium carbonate and inorganic salts were then removed through filtration under reduced pressure. The solvent was evaporated under reduced pressure, the resultant solid was then suspended in water (1 L), and the solid was recovered through filtration. The resultant crystals were further washed with a solvent mixture of methanol and water (1:1) and dried, to prepare complex B (14.7 g, yield: 93.6%).

Complex B (7.5 g, 0.009214 mol) and 2-phenyl-(2,4,6-trimethylphenyl)-1H-imidazole (6.0 g, 0.002287 mol) were suspended in glycerin (400 mL) in a nitrogen atmosphere. The suspension was subjected to reaction in a nitrogen atmosphere at 150 to 160°C for two hours. The reaction was completed after confirmation of disappearance of complex B. The reaction mixture was cooled, methanol (500 mL) was added to the mixture, and the precipitated crystals were recovered through filtration. The crystals were further washed with methanol and dried, to prepare a crude product (7.1 g, yield: 78.9%). The crude product was dissolved in a small amount of methylene chloride and purified by silica gel column chromatography (developing solvent: methylene chloride), to produce compound P-14 (6.5 g, yield: 72.2%).

[F26]

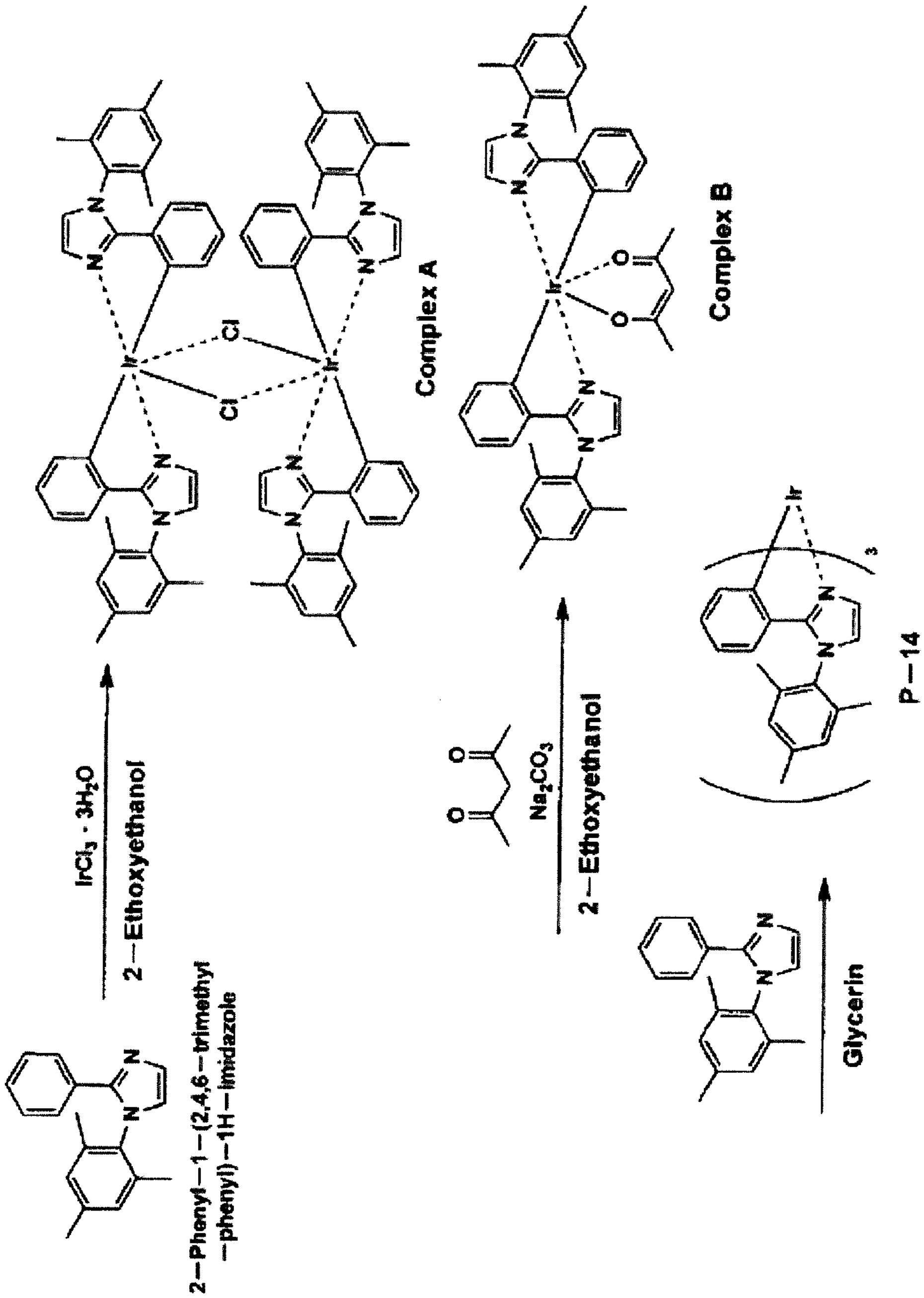


[Host compound]

Now will be described preferred host compounds used in the present invention. Any host compound may be used in the present invention. If a host compound is used in combination with a TADF compound, the host compound preferably has an excitation energy higher than the lowest excited singlet energy of the TADF compound.

A host compound represented by Formula (II) is preferably used in the present invention, because the compound represented by Formula (II), which has a condensed ring structure, exhibits high carrier transportability and a large triplet energy gap described above (phosphorescence 0-0 band).

[F27]

Formula(II)

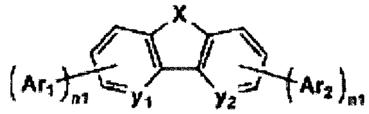

In Formula (II), X represents NR', an oxygen atom, a sulfur atom, CR'R", or SiR'R", $y_1$ and $y_2$ each represent CR' or a nitrogen atom, and R' and R" each represent a hydrogen atom or a substituent. $Ar_1$ and $Ar_2$ each represent an aromatic ring and may be identical to or different from each other. In Formula (II), n1 represents an integer of 0 to 4. The host compound used in the present invention and represented by Formula (II) is particularly preferably a carbazole derivative.

Examples of the substituent represented by R' or R" in X, $y_1$, and $y_2$ in Formula (II) include alkyl groups (e.g., methyl, ethyl, propyl, isopropyl, tert-butyl, pentyl, hexyl, octyl, dodecyl, tridecyl, tetradecyl, and pentadecyl), cycloalkyl groups (e.g., cyclopentyl and cyclohexyl), alkenyl groups (e.g., vinyl and allyl), alkynyl groups (e.g., ethynyl and propargyl), aromatic hydrocarbon groups (also referred to as aromatic carbon groups or aryl groups, such as phenyl, p-chlorophenyl, mesityl, tolyl, xylyl, naphthyl, anthryl, azulenyl, acenaphthenyl, fluorenyl, phenanthryl, indenyl, pyrenyl, and biphenylyl), aromatic heterocyclic groups (e.g., pyridyl, pyrimidinyl, furyl, pyrrolyl, imidazolyl, benzimidazolyl, pyrazolyl, pyrazinyl, and triazolyl (e.g., 1,2,4-triazol-1-yl and 1,2,3-triazol-1-yl), oxazolyl, benzoxazolyl, thiazolyl, isoxazolyl, isothiazolyl, furazanyl, thienyl, quinolyl, benzofuryl, dibenzofuryl, benzothienyl, dibenzothienyl, indolyl, carbazolyl, carbolinyl, diazacarbazolyl (a group wherein one of the carbon atoms forming the carboline ring of the carbolinyl group is substituted by a nitrogen atom), quinoxalinyl, pyridazinyl, triazinyl, quinazolinyl, and phthalazinyl), heterocyclic groups (e.g., pyrrolidyl, imidazolidyl, morpholyl, and oxazolidyl), alkoxy groups (e.g., methoxy, ethoxy, propyloxy, pentyloxy, hexyloxy, octyloxy, and dodecyloxy), cycloalkoxy groups (e.g., cyclopentyloxy and cyclohexyloxy), aryloxy groups (e.g., phenoxy and naphthyloxy), alkylthio groups (e.g., methylthio, ethylthio, propylthio, pentylthio, hexylthio, octylthio, and dodecylthio), cycloalkylthio groups (e.g., cyclopentylthio and cyclohexylthio), arylthio groups (e.g., phenylthio and naphthylthio), alkoxycarbonyl groups (e.g., methyloxycarbonyl, ethyl oxycarbonyl, butyloxycarbonyl, octyloxycarbonyl, and dodecyloxycarbonyl), aryloxycarbonyl groups (e.g., phenyloxycarbonyl and naphthyloxycarbonyl), sulfamoyl groups (e.g., aminosulfonyl, methylaminosulfonyl, dimethylaminosulfonyl, butylaminosulfonyl, hexylaminosulfonyl, cyclohexylaminosulfonyl, octylaminosulfonyl, dodecylaminosulfonyl, phenylaminosulfonyl, naphthylaminosulfonyl, and 2-pyridylaminosulfonyl), acyl groups (e.g., acetyl, ethylcarbonyl, propylcarbonyl, pentylcarbonyl, cyclohexylcarbonyl, octylcarbonyl, 2-ethylhexylcarbonyl, dodecylcarbonyl, phenylcarbonyl, naphthylcarbonyl, and pyridylcarbonyl), acyloxy groups (e.g., acetyloxy, ethylcarbonyloxy, butylcarbonyloxy, octylcarbonyloxy, dodecylcarbonyloxy, and phenylcarbonyloxy), amido groups (e.g., methylcarbonylamino, ethylcarbonylamino, dimethylcarbonylamino, propylcarbonylamino, pentylcarbonylamino, cyclohexylcarbonylamino, 2-ethyhexylcarbonylamino, octylcarbonylamino, dodecylcarbonylamino, phenylcarbonylamino, and naphthylcarbonylamino), carbamoyl groups (e.g., aminocarbonyl, methylaminocarbonyl, dimethylaminocarbonyl, propylaminocarbonyl, pentylaminocarbonyl, cyclohexylaminocarbonyl, octylaminocarbonyl, 2-ethylhexylaminocarbonyl, dodecylaminocarbonyl, phenylaminocarbonyl, naphthylaminocarbonyl, and 2-pyridylaminocarbonyl), ureido groups (e.g., methylureido, ethylureido, pentylureido, cyclohexylureido, octylureido, dodecylureido, phenylureido, naphthylureido, and 2-pyridylaminoureido), sulfinyl groups (e.g., methylsulfinyl, ethylsulfinyl, butylsulfinyl, cyclohexylsulfinyl, 2-ethylhexylsulfinyl, dodecylsulfinyl, phenylsulfinyl, naphthylsulfinyl, and 2-pyridylsulfinyl), alkylsulfonyl groups (e.g., methylsulfonyl, ethylsulfonyl, butylsulfonyl, cyclohexylsulfonyl, 2-ethylhexylsulfonyl, and dodecylsulfonyl), arylsulfonyl and heteroarylsulfonyl groups (e.g., phenylsulfonyl, naphthylsulfonyl, and 2-pyridylsulfonyl), amino groups (e.g., amino, ethylamino, dimethylamino, butylamino, cyclopentylamino, 2-ethylhexylamino, dodecylamino, anilino, naphthylamino, and 2-pyridylamino), halogen atoms (e.g., fluorine, chlorine, and bromine), fluorohydrocarbon groups (e.g., fluoromethyl, trifluoromethyl, pentafluoromethyl, and pentafluorophenyl), a cyano group, a nitro group, a hydroxy group, a mercapto group, and silyl groups (e.g., trimethylsilyl, triisopropylsilyl, triphenylsilyl, and phenyldiethylsilyl). Such a substituent may further have any of the aforementioned substituents. These substituents may together form a ring.

Particularly preferred is a compound represented by Formula (II) in which X is NR' or an oxygen atom. The compound has a low energy level of LUMO and exhibits excellent electron transportability. Preferred is a compound having an (aza)carbazole ring or an (aza)dibenzofuran ring, and more preferred is a compound having an (aza)carbazole ring, which exhibits further excellent electron transportability. In this case, R' is particularly preferably an aromatic hydrocarbon group (also referred to as an aromatic carbon group or aryl group, such as phenyl, p-chlorophenyl, mesityl, tolyl, xylyl, naphthyl, anthryl, azulenyl, acenaphthenyl, fluorenyl, phenanthryl, indenyl, pyrenyl, or biphenylyl) or an aromatic heterocyclic group (e.g., furyl, thienyl, pyridyl, pyridazinyl, pyrimidinyl, pyrazinyl, triazinyl, imidazolyl, pyrazolyl,

thiazolyl, quinazolinyl, or phthalazinyl).

The aforementioned aromatic hydrocarbon group or aromatic heterocyclic group may have a substituent represented by R' or R" of X in Formula (II).

In Formula (II), each of $y_1$ and $y_2$ is CR' or a nitrogen atom, more preferably CR'. In this case, the compound exhibits excellent hole transportability, leading to effective recombination of holes and electrons injected from an anode and a cathode in a light-emitting layer, resulting in emission from the layer.

In Formula (II), the aromatic ring represented by $Ar_1$ or $Ar_2$ is an aromatic hydrocarbon ring or an aromatic heterocyclic ring. The aromatic ring may be a monocyclic ring or a condensed ring. The aromatic ring may be unsubstituted or may have a substituent represented by R' or R" of X in Formula (II).

Examples of the aromatic hydrocarbon ring represented by $Ar_1$ or $Ar_2$ in Formula (II) include rings of benzene, biphenyl, naphthalene, azulene, anthracene, phenanthrene, pyrene, chrysene, naphthacene, triphenylene, o-terphenyl, m-terphenyl, p-terphenyl, acenaphthene, coronene, fluorine, fluoranthene, naphthacene, pentacene, perylene, pentaphene, picene, pyrene, pyranthrene, and anthranthrene.

Examples of the aromatic heterocyclic ring represented by $Ar_1$ or $Ar_2$ in the partial structure of Formula (II) include rings of furan, dibenzofuran, thiophene, oxazole, pyrrole, pyridine, pyridazine, pyrimidine, pyrazine, triazine, benzimidazole, oxadiazole, triazole, imidazole, pyrazole, thiazole, indole, indazole, benzimidazole, benzothiazole, benzoxazole, quinoxaline, quinazoline, cinnoline, quinoline, isoquinoline, phthalazine, naphthyridine, carbazole, carboline, and diazacarbazole (a ring wherein one of the carbon atoms forming the carboline ring is substituted by a nitrogen atom).

Each of these rings may have a substituent represented by R' or R" in Formula (II).

Among the aforementioned rings, the aromatic ring represented by $Ar_1$ or $Ar_2$ in Formula (II) is preferably a carbazole, carboline, dibenzofuran, or benzene ring, more preferably a carbazole, carboline, or benzene ring, still more preferably a benzene ring having a substituent, particularly preferably a benzene ring having a carbazolyl group.

In a preferred embodiment, the aromatic ring represented by $Ar_1$ or $Ar_2$ in Formula (II) is a condensed ring composed of three or more rings. Specific examples of the aromatic hydrocarbon condensed ring composed of three or more rings include rings of naphthacene, anthracene, tetracene, pentacene, hexacene, phenanthrene, pyrene, benzopyrene, benzazulene, chrysene, benzochrysene, acenaphthene, acenaphthylene, triphenylene, coronene, benzocoronene, hexabenzocoronene, fluorene, benzofluorene, fluoranthene, perylene, naphthoperylene, pentabenzoperylene, benzoperylene, pentaphene, picene, pyranthrene, coronene, naphthocoronene, ovalene, and anthranthrene. Each of these rings may further have any of the aforementioned substituents.

Specific examples of the aromatic heterocyclic ring composed of three or more rings include rings of acridine, benzoquinoline, carbazole, carboline, phenazine, phenanthridine, phenanthroline, carboline, cyclazine, quindoline, tepenidine, quinindoline, triphenodithiazine, triphenodioxazine, phenanthrazine, anthrazine, perimidine, diazacarbazole (a ring wherein any one of the carbon atoms forming the carboline ring is substituted by a nitrogen atom), phenanthroline, dibenzofuran, dibenzothiophene, naphthofuran, naphthothiophene, benzodifuran, benzodithiophene, naphthodifuran, naphthodithiophene, anthrafuran, anthradifuran, anthrathiophene, anthradithiophene, thianthrene, phenoxathiine, and thiophanthrene (naphthothiophene). Each of these rings may further have a substituent.

In Formula (II), n1 is an integer of 0 to 4, preferably 0 to 2. If X is an oxygen atom or a sulfur atom, n1 is particularly preferably 1 or 2.

In particular, the host compound used in the present invention preferably has both a dibenzofuran ring and a carbazole ring.

In the present invention, the host compound represented by Formula (II) is preferably a compound represented by Formula (III) ; i. e. , a compound having a carbozole ring having a phenyl substituent at position 3, because such a compound tends to have excellent carrier transportability.

[F28]

Formula(III)

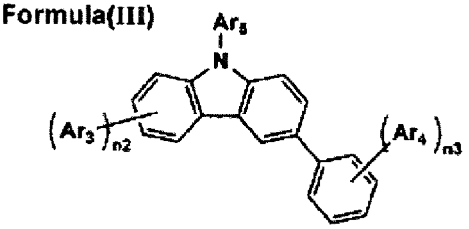

In Formula (III), $Ar_3$ to $Ar_5$ each represent an aromatic ring and may be identical to or different from one another. In Formula (III), n2 represents an integer of 0 to 4, and n3 represents an integer of 0 to 5.

The aromatic ring represented by each of $Ar_3$ to $Ar_5$ may be the same as that represented by $Ar_1$ or $Ar_2$ in

Formula (III).

Now will be exemplified host compounds used in the present invention, which have an emission wavelength of 414 to 459 nm (2.7 to 3 . 0 eV) attributed to the 0-0 transition band in a phosphorescence spectrum. Specific examples of the compounds represented by Formulae (II) and (III) and having other structures include, but are not limited to, the following compounds.

[F29]

H−1 : 442nm

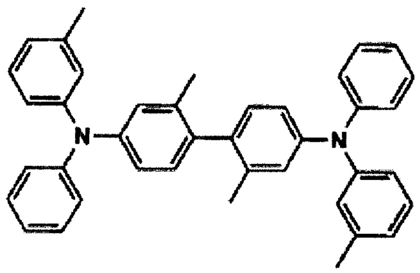

H−2 : 421nm

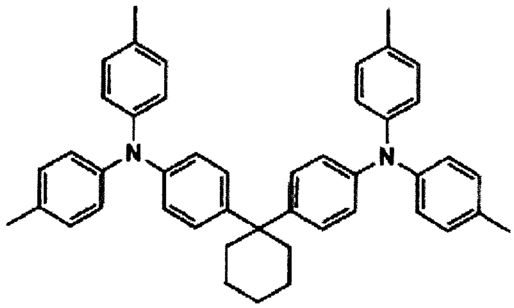

H−3 : 438nm

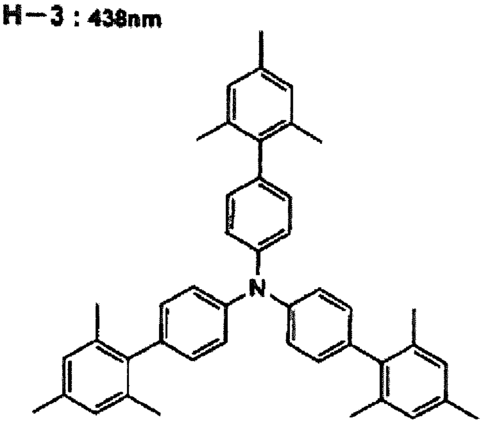

H−4 : 415nm

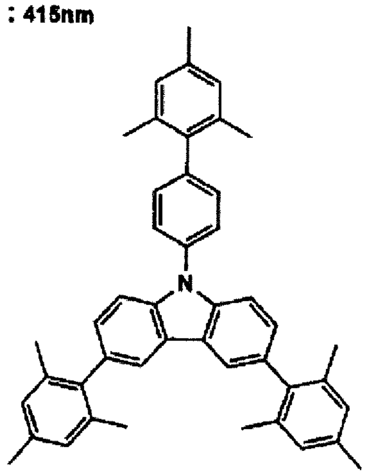

H−5 : 437nm

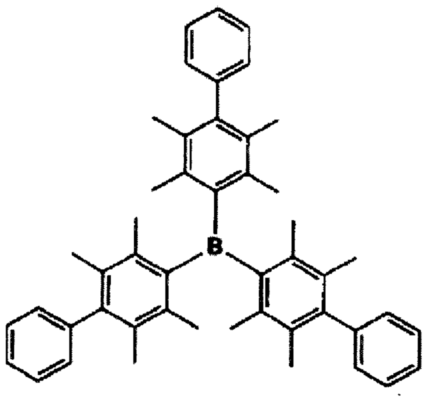

H−6 : 411nm

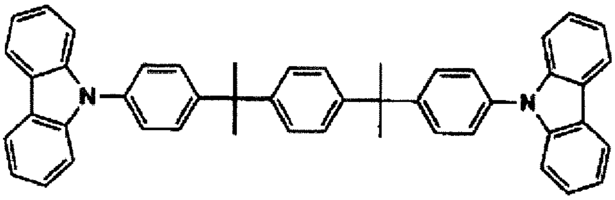

[F30]

H−7 : 412nm

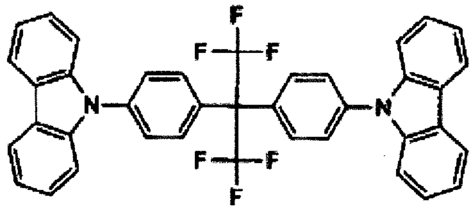

H−8 : 430nm

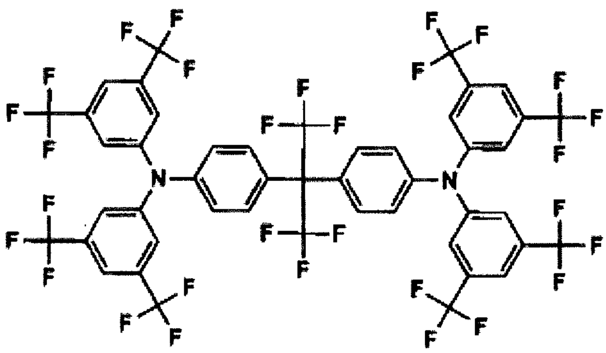

H−9 : 451nm

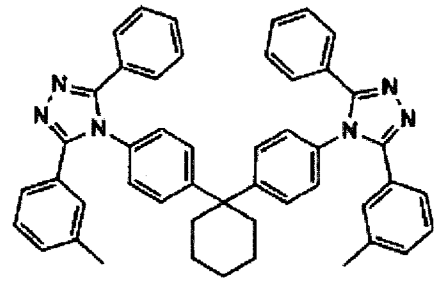

H−10 : 411nm

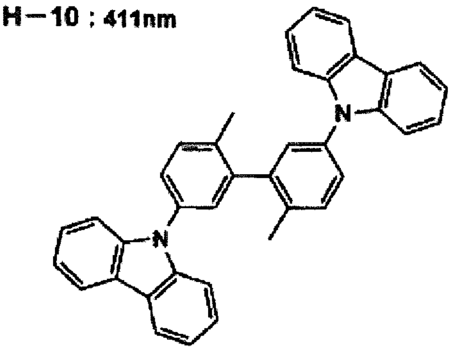

H−11 : 420nm

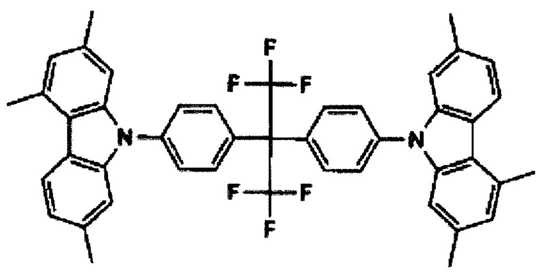

H−12 : 424nm

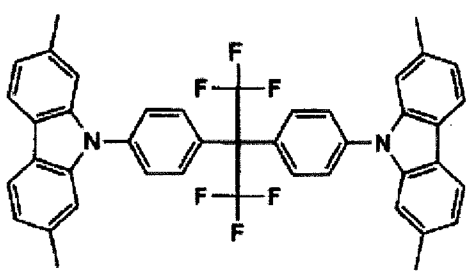

[F31]

H−13 : 410nm

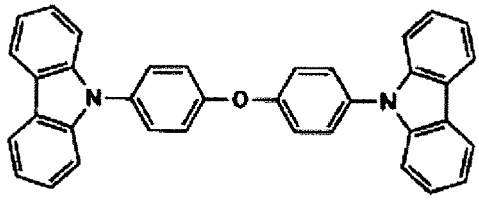

H−14 : 442nm

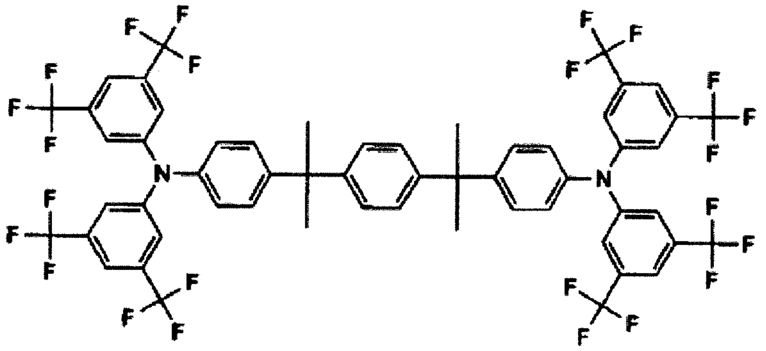

H−15 : 428nm

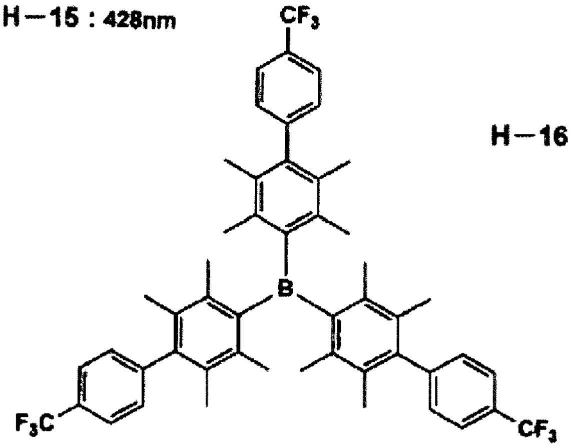

H−16 : 429nm

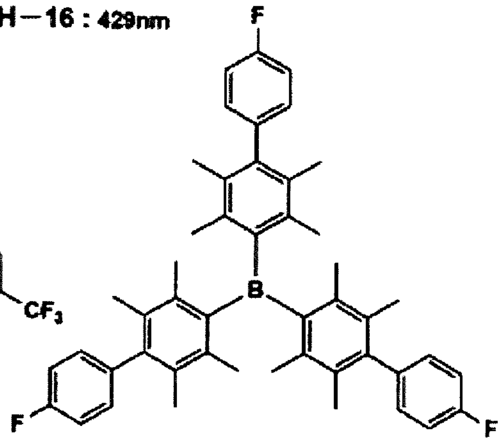

H−17 : 457nm

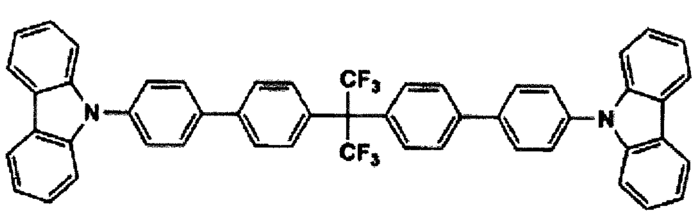

[F32]

H−18 : 411nm

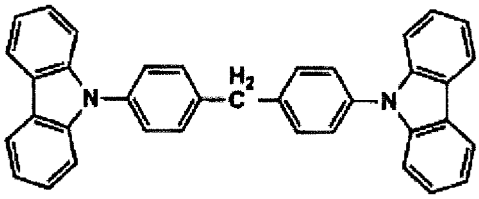

H−19 : 440nm

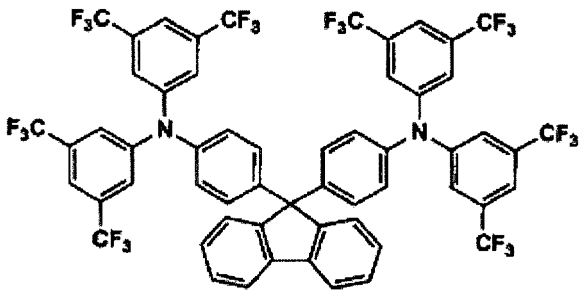

H−20 : 410nm

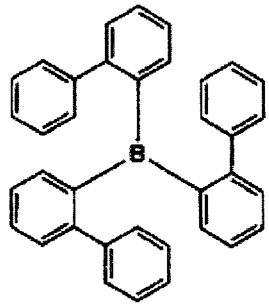

H−21 : 459nm

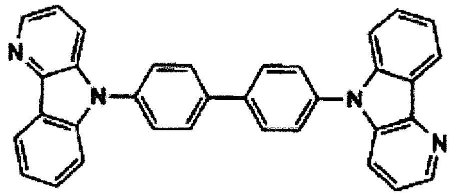

H−22 : 452nm

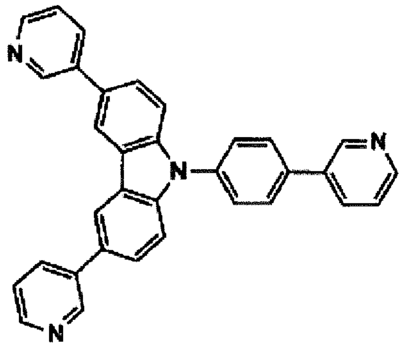

H−23 : 457nm

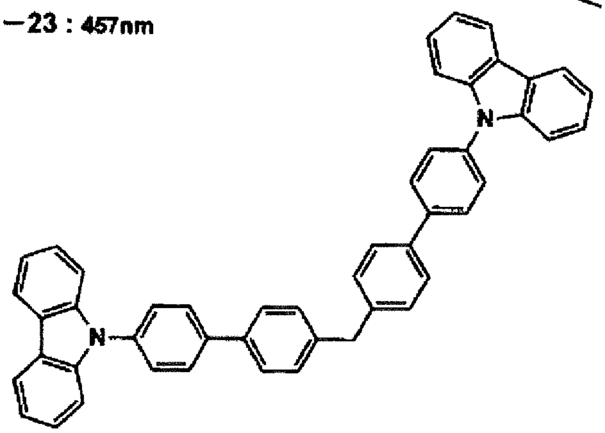

[F33]

H−24 : 440nm

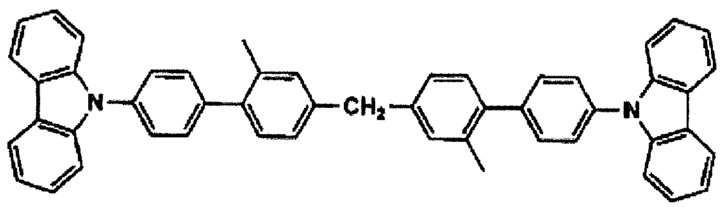

H−25 : 425nm

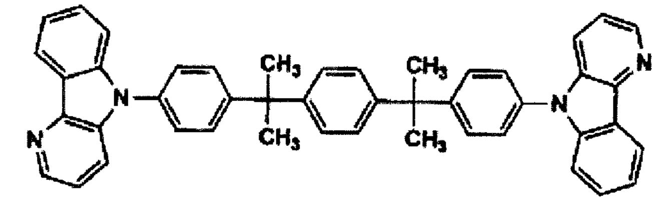

H−26 : 456nm

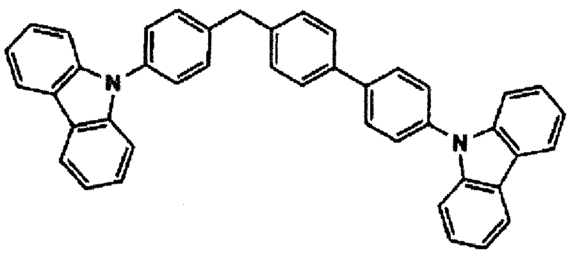

H−27 : 455nm

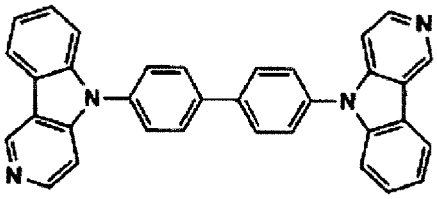

H−28 : 449nm

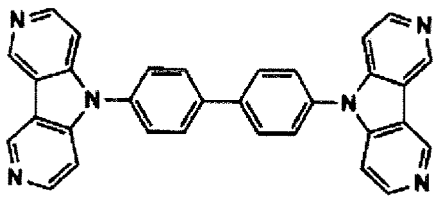

H−29 : 451nm

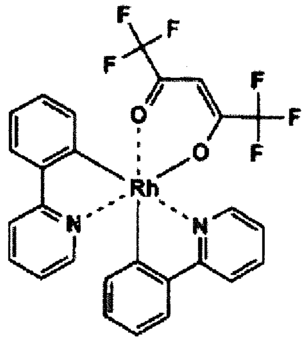

H−30 : 458nm

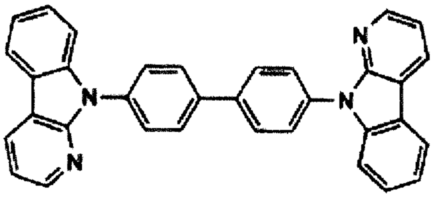

[F34]

H−31 : 448nm

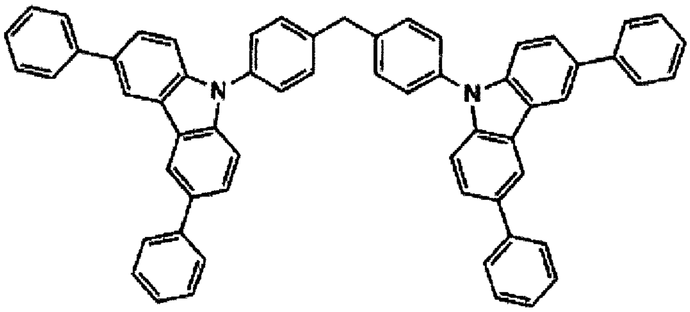

H−32 : 432nm

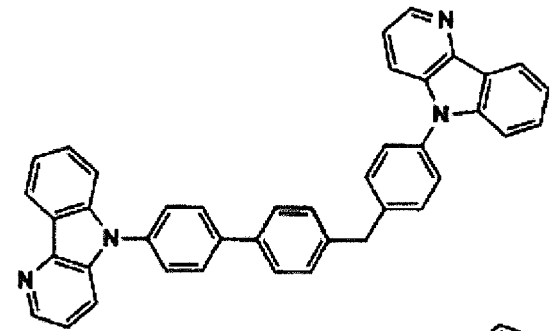

H−33 : 428nm

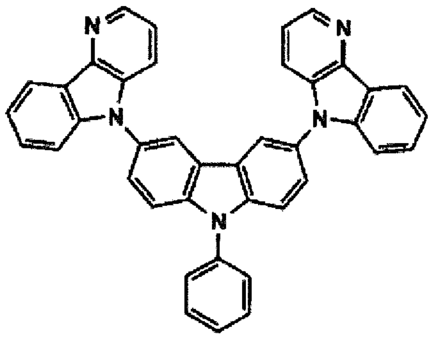

H−34 : 444nm

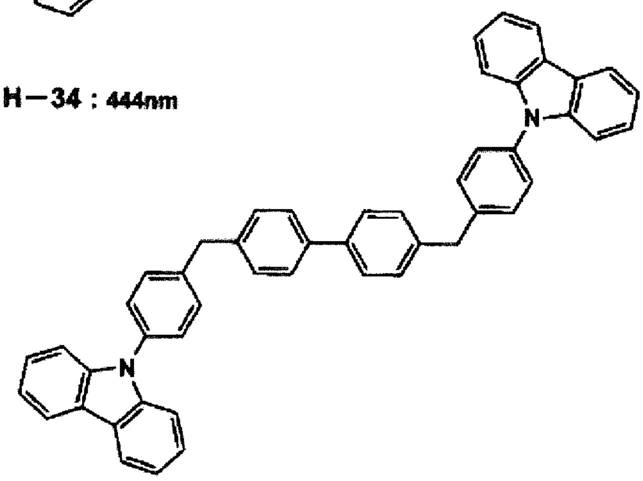

H−35 : 456nm

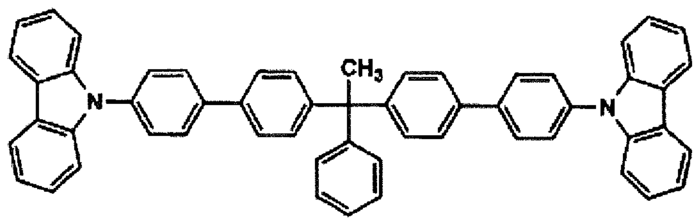

[F35]

H-36 : 413nm

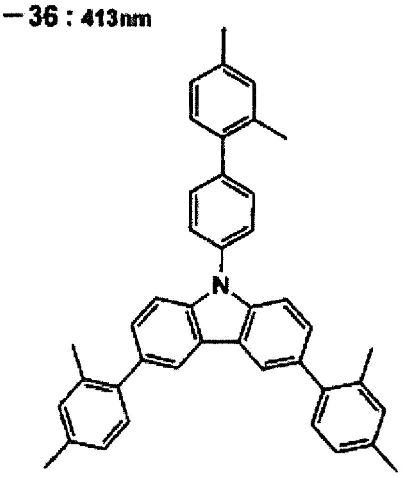

H-37 : 440nm

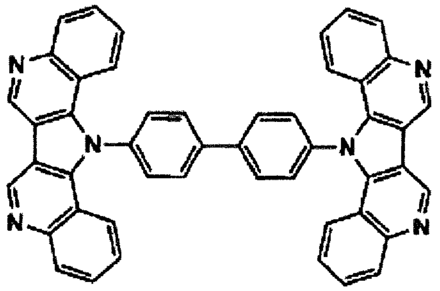

H-38 : 434nm

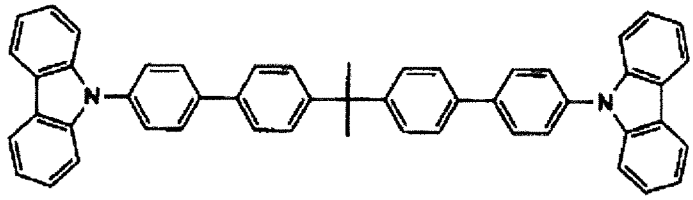

H-39 : 395nm

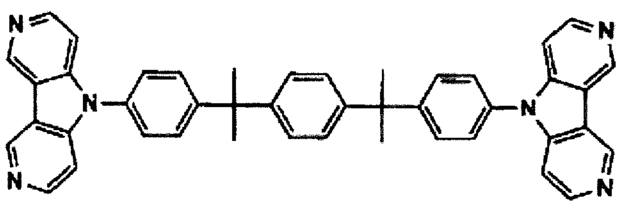

H-40 : 432nm

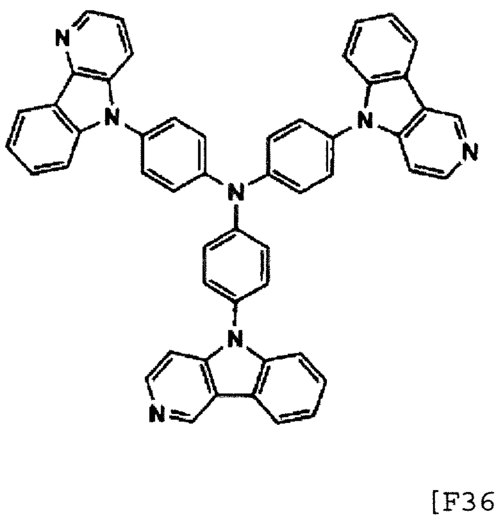

H-41 : 420nm

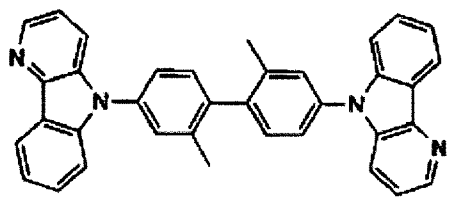

[F36]

H−42 : 398nm

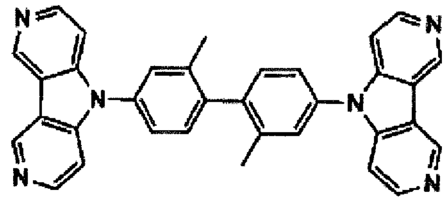

H−43 : 453nm

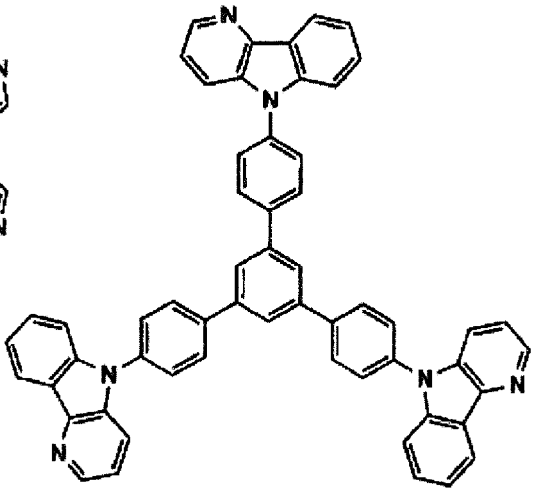

H−44 : 425nm

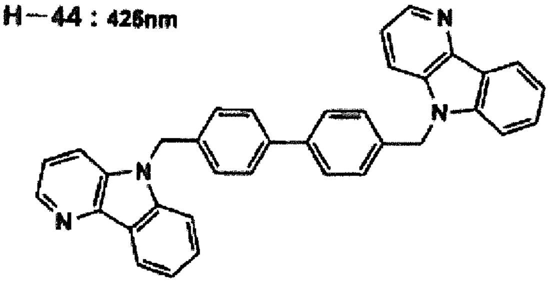

H−45 : 416nm

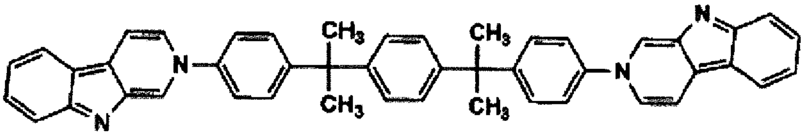

H−46 : 411nm

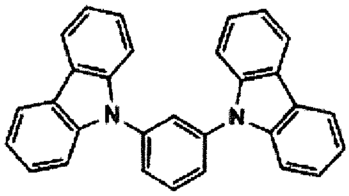

H−47 : 442nm

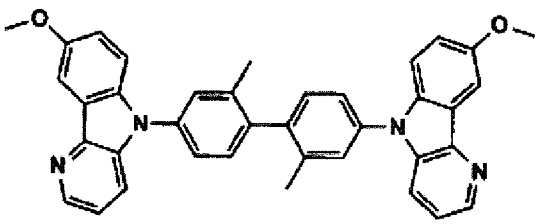

[F37]

H−48 : 449nm

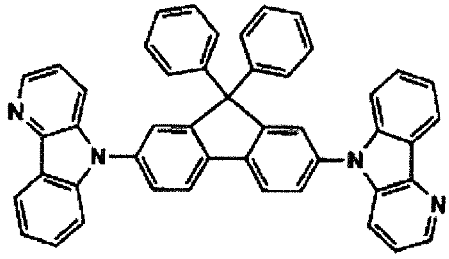

H−49 : 438nm

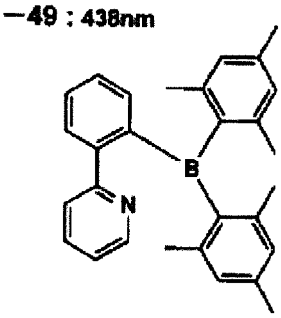

H−50 : 432nm

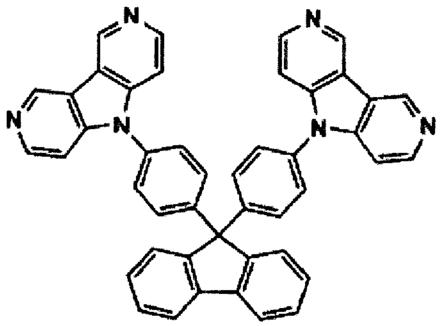

H−51 : 453nm

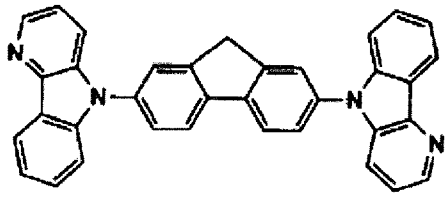

H−52 : 459nm

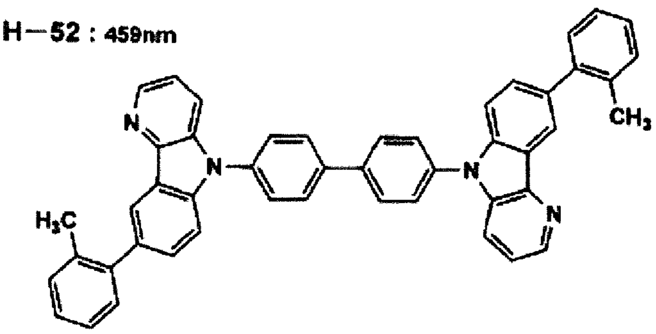

H−53 : 444nm

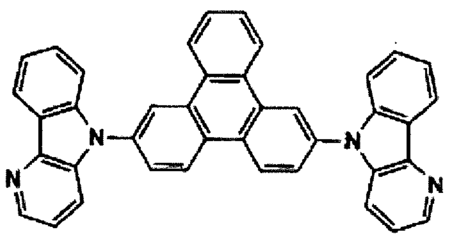

H−54 : 439nm

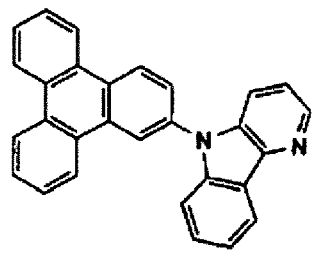

[F38]

H−55 : 420nm

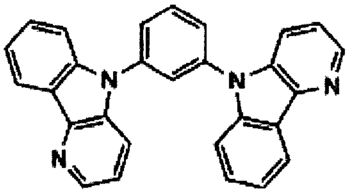

H−56 : 397nm

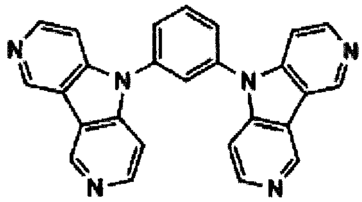

H−57 : 417nm

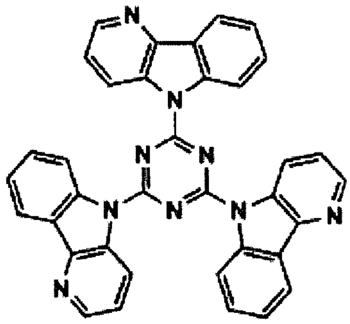

H−58 : 413nm

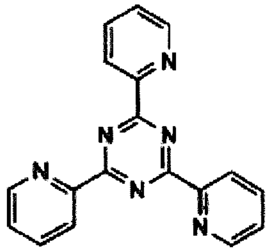

H−59 : 397nm

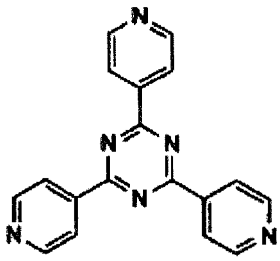

H−60 : 414nm

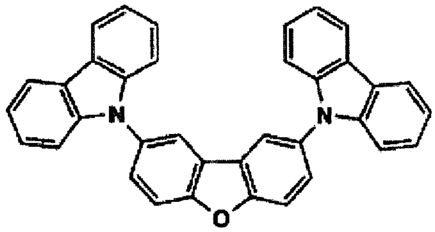

H−61 : 449nm

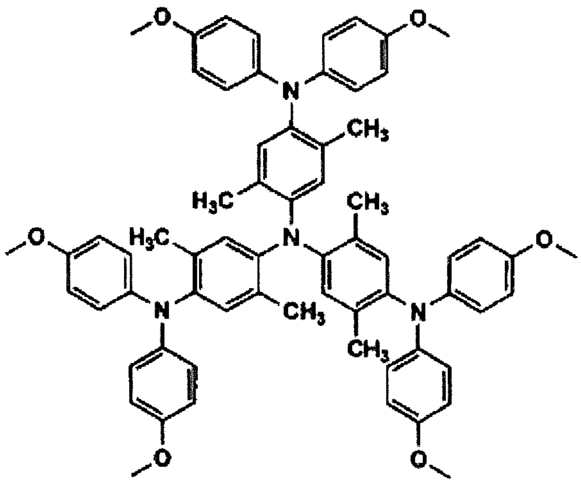

[F39]

H−62 : 444nm

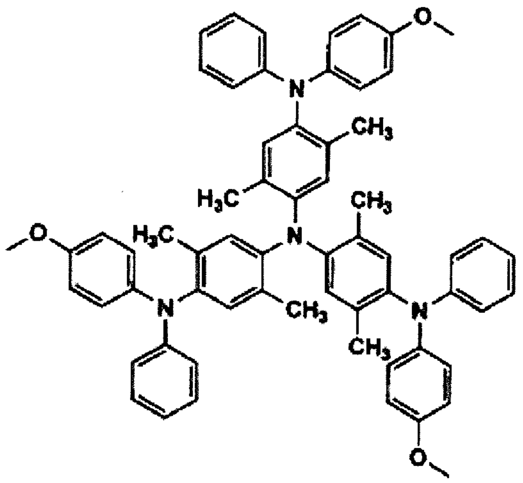

H−63 : 411nm

H−64 : 448nm

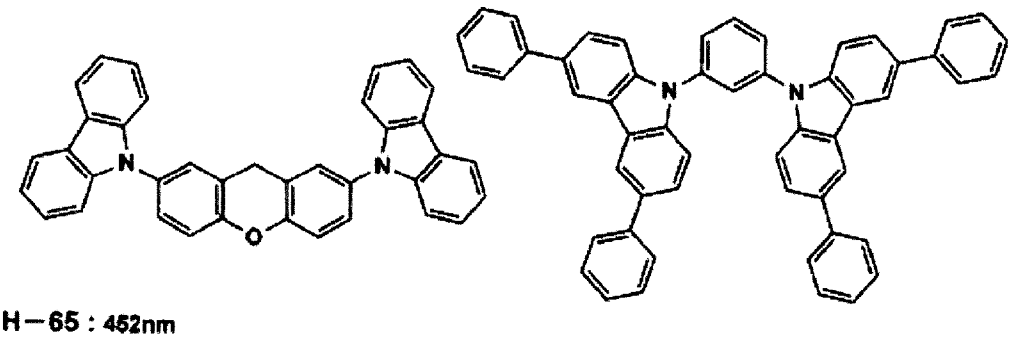

H−65 : 452nm

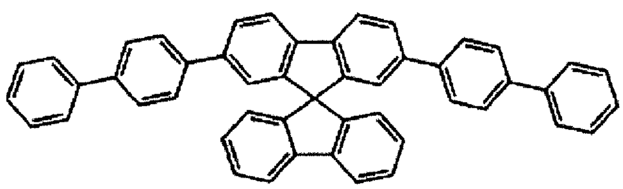

H−66 : 449nm

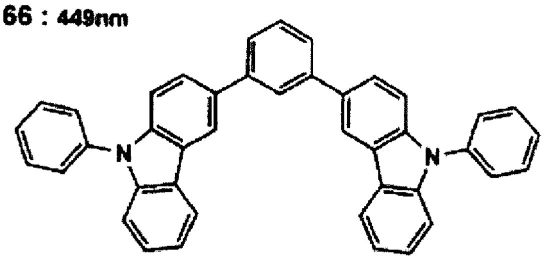

[F40]

**H−67 : 442nm**

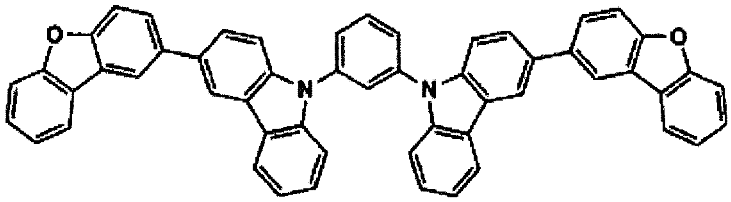

**H−68 : 446nm**

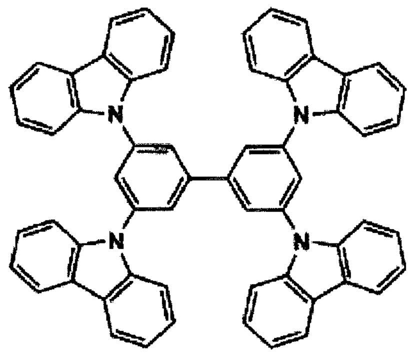

**H−69 : 450nm**

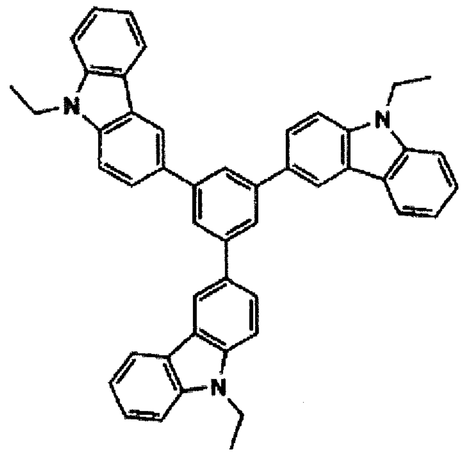

**H−70 : 451nm**

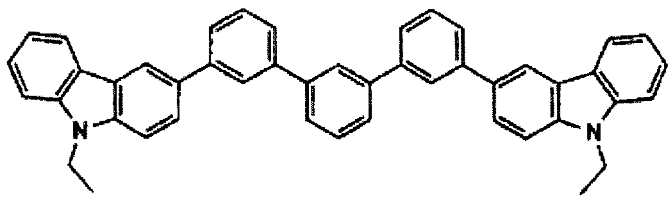

**H−71 : 432nm**

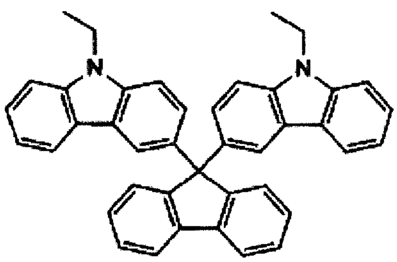

**H−72 : 454nm**

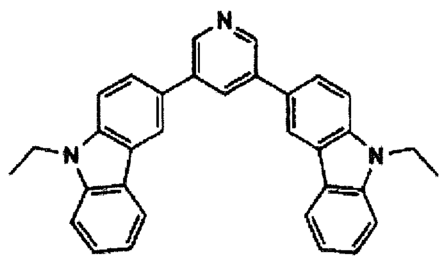

[F41]

**H−73 : 437nm**

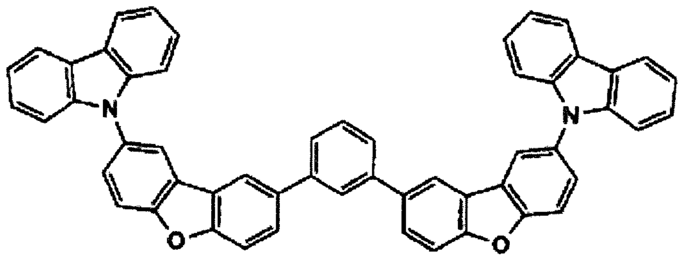

**H−74 : 455nm**

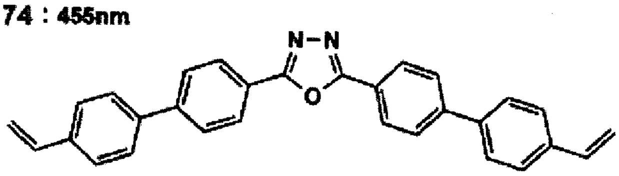

**H−75 : 441nm**

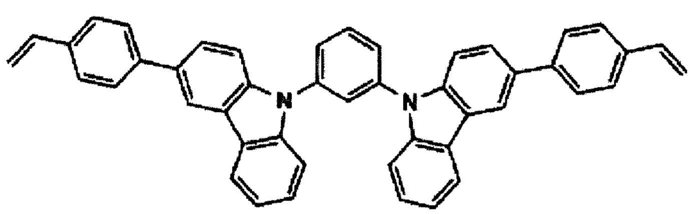

**H−76 : 446nm**

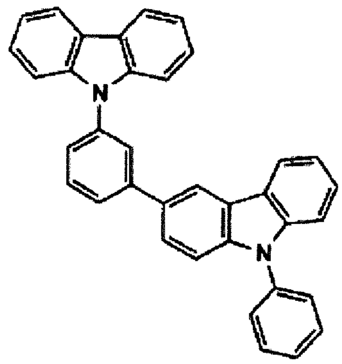

**H−77 : 436nm**

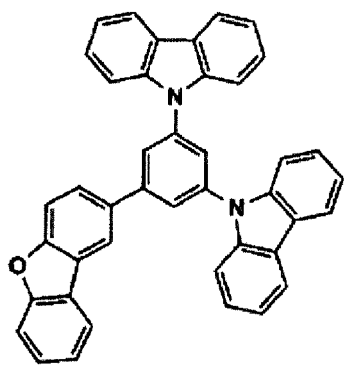

**H−78 : 446nm**

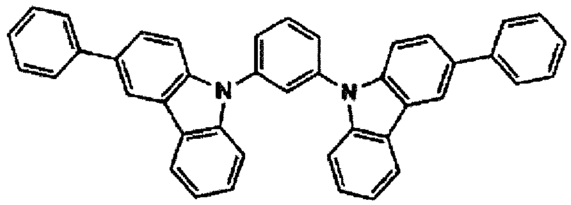

[F42]

**H−79 : 436nm**

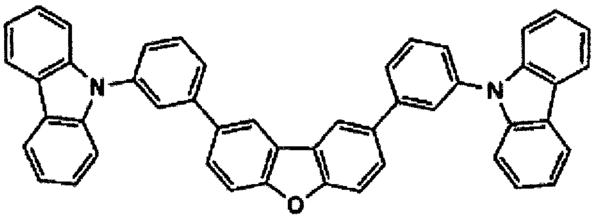

**H−80 : 452nm**

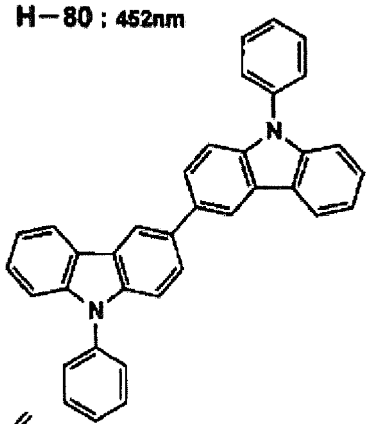

**H−81 : 441nm**

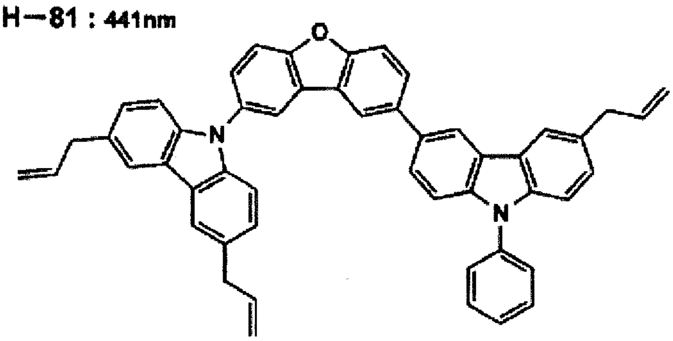

**H−82 : 419nm**

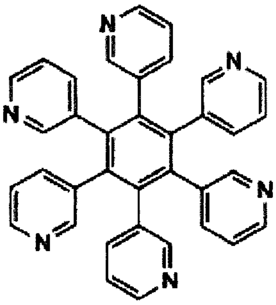

**H−83 : 444nm**

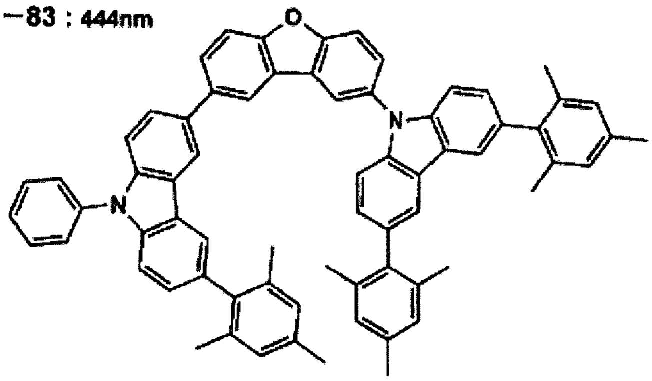

**H−84 : 431nm**

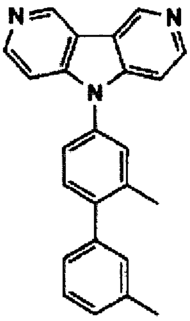

**H−85 : 397nm**

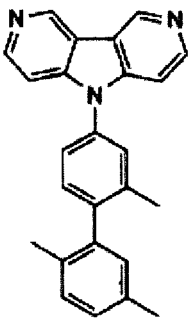

**H−86 : 436nm**

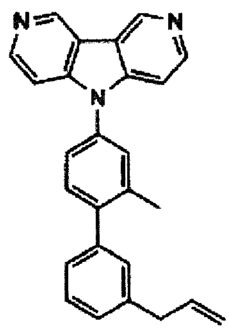

[F43]

H−87 : 430nm

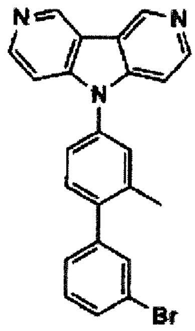

H−88 : 431nm

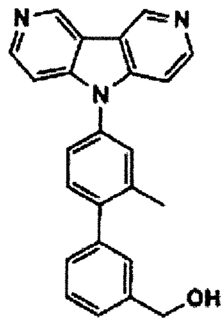

H−89 : 426nm

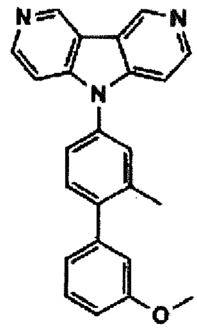

H−90 : 430nm

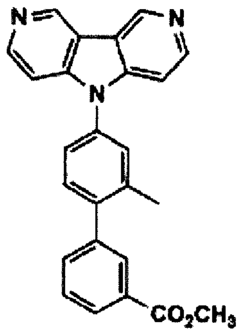

H−91 : 430nm

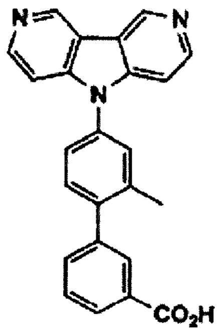

H−92 : 447nm

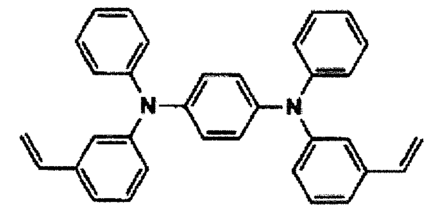

H−93 : 398nm

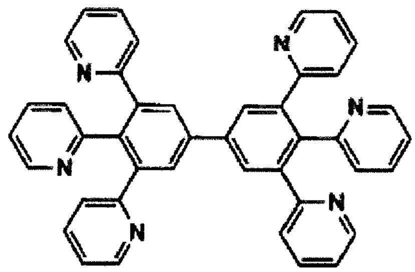

H−94 : 448nm

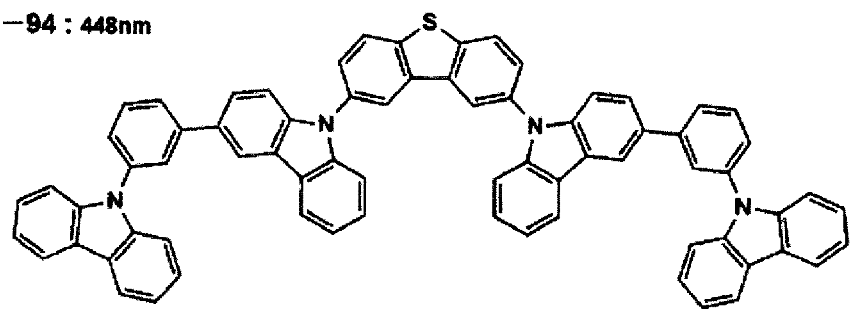

[F44]

H−95 : 447nm

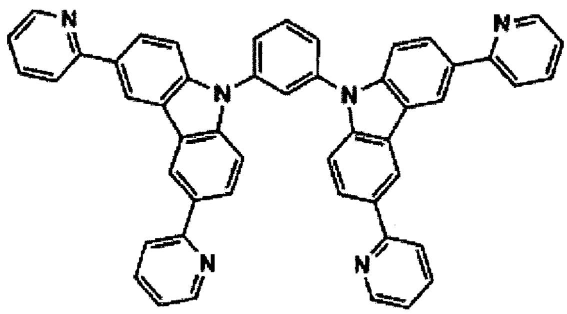

H−96 : 447nm

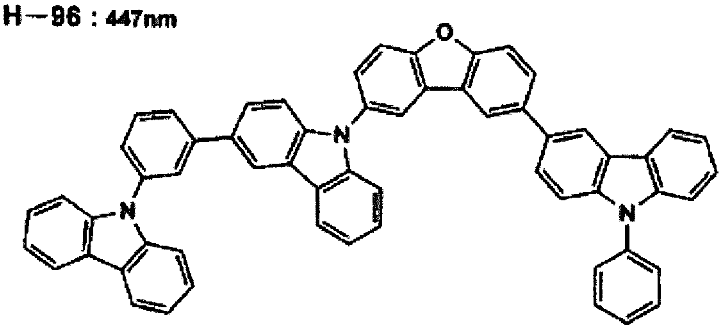

H−97 : 443nm

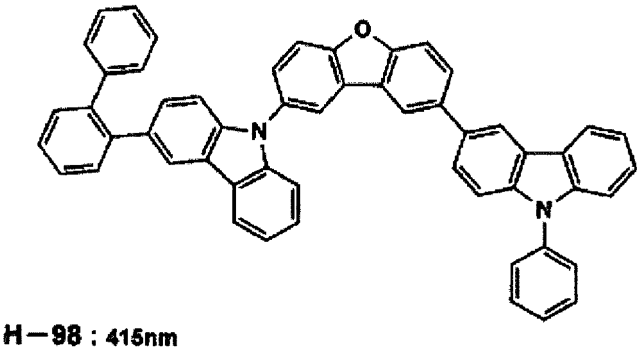

H−98 : 415nm

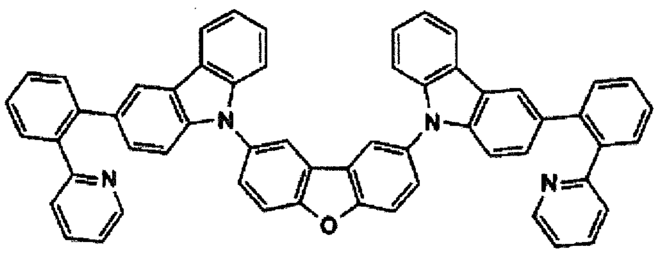

[F45]

H−99 : 447nm

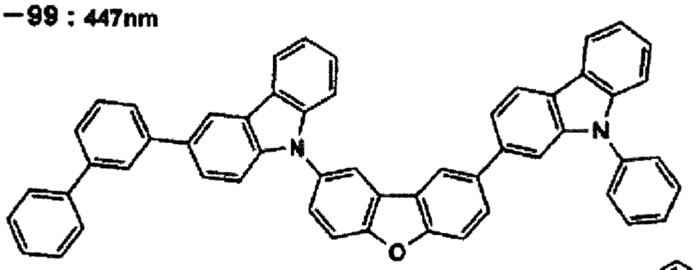

H−100 : 445nm

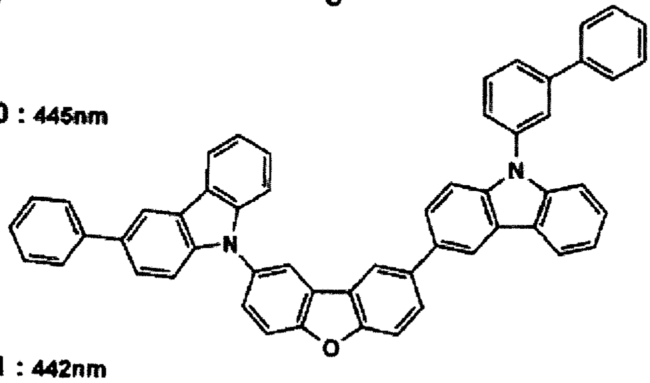

H−101 : 442nm

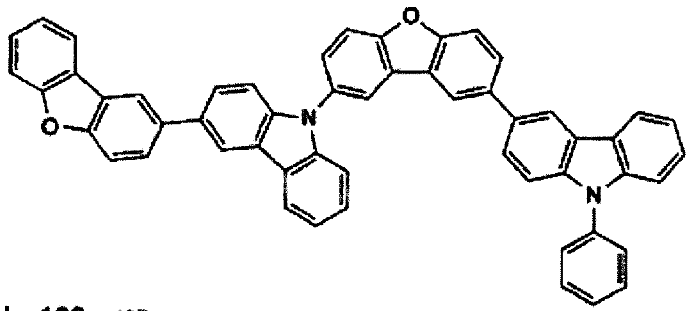

H−102 : 427nm

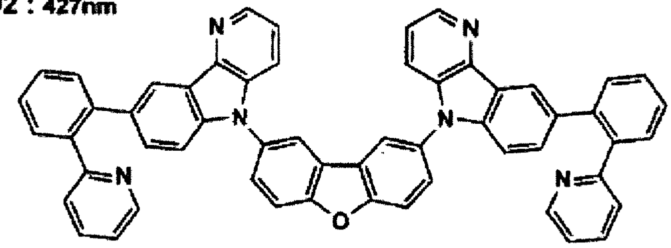

H−103 : 430nm

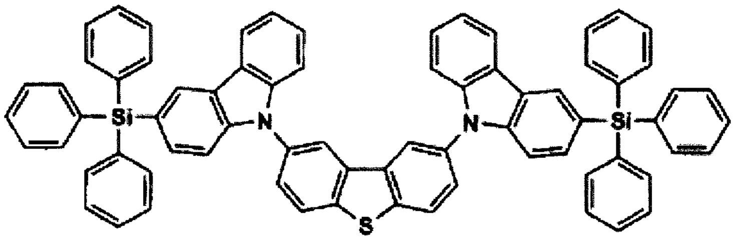

[F46]

**H-104 : 430nm**

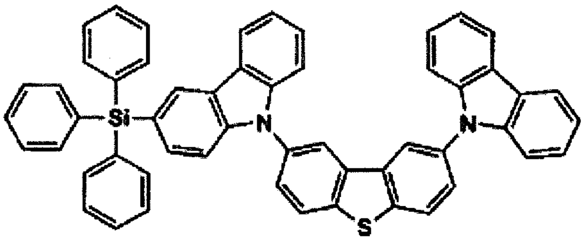

**H-105 : 430nm**

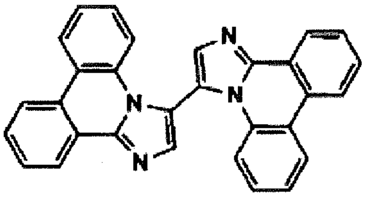

**H-106 : 430nm**

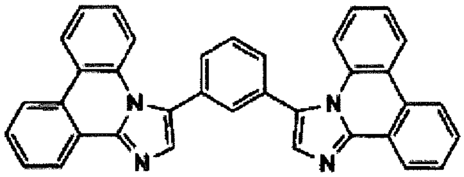

**H-107 : 448nm**

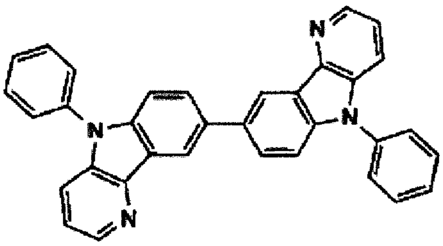

**H-108 : 441nm**

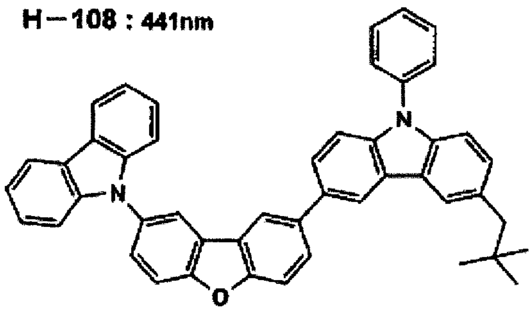

**H-109 : 446nm**

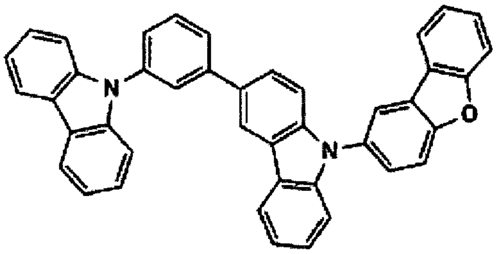

**H-110 : 449nm**

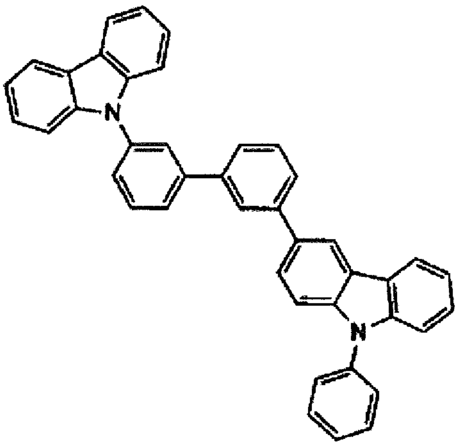

[F47]

**H−111 : 443nm**

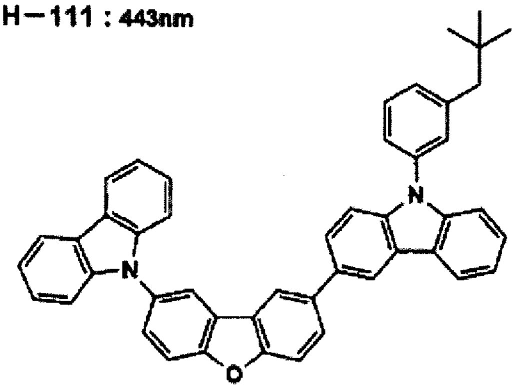

**H−112 : 445nm**

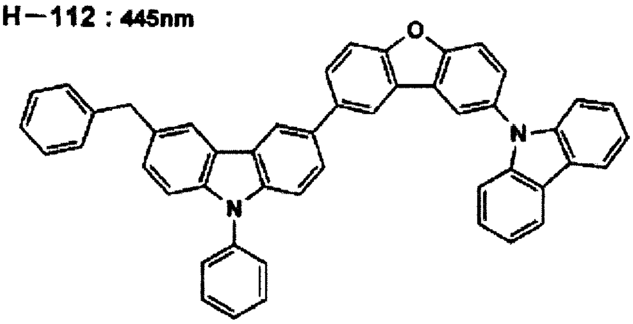

**H−113 : 449nm**

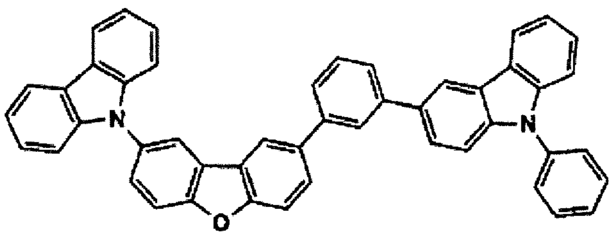

**H−114 : 441nm**

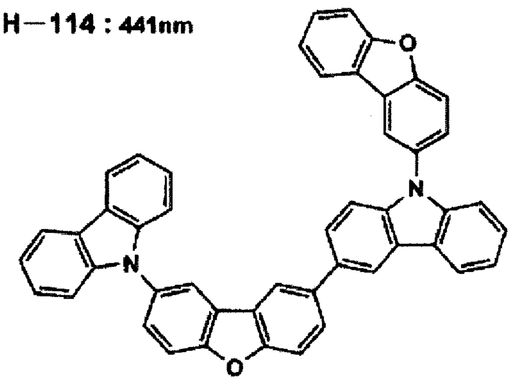

**H−115 : 419nm**

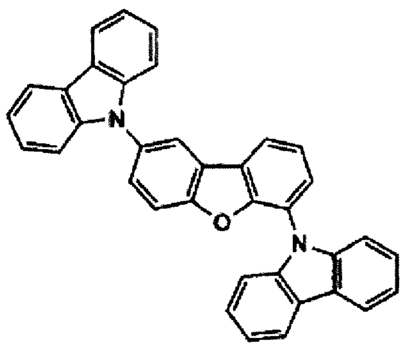

[F48]

H−116 : 448nm

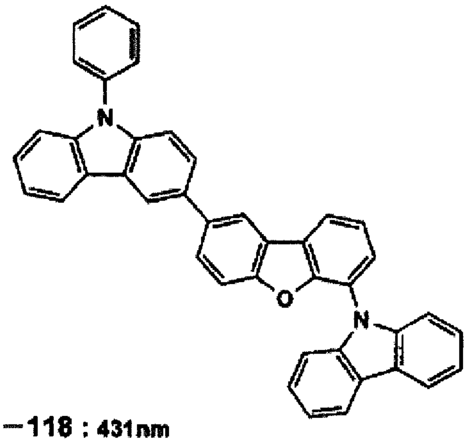

H−117 : 423nm

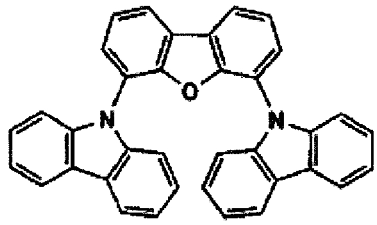

H−118 : 431nm

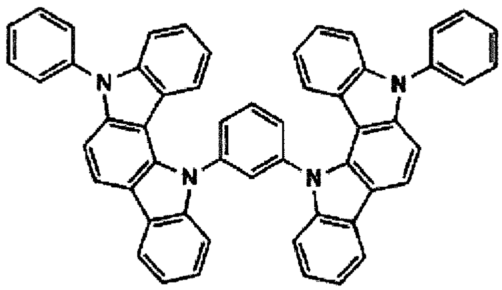

H−119 : 413nm

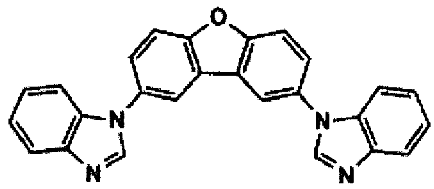

H−120 : 403nm

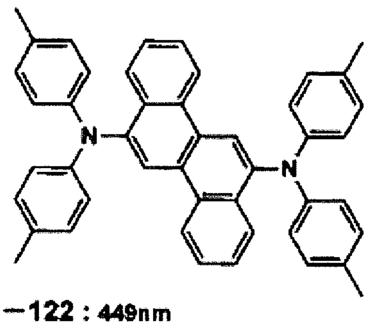

H−121 : 408nm

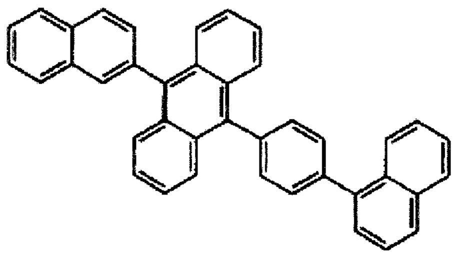

H−122 : 449nm

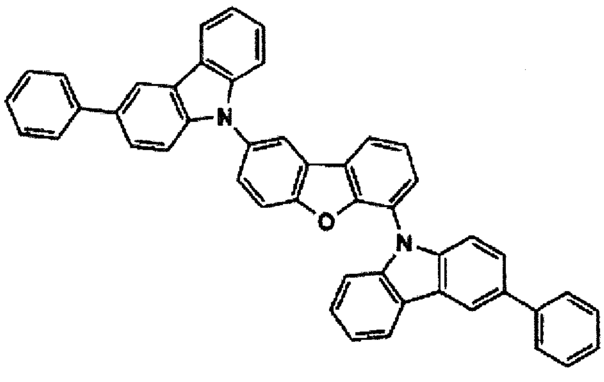

[F49]

**H−123 : 449nm**

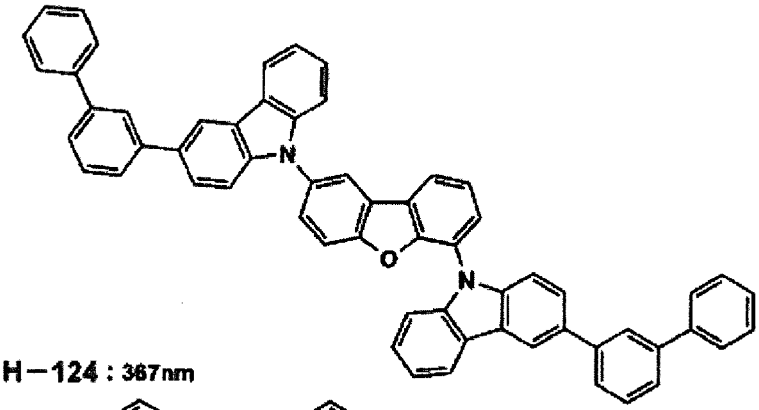

**H−124 : 367nm**

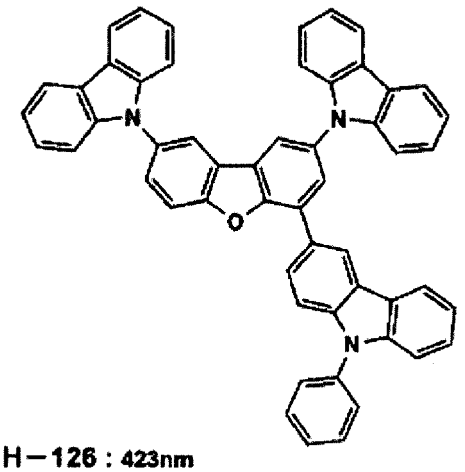

**H−125 : 436nm**

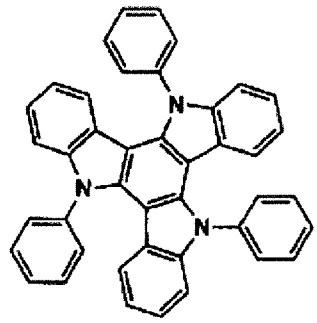

**H−126 : 423nm**

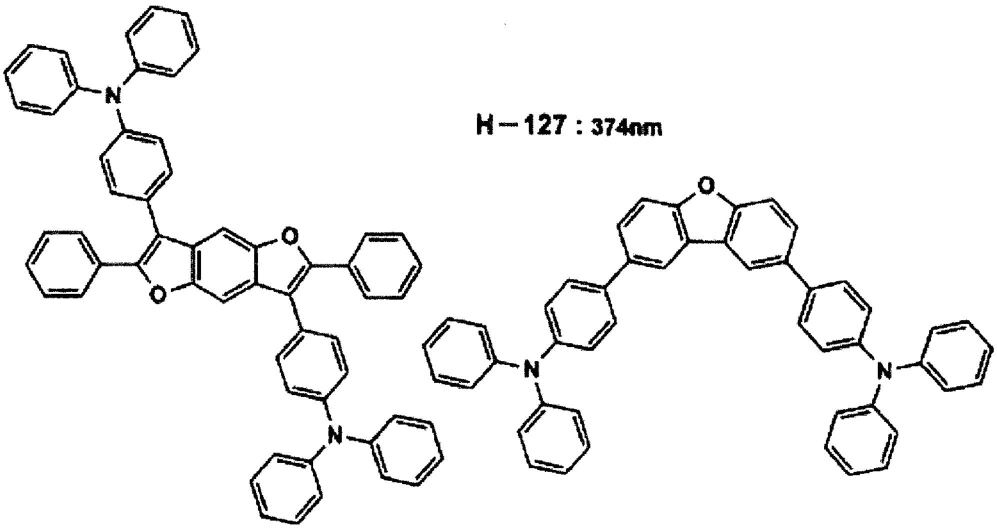

**H−127 : 374nm**

[F50]

H−128 : 409nm

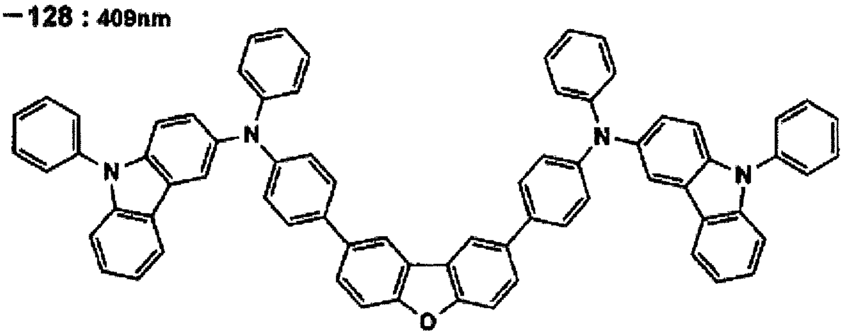

H−129 : 441nm

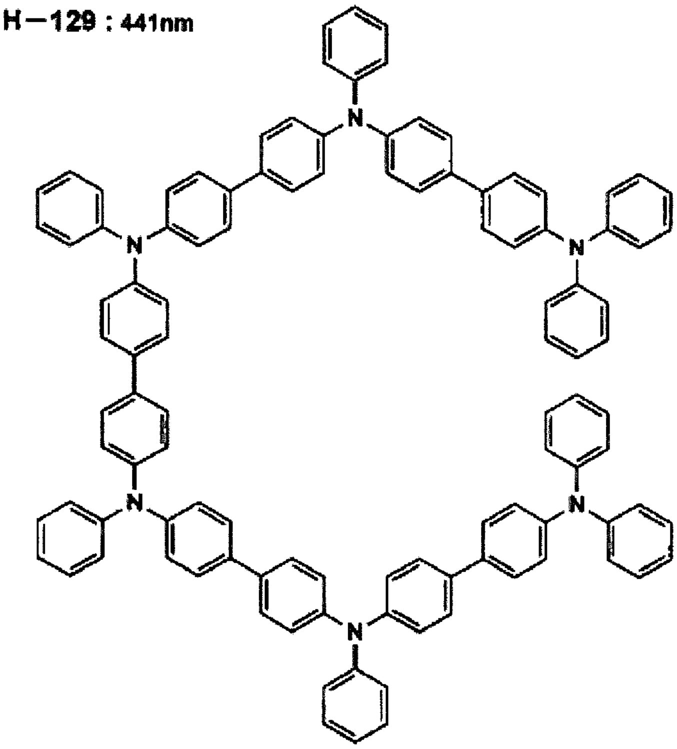

H−130 : 422nm

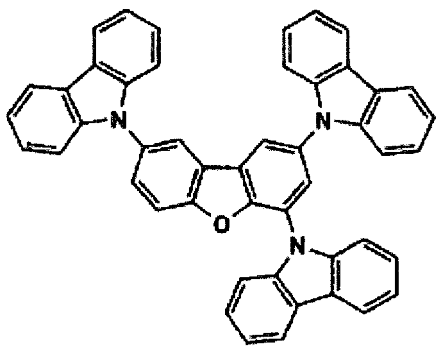

H−131 : 430nm

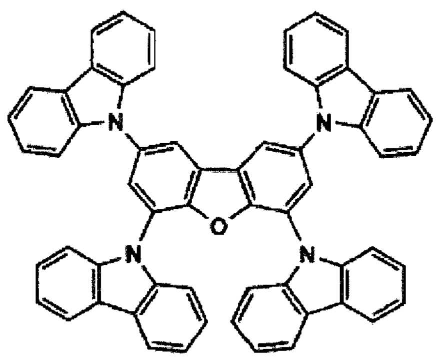

[F51]

H－132 : 417nm

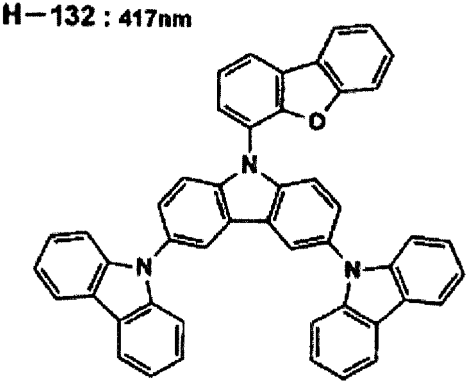

H－133 : 451nm

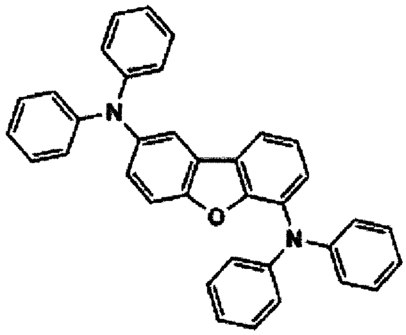

H－134 : 454nm

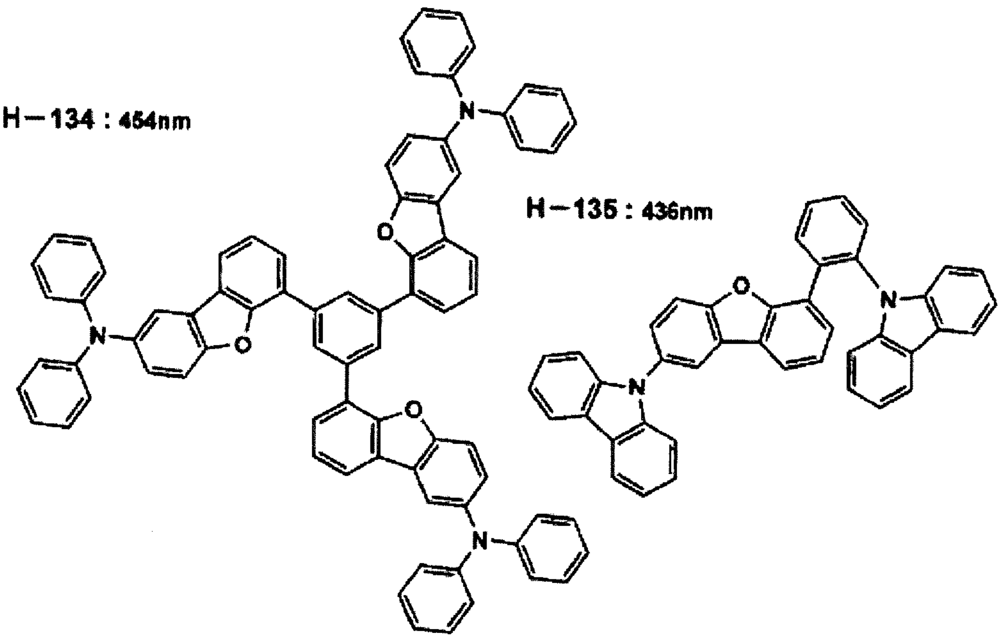

H－135 : 436nm

H－136 : 418nm

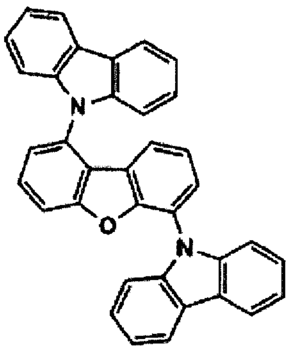

H－137 : 434nm

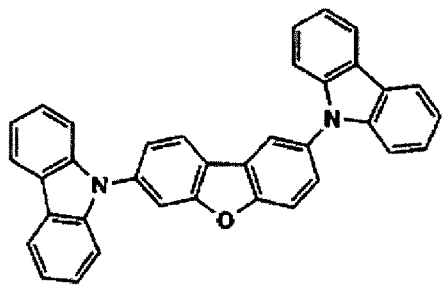

[F52]

H−138 : 420nm

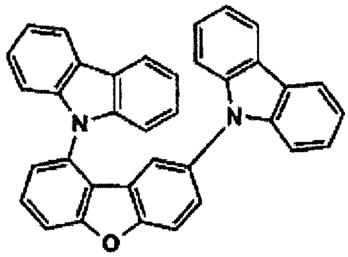

H−139 : 411nm

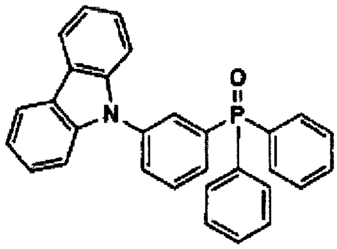

H−140 : 452nm

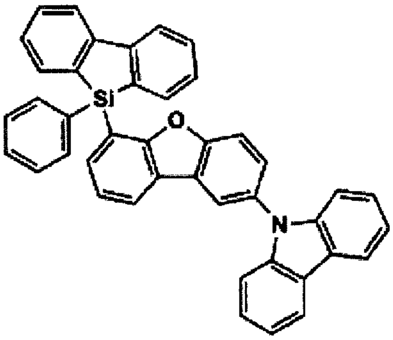

H−141 : 419nm

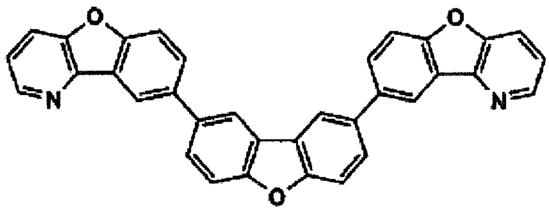

H−142 : 450nm

H−143 : 416nm

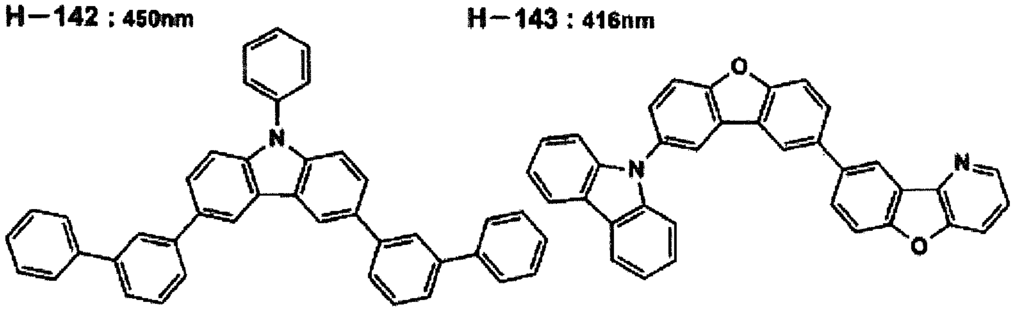

H−144 : 440nm

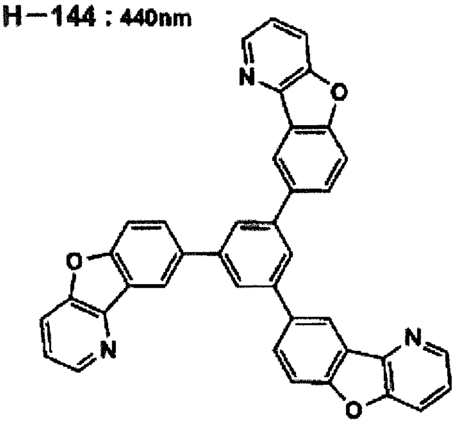

H−145 : 415nm

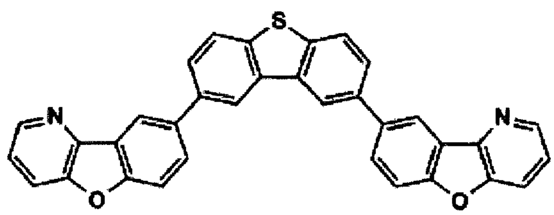

[F53]

**H-146 : 449nm**

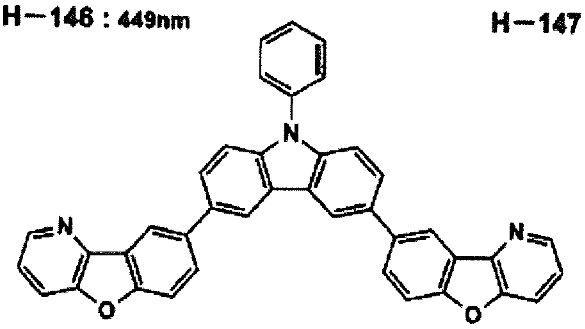

**H-147 : 414nm**

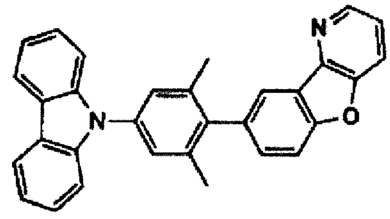

**H-148 : 411nm**

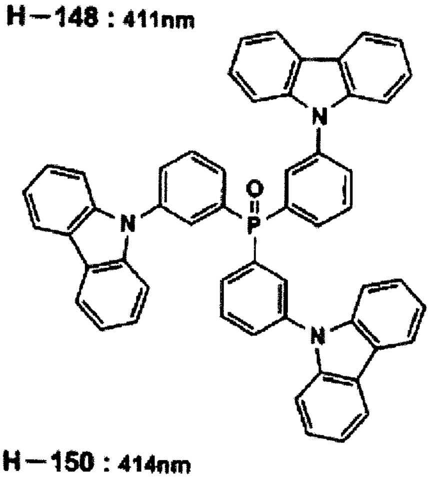

**H-149 : 415nm**

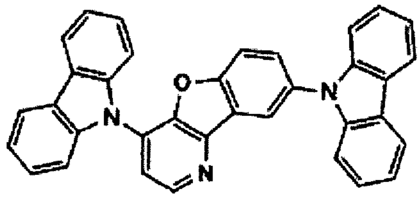

**H-150 : 414nm**

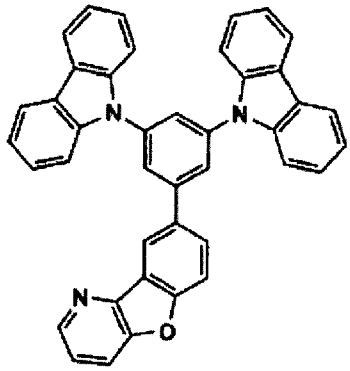

**H-151 : 458nm**

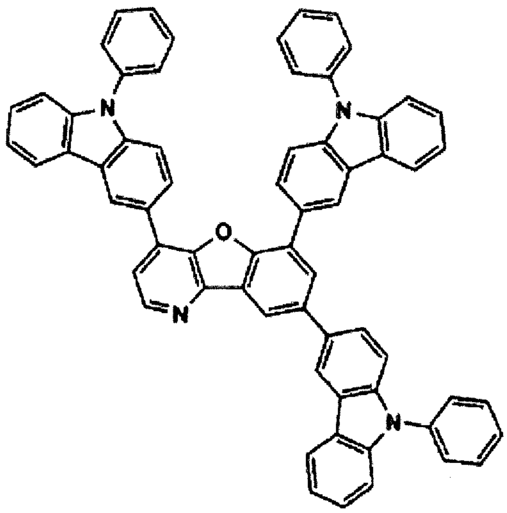

**H-152 : 447nm**

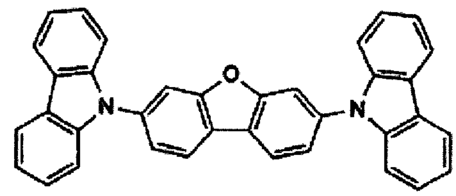

[F54]

H−153 : 452nm

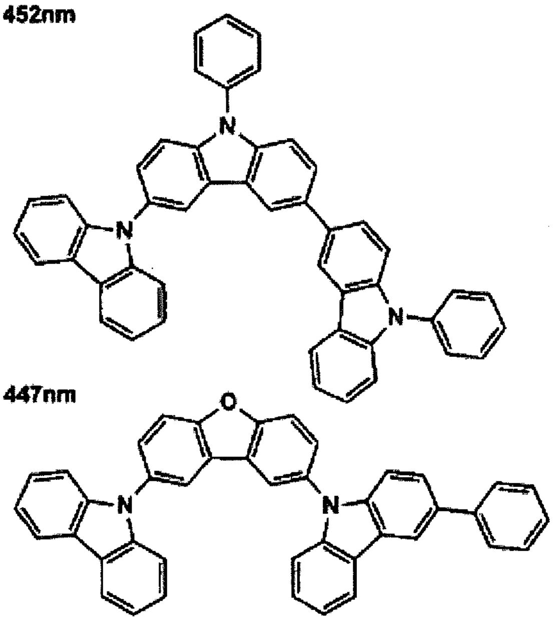

H−154 : 447nm

H−155 : 447nm

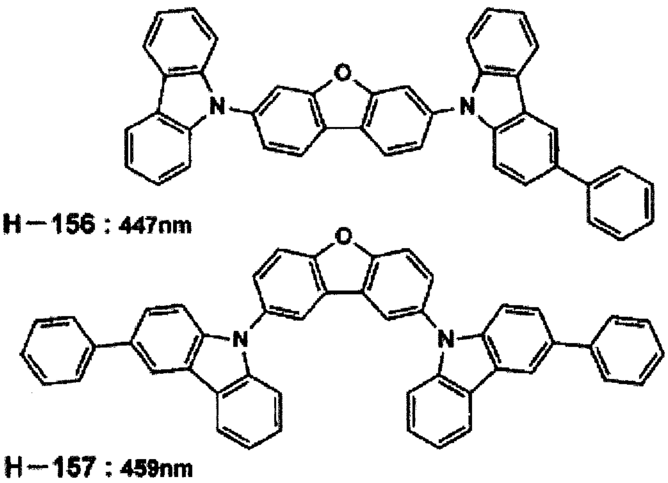

H−156 : 447nm

H−157 : 459nm

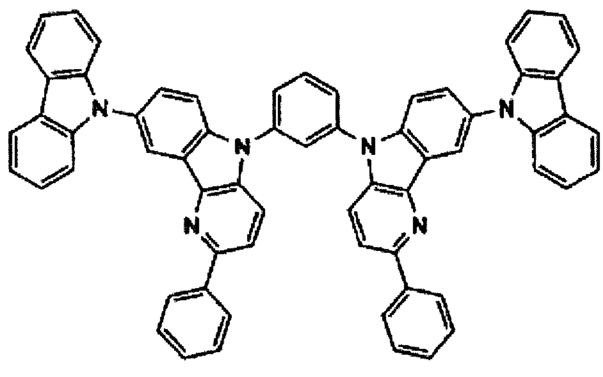

[F55]

H−158 : 458nm

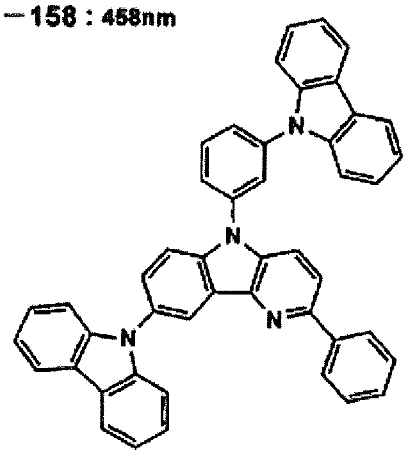

H−159 : 444nm

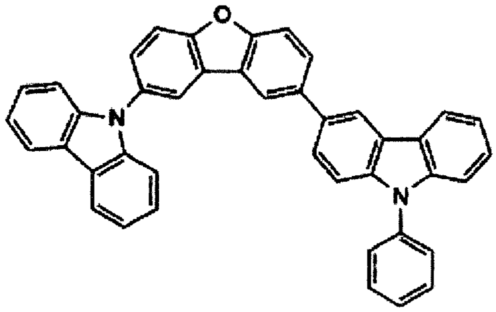

H−160 : 417nm

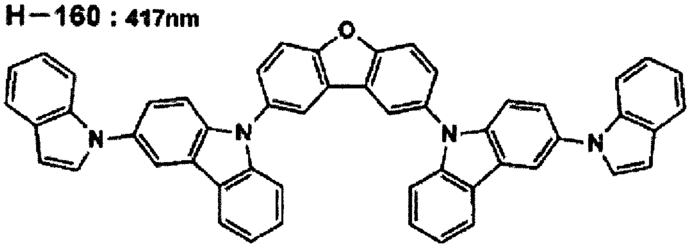

H−161 : 446nm

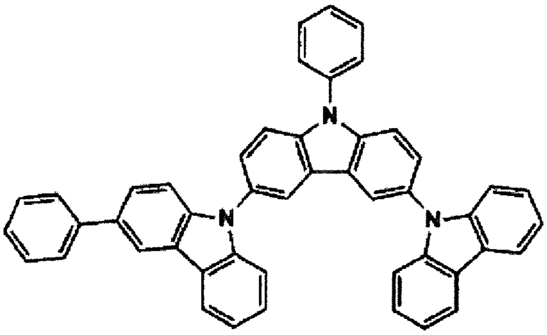

H−162 : 411nm

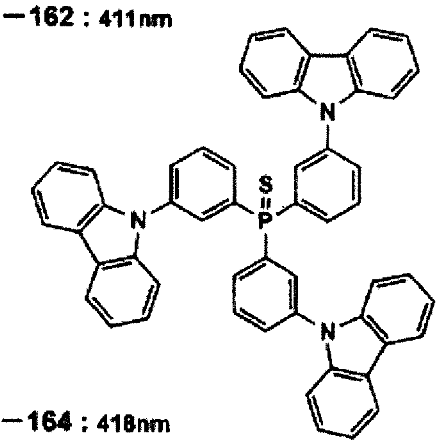

H−163 : 439nm

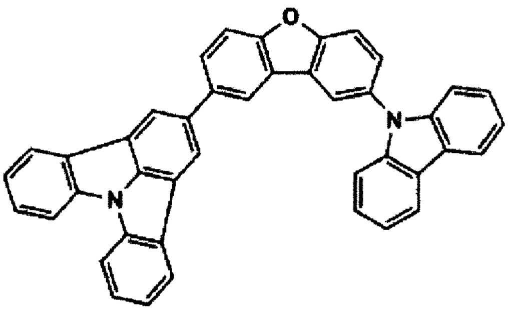

H−164 : 418nm

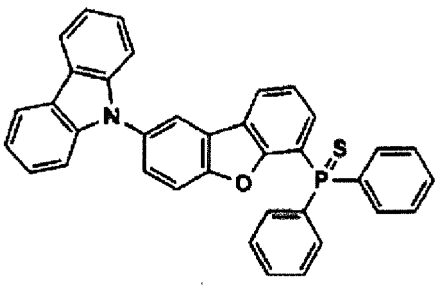

[F56]

**H−165 : 450nm**

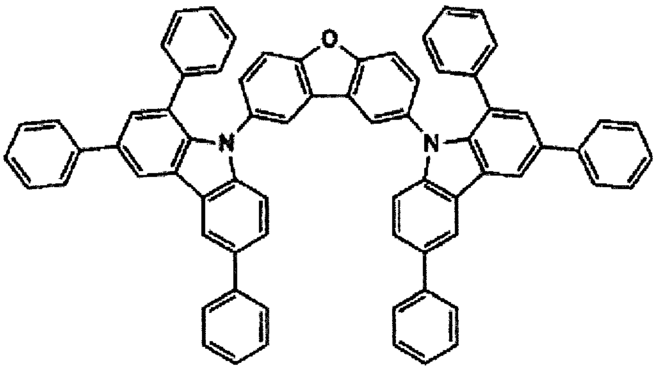

**H−166 : 431nm**

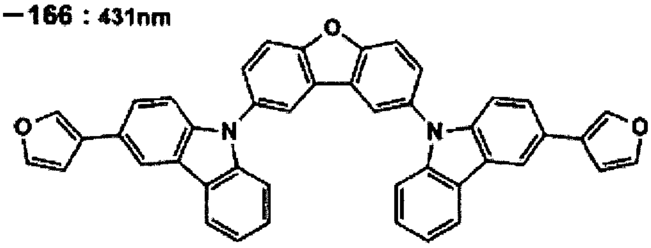

**H−167 : 457nm**

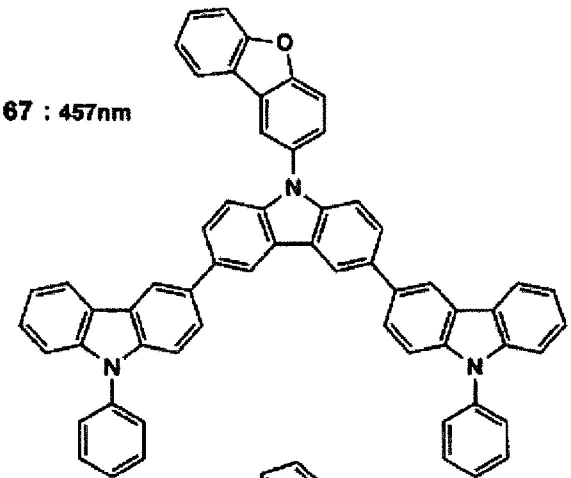

**H−168 : 452nm**

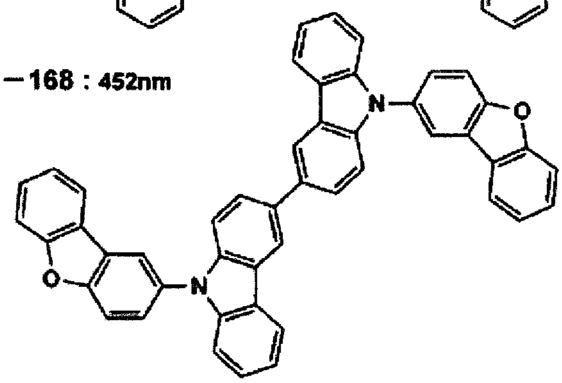

[F57]

H－169 : 449nm

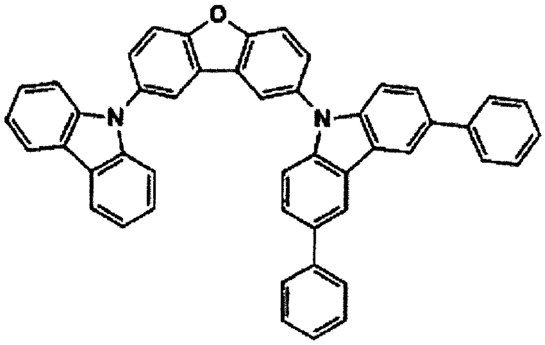

H－170 : 418nm

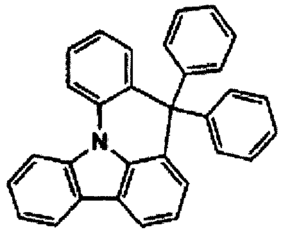

H－171 : 337nm

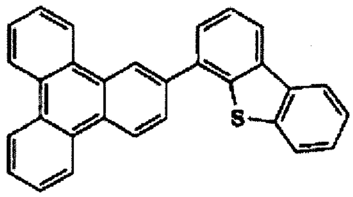

H－172 : 430nm

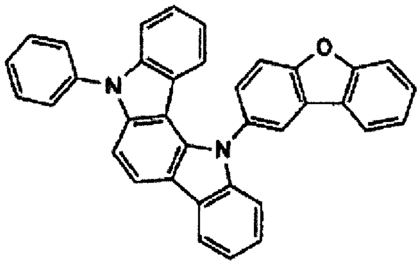

H－173 : 386nm

H－174 : 442nm

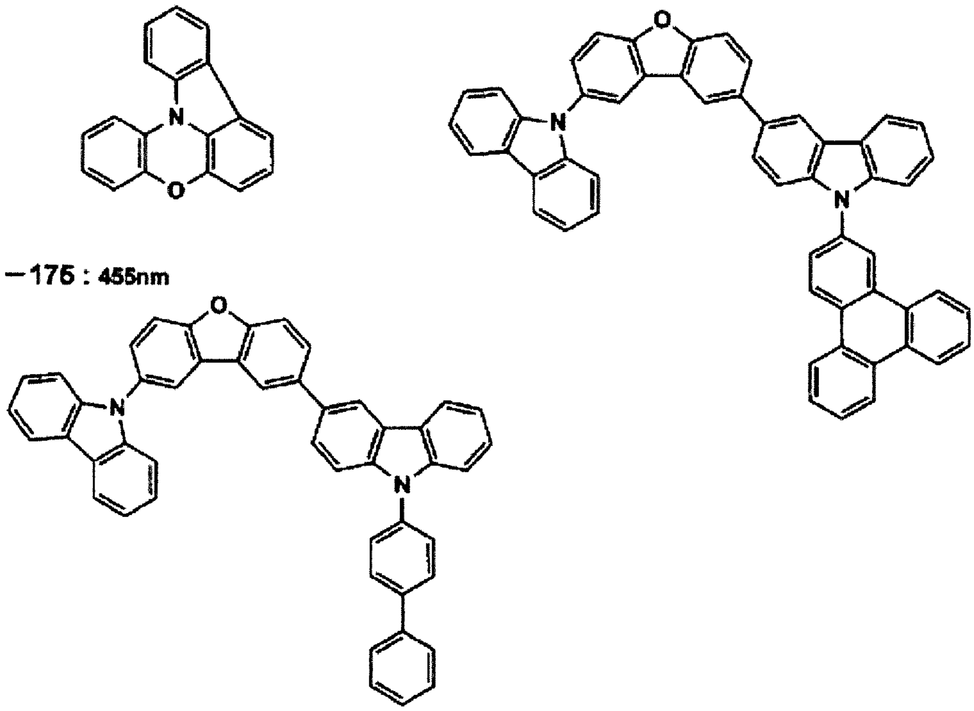

H－175 : 455nm

[F58]

H−176 : 461nm

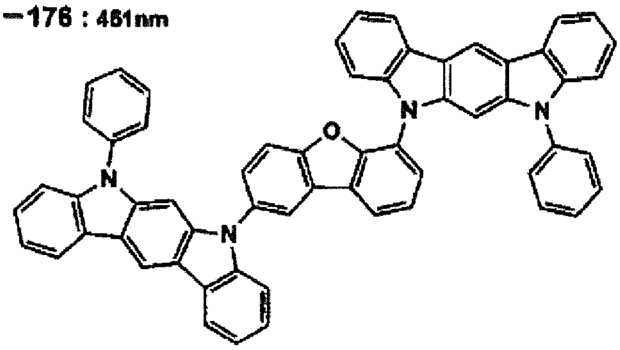

H−177 : 451nm

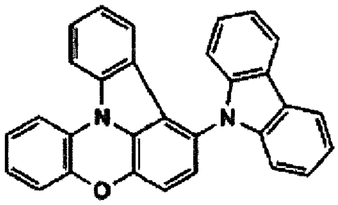

H−178 : 448nm

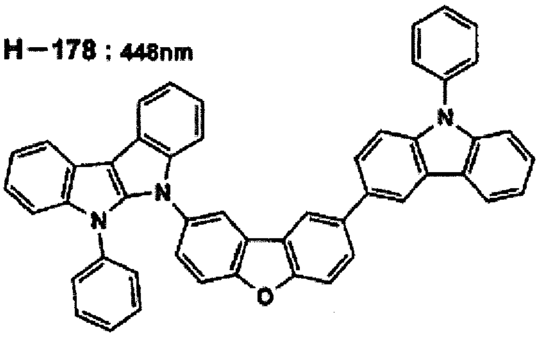

H−179 : 414nm

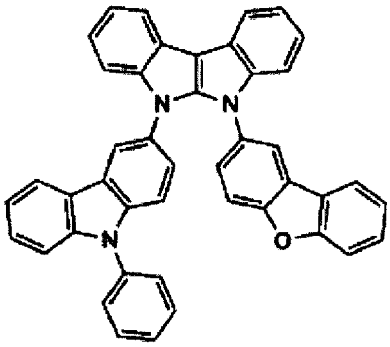

H−180 : 441nm

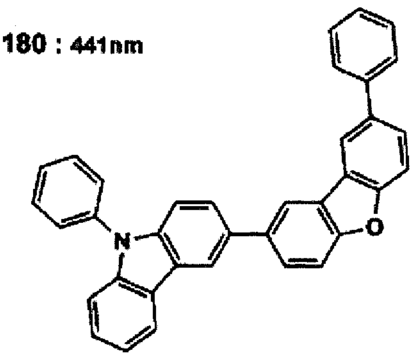

H−181 : 445nm

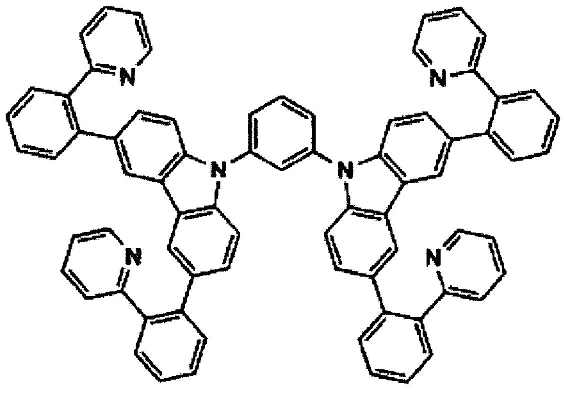

[F59]

**H−182 : 446nm**

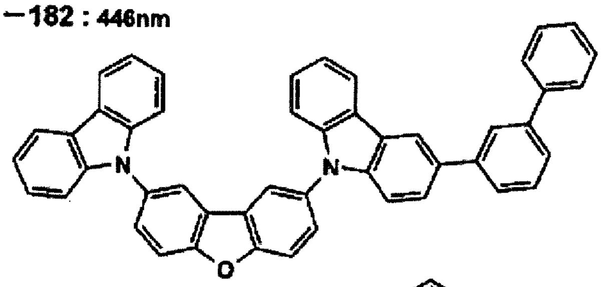

**H−183 : 448nm**

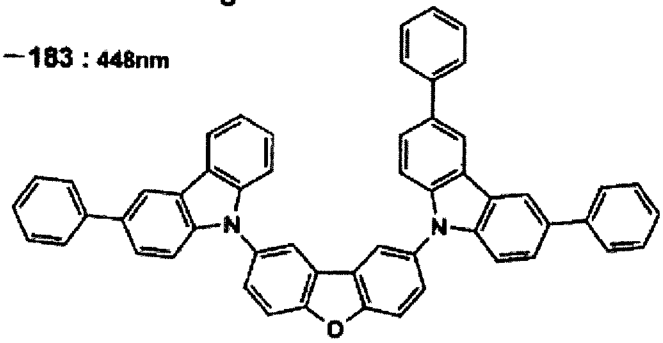

**H−184 : 446nm**

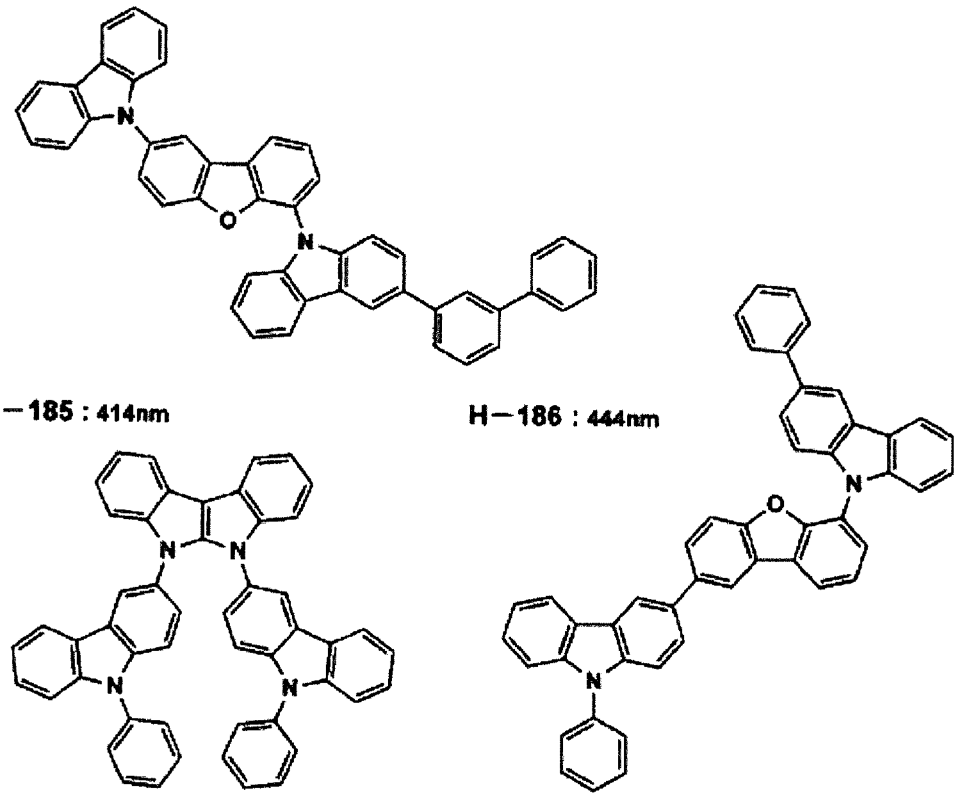

**H−185 : 414nm**

**H−186 : 444nm**

[F60]

**H−187 : 449nm**

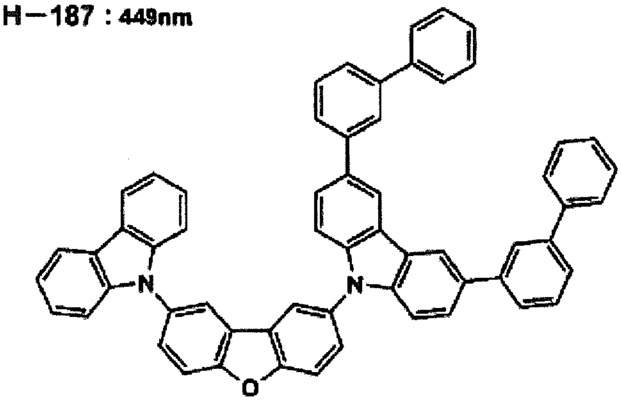

**H−188 : 456nm**

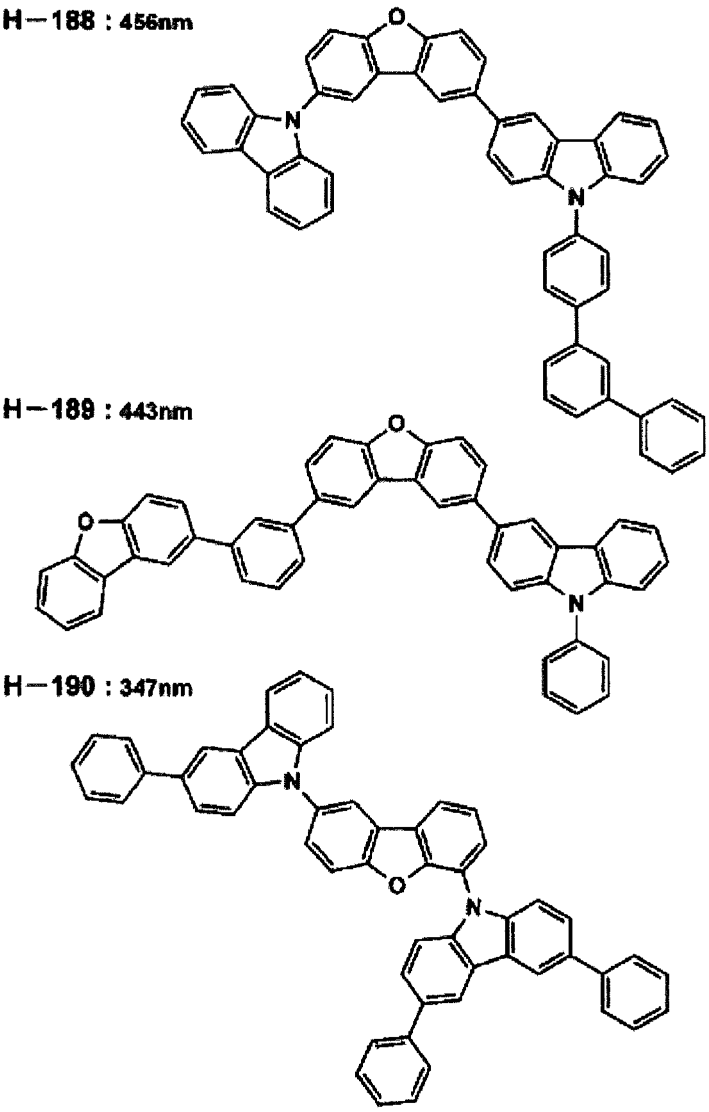

**H−189 : 443nm**

**H−190 : 347nm**

[F61]

H−191 : 449nm

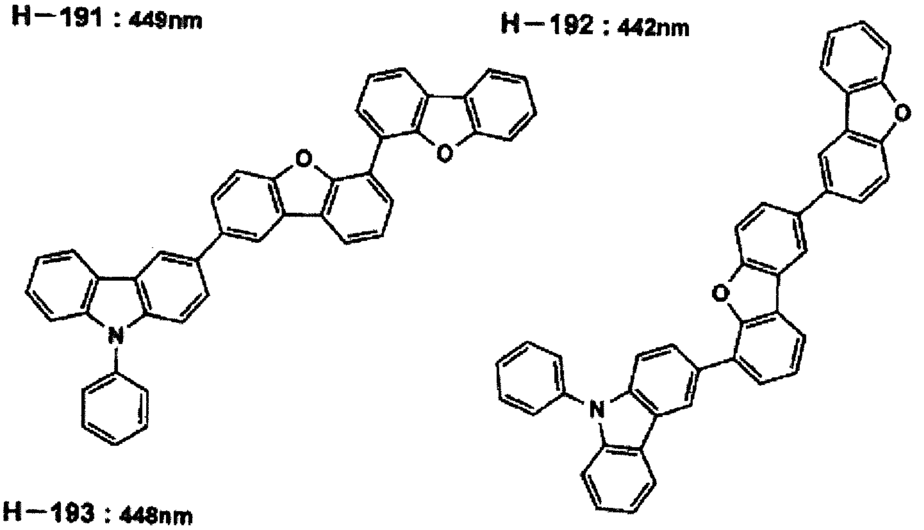

H−192 : 442nm

H−193 : 448nm

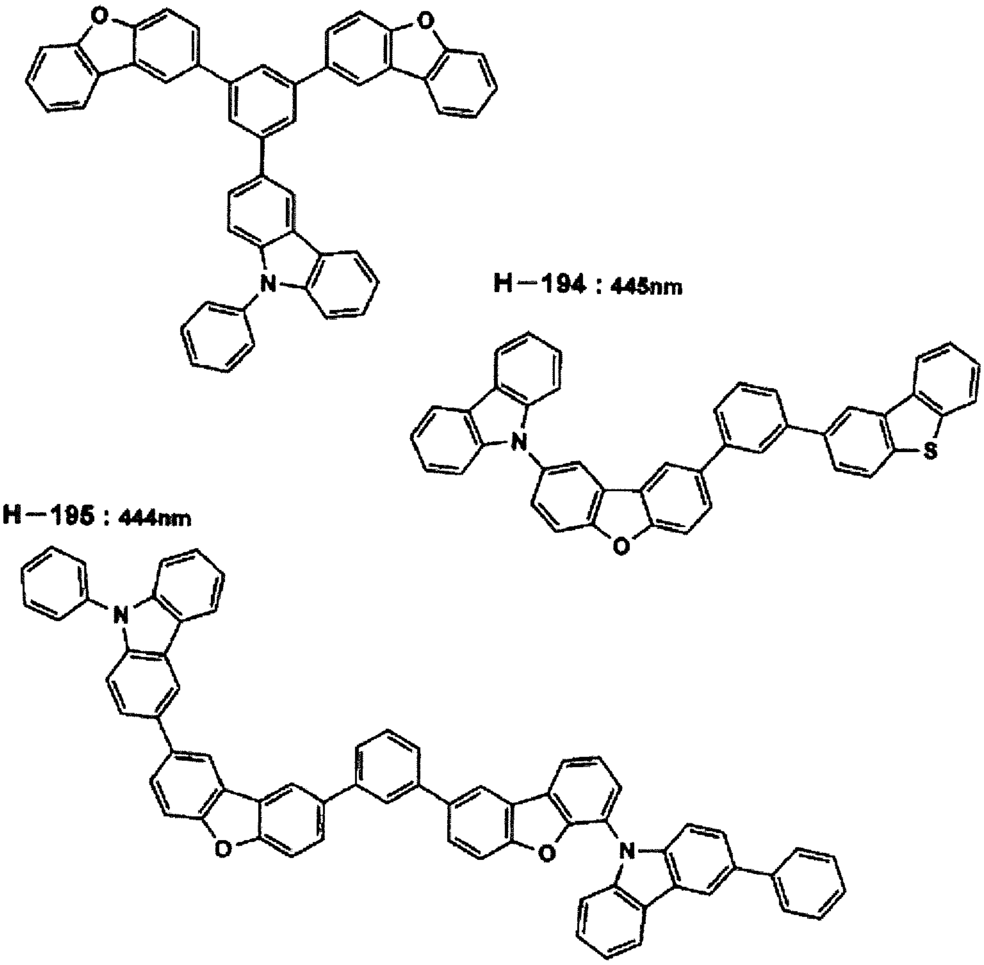

H−194 : 445nm

H−195 : 444nm

[F62]

H−196 : 446nm

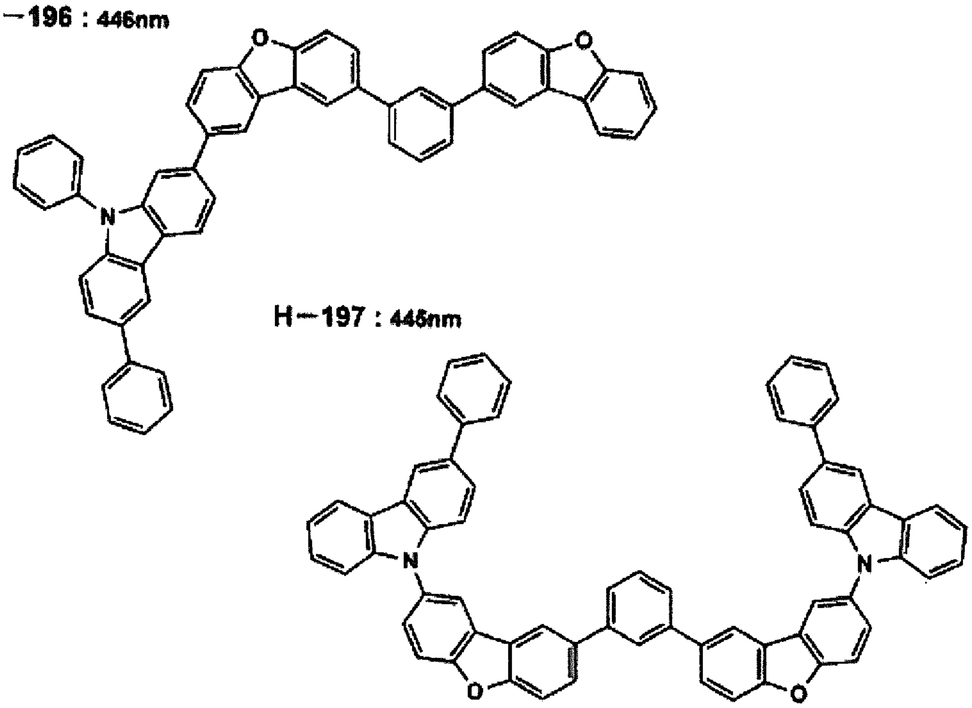

H−197 : 445nm

H−198 : 440nm

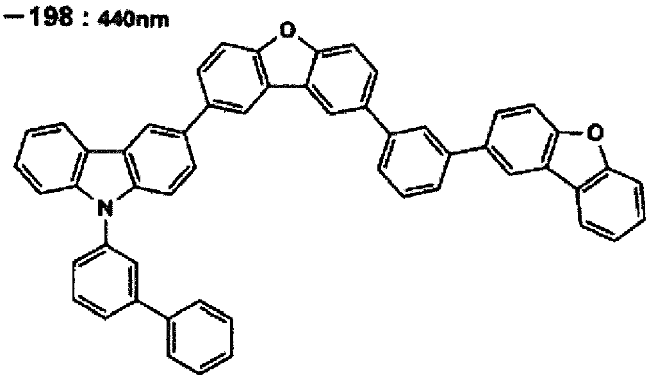

H−199 : 442nm

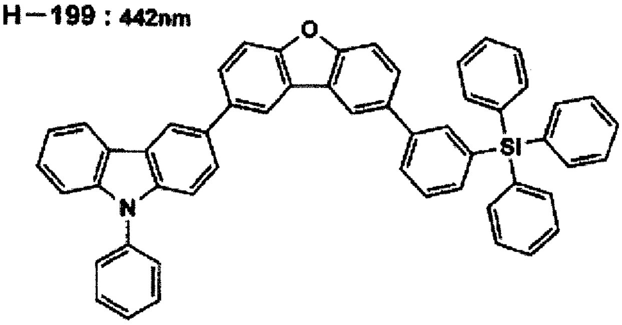

[F63]

**H−200 : 439nm**

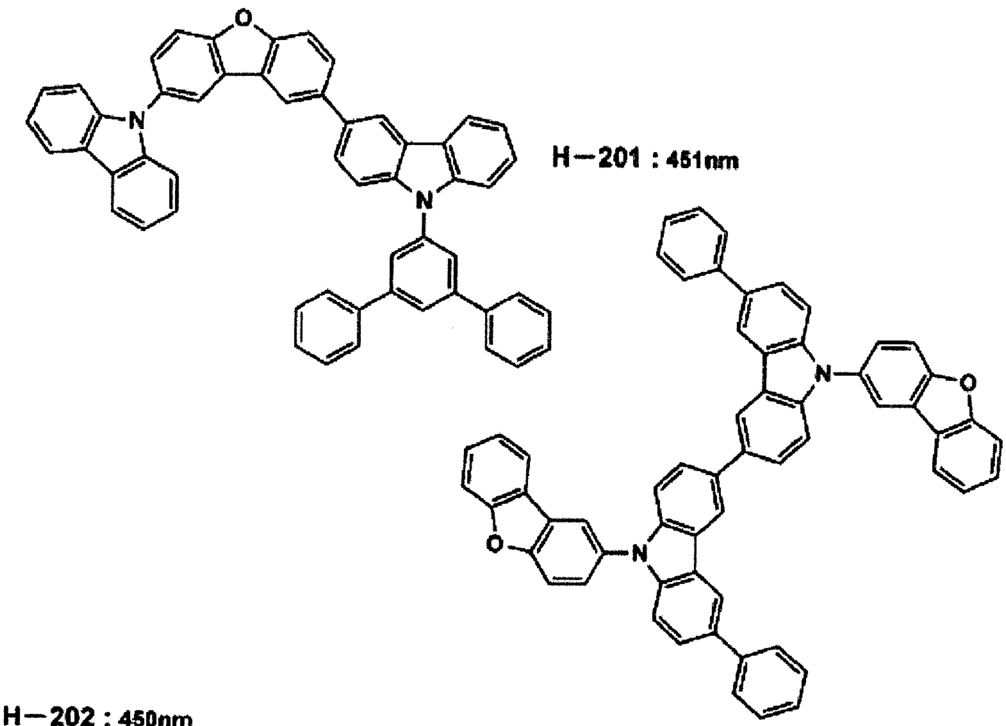

**H−201 : 451nm**

**H−202 : 450nm**

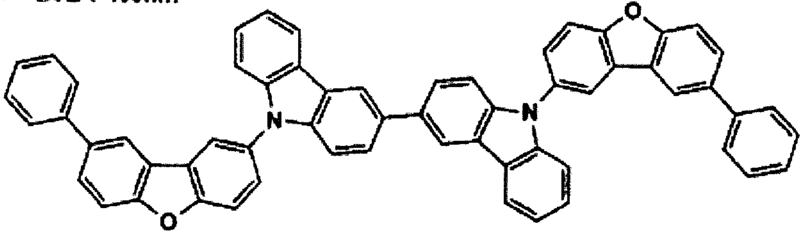

**H−203 : 451nm**

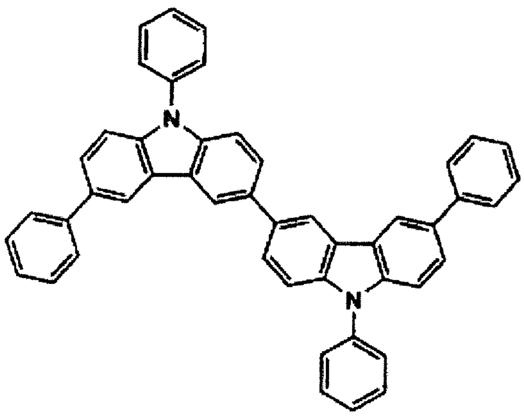

[F64]

H−204 : 446nm

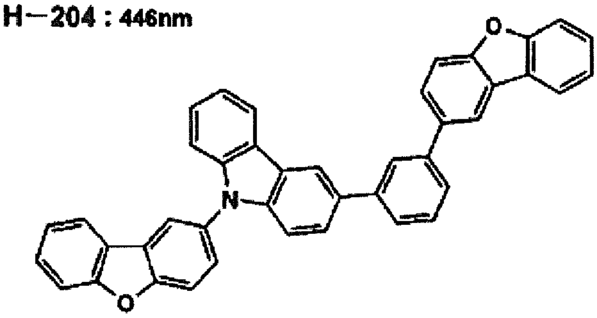

H−205 : 430nm

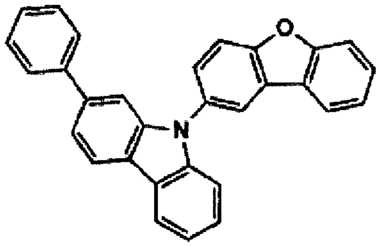

H−206 : 419nm

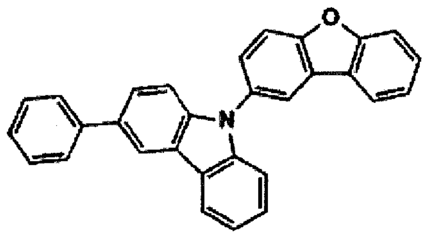

H−207 : 445nm

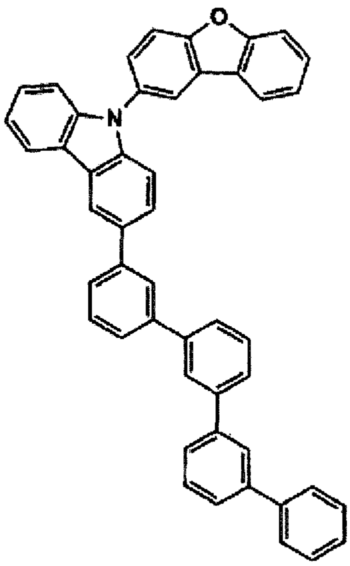

H−208 : 445nm

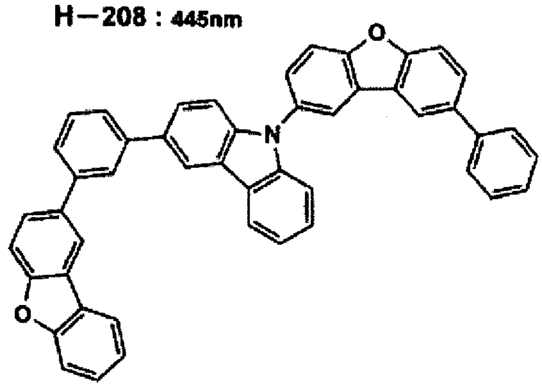

H−209 : 446nm

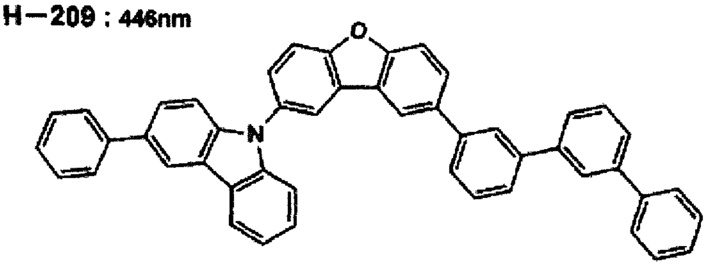

<Layer configuration of organic EL element>

Typical examples of the configuration of the organic EL element of the present invention include, but are not limited to, the following configurations.

(1) Anode/light-emitting layer/cathode
(2) Anode/light-emitting layer/electron transporting layer/cathode
(3) Anode/hole transporting layer/light-emitting layer/cathode

(4) Anode/hole transporting layer/light-emitting layer/electron transporting layer/cathode
(5) Anode/hole transporting layer/light-emitting layer/electron transporting layer/electron injecting layer/cathode
(6) Anode/hole injecting layer/hole transporting layer/light-emitting layer/electron transporting layer/cathode
(7) Anode/hole injecting layer/hole transporting layer/(electron blocking layer)/light-emitting layer/(hole blocking layer)/electron transporting layer/electron injecting layer/cathode

Among the aforementioned configurations, configuration (7) is preferred, but any other configuration may be used.
The light-emitting layer used in the present invention is composed of a single layer or a plurality of sublayers. A light-emitting layer composed of a plurality of light-emitting sublayers may include a non-luminescent intermediate sublayer between the light-emitting sublayers.
A hole blocking layer (also referred to as "hole barrier layer") or an electron injecting layer (also referred to as "cathode buffer layer") may optionally be disposed between the light-emitting layer and the cathode. An electron blocking layer (also referred to as "electron barrier layer") or a hole injecting layer (also referred to as "anode buffer layer") may be disposed between the light-emitting layer and the anode.
The electron transporting layer used in the present invention, which has a function of transporting electrons, encompasses the electron injecting layer and the hole blocking layer in a broad sense. The electron transporting layer may be composed of a plurality of sublayers.
The hole transporting layer used in the present invention, which has a function of transporting holes, encompasses the hole injecting layer and the electron blocking layer in a broad sense. The hole transporting layer may be composed of a plurality of sublayers.
In the typical configurations described above, any of the layers other than the anode and the cathode may also be referred to as "organic layer."

(Tandem structure)

The organic EL element of the present invention may have a tandem structure including a plurality of light-emitting units each including at least one light-emitting layer.
A typical tandem structure of the organic EL element is as follows:
Anode/first light-emitting unit/intermediate layer/second light-emitting unit/intermediate layer/third light-emitting unit/cathode
In this structure, the first, second, and third light-emitting units may be identical to or different from one another. Any two of the light-emitting units may be identical to each other, and may be different from the remaining one unit.
Two light-emitting units may be bonded directly to each other, or an intermediate layer may be disposed therebetween. The intermediate layer is generally also called "intermediate electrode," "intermediate conductive layer," "charge generating layer," "electron extraction layer," "connection layer," or "intermediate insulating layer." Any known material can be used for forming an intermediate layer capable of supplying electrons to the adjacent layer on the anode and supplying holes to the adjacent layer on the cathode.
Examples of the material used for the intermediate layer include, but are not limited to, conductive inorganic compounds, such as indium tin oxide (ITO), indium zinc oxide (IZO), $ZnO_2$, TiN, ZrN, HfN, $TiO_x$, $VO_x$, CuI, InN, GaN, $CuAlO_2$, $CuGaO_2$, $SrCu_2O_2$, $LaB_6$, $RuO_2$, and Al; two-layer films, such as $Au/Bi_2O_3$; multi-layer films, such as $SnO_2/Ag/SnO_2$, ZnO/Ag/ZnO, $Bi_2O_3/Au/Bi_2O_3$, $TiO_2/TiN/TiO_2$, and $TiO_2/ZrN/TiO_2$; fullerene compounds, such as $C_{60}$; conductive organic substances, such as oligothiophene; and conductive organic compounds, such as metal phthalocyanines, metal-free phthalocyanines, metal porphyrins, and metal-free porphyrins.
Examples of preferred light-emitting units include, but are not limited to, the aforementioned typical device configurations (1) to (7) (exclusive of the anode and the cathode).
Specific examples of tandem organic EL elements include, but are not limited to, device configurations and constituent materials disclosed in U.S. Patent Nos. 6337492, 7420203, 7473923, 6872472, 6107734, and 6337492, International Patent Publication WO2005/009087, Japanese Patent Application Laid-Open Publication Nos. 2006-228712, 2006-24791, 2006-49393, 2006-49394, 2006-49396, 2011-96679, and 2005-340187, Japanese Patent Nos. 4711424, 3496681, 3884564, and 4213169, Japanese Patent Application Laid-Open Publication Nos. 2010-192719, 2009-076929, 2008-078414, 2007-059848, 2003-272860, and 2003-045676, and International Patent Publication WO2005/094130.
Now will be described the respective layers forming the organic EL element of the present invention.

[Light-emitting layer]

The light-emitting layer used in the present invention is a layer where electrons and holes injected from the

electrodes or adjacent layers are recombined to emit light through excitons. A light emission portion may be located within the light-emitting layer or at the interface between the light-emitting layer and the layer adjacent thereto. The light-emitting layer may have any configuration satisfying the requirements of the present invention.

The light-emitting layer may have any total thickness. The light-emitting layer has a total thickness of preferably 2 nm to 5 μm, more preferably 2 to 500 nm, still more preferably 5 to 200 nm, in view of the homogeneity of the layer, inhibition of application of unnecessarily high voltage upon light emission, and an improvement in stability of emission color against driving current.

Each of the sublayers forming the light-emitting layer has a thickness of preferably 2 nm to 1 μm, more preferably 2 to 200 nm, still more preferably 3 to 150 nm.

The light-emitting layer used in the present invention preferably contains the aforementioned TADF compound and phosphorescent metal complex as a light-emitting dopant (hereinafter also referred to as "light-emitting dopant compound, " "dopant compound," or "dopant") and the aforementioned host compound (also referred to as "matrix material" or "host").

[Electron transporting layer]

The electron transporting layer used in the present invention, which is composed of a material having electron transportability, only needs to have a function of transferring electrons injected from the cathode to the light-emitting layer.

The electron transporting layer may have any thickness . The electron transporting layer generally has a thickness of 2 nm to 5 μm, more preferably 2 to 500 nm, still more preferably 5 to 200 nm.

In the organic EL element, when light emitted from the light-emitting layer is extracted through an electrode, light extracted directly from the light-emitting layer interferes with light reflected by the counter electrode. If light is reflected by the cathode, the thickness of the electron transporting layer can be appropriately adjusted to several nm to several μm, to effectively utilize this interference phenomenon.

An increase in thickness of the electron transporting layer tends to cause an increase in voltage. Thus, an electron transporting layer having a large thickness preferably has an electron mobility of $10^{-5}$ $cm^2/Vs$ or more.

The material used for the electron transporting layer (hereinafter referred to as "electron transporting material") may be any of conventional compounds capable of injecting or transporting electrons or blocking holes.

Examples of the electron transporting material include nitrogen-containing aromatic heterocyclic derivatives (e.g., carbazole derivatives, azacarbazole derivatives (wherein at least one of the carbon atoms forming the carbazole ring is substituted by a nitrogen atom), pyridine derivatives, pyrimidine derivatives, pyrazine derivatives, pyridazine derivatives, triazine derivatives, quinolone derivatives, quinoxaline derivatives, phenanthroline derivatives, azatriphenylene derivatives, oxazole derivatives, thiazole derivatives, oxadiazole derivatives, thiadiazole derivatives, triazole derivatives, benzimidazole derivatives, benzoxazole derivatives, and benzothiazole derivatives), dibenzofuran derivatives, dibenzothiophene derivatives, silole derivatives, and aromatic hydrocarbon derivatives (e.g., naphthalene derivatives, anthracene derivatives, and triphenylene).

The electron transporting material may be a metal complex having a quinolinol or dibenzoquinolinol skeleton as a ligand. Examples of the metal complex include tris(8-quinolinol)aluminum (Alq), tris(5,7-dichloro-8-quinolinol)aluminum, tris(5,7-dibromo-8-quinolinol)aluminum, tris(2-methyl-8-quinolinol)aluminum, tris(5-methyl-8-quinolinol)aluminum, bis(8-quinolinol)zinc (Znq), and metal complexes where the central metal of any of these complexes is substituted by In, Mg, Cu, Ca, Sn, Ga or Pb.

The electron transporting material may also be a metal phthalocyanine, a metal-free phthalocyanine, or a metal or metal-free phthalocyanine whose end is substituted by an alkyl group or a sulfonate group. The electron transporting material may also be a distyrylpyrazine derivative, which has been exemplified as a material for the light-emitting layer, or may be an inorganic semiconductor material (e.g., n-type Si or n-type SiC) as in the case of the hole injecting layer or the hole transporting layer.

The electron transporting material may be a polymer material prepared by incorporation of any of these materials into a polymer chain, or a polymer material having a main chain composed of any of these materials.

The electron transporting layer used in the present invention may be a highly negative (electron-rich) electron transporting layer doped with a dopant serving as a guest. Examples of the dopant include n-type dopants, such as metal compounds (e.g., metal complexes and metal halides). Specific examples of the electron transporting layer having the aforementioned configuration include those disclosed in Japanese Patent Application Laid-Open Publication Nos. H4-297076, H10-270172, 2000-196140, and 2001-102175, and J. Appl. Phys., 95, 5773 (2004).

Specific examples of known electron transporting materials preferably used in the organic EL element of the present invention include, but are not limited to, compounds described in U.S. Patent Nos. 6528187 and 7230107, U.S. Patent Application Publication Nos. 2005/0025993, 2004/0036077, 2009/0115316, 2009/0101870, and 2009/0179554, International Patent Publication WO2003/060956 and WO2008/132085, Appl. Phys. Lett. 75, 4 (1999), Appl. Phys. Lett. 79, 449 (2001), Appl. Phys. Lett. 81, 162 (2002), Appl. Phys. Lett. 81, 162 (2002), Appl. Phys. Lett. 79, 156 (2001), U.S.

Patent No. 7964293, U.S. Patent Application Publication No. 2009/030202, International Patent Publication WO2004/080975, WO2004/063159, WO2005/085387, WO2006/067931, WO2007/086552, WO2008/114690, WO2009/069442, WO2009/066779, WO2009/054253, WO2011/086935, WO2010/150593, and WO2010/047707, EP 2311826, Japanese Patent Application Laid-Open Publication Nos. 2010-251675, 2009-209133, 2009-124114, 2008-277810, 2006-156445, 2005-340122, 2003-45662, 2003-31367, and 2003-282270, and International Patent Publication WO2012/115034.

Examples of more preferred electron transporting materials include pyridine derivatives, pyrimidine derivatives, pyrazine derivatives, triazine derivatives, dibenzofuran derivatives, dibenzothiophene derivatives, carbazole derivatives, azacarbazole derivatives, and benzimidazoles derivatives.

These electron transporting materials may be used alone or in combination.

[Hole blocking layer]

The hole blocking layer functions as an electron transporting layer in a broad sense and is preferably composed of a material which transports electrons and has a low capability of transporting holes. The hole blocking layer transports electrons and blocks holes, thereby increasing the probability of recombination of electrons and holes.

The aforementioned electron transporting layer may optionally be used as the hole blocking layer described herein.

In the organic EL element of the present invention, the hole blocking layer is preferably disposed adjacent to the light-emitting layer on the cathode side.

The hole blocking layer used in the present invention has a thickness of preferably 3 to 100 nm, more preferably 5 to 30 nm.

The hole blocking layer is preferably composed of a material used for the aforementioned electron transporting layer, and is also preferably composed of any of the aforementioned host compounds.

[Electron injecting layer]

The electron injecting layer used in the present invention (also referred to as "cathode buffer layer") is provided between the cathode and the light-emitting layer for a reduction in driving voltage or an increase in luminance. The electron injecting layer is detailed in Chapter 2 "Denkyoku Zairyo (Electrode Materials)" (pp. 123-166) of Part 2 of "Yuki EL Soshi to Sono Kogyoka Saizensen (Organic EL element and its forefront of industrialization)" published by NTS Corporation, November 30, 1998.

In the present invention, the electron injecting layer is optionally provided. The electron injecting layer may be disposed between the cathode and the light-emitting layer as described above, or between the cathode and the electron transporting layer.

The electron injecting layer is preferably composed of a very thin film, and has a thickness of preferably 0.1 to 5 nm, which may vary depending on the raw material used. The electron injecting layer may be composed of a film containing a non-uniformly distributed material.

The electron injecting layer is also detailed in Japanese Patent Application Laid-Open Publication Nos. H6-325871, H9-17574, and H10-74586. Specific examples of materials preferably used for the electron injecting layer include metals, such as strontium and aluminum, alkali metal compounds, such as lithium fluoride, sodium fluoride, and potassium fluoride; alkaline earth metal compounds, such as magnesium fluoride and calcium fluoride, metal oxides, such as aluminum oxide, and metal complexes, such as lithium 8-hydroxyquinolate (Liq). The aforementioned electron transporting materials may also be used.

These materials for the electron injecting layer may be used alone or in combination.

[Hole transporting layer]

The hole transporting layer used in the present invention, which is composed of a material having hole transportability, only needs to have a function of transferring holes injected from the anode to the light-emitting layer.

The hole transporting layer may have any thickness. The electron transporting layer generally has a thickness of 5 nm to 5 $\mu$m, more preferably 2 to 500 nm, still more preferably 5 to 200 nm.

The material used for the hole transporting layer (hereinafter referred to as "hole transporting material") may be any of conventional compounds capable of injecting or transporting holes or blocking electrons.

Examples of the hole transporting material include porphyrin derivatives, phthalocyanine derivatives, oxazole derivatives, oxadiazole derivatives, triazole derivatives, imidazole derivatives, pyrazoline derivatives, pyrazolone derivatives, phenylenediamine derivatives, hydrazine derivatives, stilbene derivatives, polyarylalkane derivatives, triarylamine derivatives, carbazole derivatives, indolocarbazole derivatives, isoindole derivatives, acene derivatives, such as anthracene and naphthalene, fluorine derivatives, fluorenone derivatives, poly(vinylcarbazole), polymer materials and oligomers having an aromatic amine in the main chain or side chain, polysilanes, and conductive polymers and oligomers (e.g., PEDOT/PSS, aniline copolymers, polyaniline, and polythiophene).

Examples of the triarylamine derivatives include benzidine derivatives, such as α-NPD, starburst amine derivatives, such as MTDATA, and compounds having fluorine or anthracene on the bonding cores of tryarylamines.

The hole transporting material may also be hexaazatriphenylene derivatives described in Japanese Translation of PCT International Application Publication No. 2003-519432 and Japanese Patent Application Laid-Open Publication No. 2006-135145.

The hole transporting layer may be a highly positive hole transporting layer doped with an impurity. Examples of such an electron transporting layer include those described in Japanese Patent Application Laid-Open Publication Nos. H4-297076, 2000-196140, and 2001-102175, and J. Appl. Phys., 95, 5773 (2004).

The hole transporting material may be a p-type hole transporting material or an inorganic compound (e.g., p-type Si or p-type SiC) described in Japanese Patent Application Laid-Open Publication No. H11-251067 and J. Huang, et al., Applied Physics Letters 80 (2002), p.139. The hole transporting material is preferably an ortho-metalated organometallic complex having Ir or Pt as a central metal, such as $Ir(ppy)_3$.

Among the aforementioned hole transporting materials, preferred are triarylamine derivatives, carbazole derivatives, indolocarbazole derivatives, azatriphenylene derivatives, organometallic complexes, and polymer materials and oligomers having an aromatic amine in the main chain or side chain.

Specific examples of known hole transporting materials preferably used in the organic EL element of the present invention include, but are not limited to, compounds described in the aforementioned publications and described in Appl. Phys. Lett. 69, 2160 (1996), J. Lumin. 72-74, 985 (1997), Appl. Phys. Lett. 78, 673 (2001), Appl. Phys. Lett. 90, 183503 (2007), Appl. Phys. Lett. 90, 183503 (2007), Appl. Phys. Lett. 51, 913 (1987), Synth. Met. 87, 171 (1997), Synth. Met. 91, 209 (1997), Synth. Met. 111, 421 (2000), SID Symposium Digest, 37, 923 (2006), J. Mater. Chem. 3, 319 (1993), Adv. Mater. 6, 677 (1994), Chem. Mater. 15, 3148 (2003), U.S. Patent Application Publication Nos. 2003/0162053, 2002/0158242, 2006/0240279, and 2008/0220265, U.S. Patent No. 5061569, International Patent Publication WO2007/002683 and WO2009/018009, EP No. 650955, U.S. Patent Application Publication Nos. 2008/0124572, 2007/0278938, 2008/0106190, and 2008/0018221, International Patent Publication WO2012/115034, Japanese Translation of PCT International Application Publication No. 2003-519432, Japanese Patent Application Laid-Open Publication No. 2006-135145, and U.S. Patent Application No. 13/585981.

These hole transporting materials may be used alone or in combination.

[Electron blocking layer]

The electron blocking layer functions as a hole transporting layer in a broad sense and is preferably composed of a material which transports holes and has a low capability of transporting electrons. The electron blocking layer transports holes and blocks electros, thereby increasing the probability of recombination of electrons and holes.

The aforementioned hole transporting layer may optionally be used as the electron blocking layer described herein.

In the organic EL element of the present invention, the electron blocking layer is preferably disposed adjacent to the light-emitting layer on the anode side.

The electron blocking layer used in the present invention has a thickness of preferably 3 to 100 nm, more preferably 5 to 30 nm.

The electron blocking layer is preferably composed of a material used for the aforementioned hole transporting layer, and is also preferably composed of any of the aforementioned host compounds.

[Hole injecting layer]

The hole injecting layer used in the present invention (also referred to as "anode buffer layer") is provided between the anode and the light-emitting layer for a reduction in driving voltage or an increase in luminance. The hole injecting layer is detailed in Chapter 2 "Denkyoku Zairyo (Electrode Materials) " (pp. 123-166) of Part 2 of " Yuki EL Soshi to Sono Kogyoka Saizensen (Organic EL element and its forefront of industrialization)" published by NTS Corporation, November 30, 1998."

In the present invention, the hole injecting layer is optionally provided. The hole injecting layer may be disposed between the anode and the light-emitting layer as described above, or between the anode and the hole transporting layer.

The hole injecting layer is also detailed in Japanese Patent Application Laid-Open Publication Nos. H9-45479, H9-260062, and H8-288069. Examples of the material for the hole injecting layer include those used for the aforementioned hole transporting layer.

Examples of particularly preferred materials include phthalocyanine derivatives, such as copper phthalocyanine,

hexaazatriphenylene derivatives described in Japanese Translation of PCT International Application Publication No. 2003-519432 and Japanese Patent Application Laid-Open Publication No. 2006-135145, metal oxides, such as vanadium oxide, amorphous carbon, conductive polymers, such as polyaniline (emeraldine) and polythiophene, ortho-metalated complexes, such as a tris(2-phenylpyridine)iridium complex, and triarylamine derivatives.

These materials for the hole injecting layer maybe used alone or in combination.

[Additive]

Each of the aforementioned organic layers may contain any other additive.

Examples of the additive include halogens, such as bromine, iodine, and chlorine, halides, alkali metals and alkaline earth metals, such as Pd, Ca, and Na, transition metal compounds, complexes, and salts.

The additive content of the organic layer may be appropriately determined. The additive content is preferably 1,000 ppm or less, more preferably 500 ppm or less, still more preferably 50 ppm or less, relative to the entire mass % of the layer containing the additive.

The additive content may fall outside of this range for improvement of electron or hole transportability or effective energy transfer of excitons.

[Formation of organic layer]

Now will be described a process of forming the organic layers (hole injecting layer, hole transporting layer, light-emitting layer, hole blocking layer, electron transporting layer, and electron injecting layer) used in the present invention.

The organic layer can be formed by any known process, such as a vacuum deposition process or a wet process.

Examples of the wet process include spin coating, casting, ink jetting, printing, die coating, blade coating, roll coating, spray coating, curtain coating, and the Langmuir-Blodgett (LB) method. Preferred are processes highly suitable for a roll-to-roll system, such as die coating, roll coating, ink jetting, and spray coating, in view of easy formation of a thin homogeneous film and high productivity.

Examples of the liquid medium for dissolution or dispersion of the organic EL materials according to the present invention include ketones, such as methyl ethyl ketone and cyclohexanone, fatty acid esters, such as ethyl acetate, halogenated hydrocarbons, such as dichlorobenzene, aromatic hydrocarbons, such as toluene, xylene, mesitylene, and cyclohexylbenzene, aliphatic hydrocarbons, such as cyclohexane, decalin, and dodecane, and organic solvents, such as DMF and DMSO.

Examples of the usable dispersion technique include ultrasonic dispersion, high shearing force dispersion, and medium dispersion.

Different layers may be formed through different processes. If a layer is formed through a deposition process, appropriate deposition conditions, which may vary depending on the type of a compound used, are as follows: a boat heating temperature of 50 to 450°C, a vacuum of $10^{-6}$ to $10^{-2}$ Pa, a deposition rate of 0.01 to 50 nm/second, a substrate temperature of -50 to 300°C, and a layer thickness of 0.1 nm to 5 μm (preferably 5 to 200 nm).

The organic EL element of the present invention is preferably produced by forming the aforementioned organic layers (from the hole injecting layer to the cathode) through a single vacuuming process. The vacuuming process may be intermitted, and a process other than the vacuuming process may then be performed for forming the layers. In such a case, the process is preferably carried out in a dry inert gas atmosphere.

[Anode]

The anode of the organic EL element is preferably composed of an electrode material having a high work function (4 eV or more, preferably 4.5 eV or more), such as a metal, an alloy, a conductive compound, or a mixture thereof. Specific examples of the electrode material include metals, such as Au, and transparent conductive materials, such as CuI, indium thin oxide (ITO), $SnO_2$, and ZnO. An amorphous material capable of forming a transparent conductive film, such as IDIXO ($In_2O_3$-ZnO), may also be used.

The anode can be prepared through formation of a thin film from any of the aforementioned electrode materials by deposition or sputtering, followed by patterning through photolithography, to form a desired pattern. If high patterning accuracy is not required (i.e., an accuracy of about 100 μm or more), patterning may be performed with a mask having a desired shape in deposition or sputtering of the aforementioned electrode material.

If an applicable substance, such as an organic conductive compound, is used, a wet film forming process, such as printing or coating, may be performed. For extraction of light emitted from the anode, the transmittance of the anode is preferably 10% or more, and the sheet resistance of the anode is preferably several hundreds of Ω/square or less.

The anode has a thickness of 10 nm to 1 μm, preferably 10 to 200 nm, which may vary depending on the material used.

[Cathode]

The cathode is composed of an electrode material having a low work function (4 eV or less), such as a metal (referred to as "electron-injecting metal"), an alloy, a conductive compound, or a mixture thereof. Specific examples of the electrode material include sodium, a sodium-potassium alloy, magnesium, lithium, a magnesium-copper mixture, a magnesium-silver mixture, a magnesium-aluminum mixture, a magnesium-indium mixture, an aluminum-aluminum oxide ($Al_2O_3$) mixture, indium, a lithium-aluminum mixture, aluminum, and rare earth elements. Among these material, preferred is a mixture of an electron-injecting metal and a second metal which is stable and has a work function higher than that of the electron-injecting material, such as a magnesium-silver mixture, a magnesium-aluminum mixture, a magnesium-indium mixture, an aluminum-aluminum oxide ($Al_2O_3$) mixture, a lithium-aluminum mixture, or aluminum, in view of electron injection and resistance against oxidation, for example.

The cathode can be prepared through formation of a thin film from any of the aforementioned electrode materials by deposition or sputtering. The cathode has a sheet resistance of preferably several hundreds of Ω/square or less, and has a thickness of 10 nm to 5 μm, preferably 50 to 200 nm.

From the viewpoint of transmission of emitted light, the anode or cathode of the organic EL element is preferably transparent or translucent for an increase in luminance.

The cathode can be imparted with transparency or translucency by forming of a film having a thickness of 1 to 20 nm on the cathode from any of the aforementioned metals, followed by deposition, on the film, of any of the transparent conductive materials used for the anode. Application of this process can produce an organic El element including a translucent anode and a translucent cathode.

[Supporting substrate]

The supporting substrate used for the organic EL element of the present invention (hereinafter also referred to as "substrate, " "base," or "support") may be composed of any glass or plastic material, and may be transparent or opaque. If light is extracted through the supporting substrate, the supporting substrate is preferably transparent. Examples of preferred transparent supporting substrates include glass films, quartz films, and transparent resin films. Particularly preferred is a resin film which can impart flexibility to the organic EL element.

Examples of the resin film include films of polyesters, such as poly(ethylene terephthalate) (PET) and poly(ethylene naphthalate) (PEN), polyethylene, polypropylene, cellophane, cellulose esters and their derivatives, such as cellulose diacetate, cellulose triacetate, cellulose acetate butyrate, cellulose acetate propionate (CAP), cellulose acetate phthalate (TAC), and cellulose nitrate, poly(vinylidene chloride), poly(vinyl alcohol), polyethylene/vinyl alcohol, syndiotactic polystyrene, polycarbonates, norbornene resins, polymethylpentene, polyether ketones, polyimides, polyethersulfone (PES), poly(phenylene sulfide), polysulfones, polyether imide, polyether ketone imide, polyamides, fluororesins, nylon, poly(methyl methacrylate), acrylic resins, polyarylates, and cycloolefin resins, such as ARTON (trade name, manufactured by JSR Corp.) and APEL (trade name, manufactured by Mitsui Chemicals Inc.) .

On the surface of the resin film may be formed an inorganic or organic coating film or a hybrid coating film composed of both. The coating film is preferably a barrier film having a water vapor transmission rate (25±0.5°C, relative humidity (90±2)%RH) of 0.01 g/ ($m^2$·24h) or less as determined in accordance with JIS K 7129-1992. The coating film is more preferably a high barrier film having an oxygen transmission rate of $1\times0^{-3}$ mL/$m^2$·24h·atm or less as determined in accordance with JIS K 7126-1987 and a water vapor transmission rate of $1\times10^{-5}$ g/$m^2$·24h or less.

The barrier film may be formed from any material capable of preventing intrusion of a substance which impairs the organic EL element, such as moisture or oxygen. Examples of the material include silicon oxide, silicon dioxide, and silicon nitride. In view of enhancement of the strength, the barrier film preferably has a layered structure composed of an inorganic layer and an organic material layer. The inorganic layer and the organic layer may be disposed in any order. Preferably, a plurality of inorganic layers and organic layers are alternately disposed.

The barrier film may be formed by any known process . Examples of the process include vacuum deposition, sputtering, reactive sputtering, molecular beam epitaxy, the ionized-cluster beam method, ion plating, plasma polymerization, atmospheric pressure plasma polymerization, plasma CVD, laser CVD, thermal CVD, and coating. In particular, the barrier film is preferably formed through atmospheric pressure plasma polymerization as described in Japanese Patent Application Laid-Open Publication No. 2004-68143.

Examples of the opaque supporting substrate include metal plates, such as aluminum plates and stainless steel plates, films, opaque resin substrates, and ceramic substrates.

In the organic EL element of the present invention, the external extraction efficiency of light at room temperature (25°C) is preferably 1% or more, more preferably 5% or more.

The external extraction efficiency of light (%) is determined by the following expression:

external extraction efficiency of light (%) = (the number of photons emitted to the outside of the organic EL element/the

number of electrons flowing through the organic EL element)×100.

A hue improving filter (e.g., a color filter) may be used in combination. Alternatively, a color conversion filter may be used in combination which converts the color of light emitted from the organic EL element into multiple colors with a fluorescent material.

[Sealing]

Examples of the means for sealing of the organic EL element of the present invention include a process of bonding a sealing member to the electrode and the supporting substrate with an adhesive. The sealing member only needs to be disposed to cover a display area of the organic EL element. The sealing member may be in the form of concave plate or flat plate. The sealing member may have transparency or electrical insulating property.

Specific examples of the sealing member include a glass plate, a composite of polymer plate and film, and a composite of metal plate and film. Examples of the glass plate include plates of soda-lime grass, glass containing barium and strontium, lead glass, aluminosilicate glass, borosilicate glass, barium borosilicate glass, and quartz. Examples of the polymer plate include plates of polycarbonate, acrylic resin, poly(ethylene terephthalate), polyethersulfide, and polysulfone. Examples of the metal plate include plates composed of one or more metals selected from stainless steel, iron, copper, aluminum, magnesium, nickel, zinc, chromium, titanium, molybdenum, silicon, germanium, and tantalum, and plates composed of alloys of these metals.

In the present invention, a polymer film or a metal film is preferably used for reducing the thickness of the organic EL element. The polymer film preferably has an oxygen transmission rate of $1\times10^{-3}$ mL/m$^2$·24h or less as determined in accordance with JIS K 7126-1987 and a water vapor transmission rate (25±0.5°C, relative humidity of 90±2%) of $1\times10^{-3}$ g/m$^2$·24h or less as determined in accordance with JIS K 7129-1992.

The sealing member may be formed into a concave plate by sandblasting or chemical etching.

Specific examples of the adhesive include photocurable and thermosetting adhesives containing reactive vinyl groups of acrylic acid oligomers and methacrylic acid oligomers, moisture-curable adhesives, such as 2-cyanoacrylate esters, and thermosetting and chemical-curable adhesives (two-component adhesives), such as epoxy adhesives. Other examples include hot-melt polyamides, polyesters, and polyolefins, and cationic UV-curable epoxy resin adhesives.

In consideration that the organic EL element may be degraded through thermal treatment, an adhesive is preferably used which can be cured at a temperature of room temperature to 80°C. The adhesive may contain a desiccant dispersed therein. The adhesive may be applied to a sealing portion with a commercially available dispenser or by screen printing.

An inorganic or organic layer, serving as a sealing film, is preferably formed on the electrode which sandwiches the organic layer with the supporting substrate so as to cover the electrode and the organic layer and to come into contact with the supporting substrate. The sealing film may be formed from any material capable of preventing intrusion of a substance which impairs the organic EL element, such as moisture or oxygen. Examples of the material include silicon oxide, silicon dioxide, and silicon nitride.

In view of enhancement of the strength, the sealing film preferably has a layered structure composed of an inorganic layer and an organic material layer. The sealing film may be formed by any known process. Examples of the process include vacuum deposition, sputtering, reactive sputtering, molecular beam epitaxy, the ionized-cluster beam method, ion plating, plasma polymerization, atmospheric pressure plasma polymerization, plasma CVD, laser CVD, thermal CVD, and coating.

The gap between the sealing member and the display area of the organic EL element is preferably filled with an inert gas (e.g., nitrogen or argon) or an inert liquid (e.g. , fluorohydrocarbon or silicone oil). The gap between the sealing member and the display area may be vacuum. Alternatively, the gap may be filled with a hygroscopic compound.

Examples of the hygroscopic compound include metal oxides (e.g., sodium oxide, potassium oxide, calcium oxide, barium oxide, magnesium oxide, and aluminum oxide), sulfates (e.g., sodium sulfate, calcium sulfate, magnesium sulfate, and cobalt sulfate), metal halides (e.g., calcium chloride, magnesium chloride, cesium fluoride, tantalum fluoride, cerium bromide, magnesium bromide, barium iodide, and magnesium iodide), and perchlorates (e.g., barium perchlorate and magnesium perchlorate). Preferred are anhydrous salts of sulfates, metal halides, and perchlorates.

[Protective film, protective plate]

In order to increase the mechanical strength of the organic EL element, a protective film or plate may be provided on the surface of the sealing film which faces the supporting substrate with the organic layer being disposed therebetween. If the sealing film is used for sealing of the organic EL element, such a protective film or plate is preferably provided, because the mechanical strength of the element is not necessarily high. Examples of the material for the protective film or plate include those used for the aforementioned sealing member, such as a glass plate, a composite of polymer plate and film, and a composite of metal plate and film. Of these, a polymer film is preferably used in view of a reduction in

weight and thickness.

[Technique for improvement of light extraction]

In general, in an organic electroluminescent element, light is emitted in a layer having a refractive index higher than that of air (i.e., a refractive index of about 1.6 to 2.1), and only about 15 to 20% of the light emitted from the light-emitting layer is extracted. The reason for this is attributed to the fact that light incident on an interface (interface between a transparent substrate and air) at an angle θ equal to or larger than the critical angle is totally reflected and cannot be extracted from the element, and that light is totally reflected at the interface between the transparent substrate and the transparent electrode or the light-emitting layer and is guided to the transparent electrode or the light-emitting layer, whereby the light is released along the side face of the element.

Examples of the technique for improving the efficiency of light extraction include a technique for preventing total reflection at the interface between the transparent substrate and air by providing irregularities on the surface of the transparent substrate (see, for example, U.S. Patent No. 4774435) ; a technique for improving the efficiency of light extraction by imparting light collecting property to the substrate (see, for example, Japanese Patent Application Laid-Open Publication No. S63-314795); a technique for forming a reflection surface on the side faces of the element (see, for example, Japanese Patent Application Laid-Open Publication No. H1-220394); a technique for providing an anti-reflection film by disposing a flat layer between the substrate and the light-emitting layer, the flat layer having a refractive index which is intermediate between those of the substrate and the light-emitting layer (see, for example, Japanese Patent Application Laid-Open Publication No. S62-172691); a technique for disposing a flat layer between the substrate and the light-emitting layer, the flat layer having a refractive index lower than that of the substrate (see, for example, Japanese Patent Application Laid-Open Publication No. 2001-202827); and a technique for providing a diffraction grating between any layers of the substrate, the transparent electrode layer, and the light-emitting layer (including on the substrate surface exposed to the outside) (Japanese Patent Application Laid-Open Publication No. Hll-283751).

In the present invention, any of these techniques can be used for the organic electroluminescent element of the present invention. In particular, preferred is a technique for disposing a flat layer between the substrate and the light-emitting layer, the flat layer having a refractive index lower than that of the substrate, or a technique for forming a diffraction grating between any layers of the substrate, the transparent electrode layer, and the light-emitting layer (including on the substrate surface exposed to the outside).

The present invention can provide an element exhibiting higher luminance or excellent durability by combining the aforementioned techniques.

If a medium having a low refractive index and having a thickness larger than a light wavelength is provided between a transparent electrode and a transparent substrate, the efficiency of extraction of light from the transparent electrode to the outside increases with a decrease in refractive index of the medium.

The layer of low refractive index may be composed of, for example, aero gel, porous silica, magnesium fluoride, or a fluorine-containing polymer. The refractive index of the layer of low refractive index is preferably about 1.5 or less, because the transparent substrate generally has a refractive index of about 1.5 to 1.7. The refractive index of the layer of low refractive index is more preferably 1.35 or less.

The medium of low refractive index preferably has a thickness twice or more a light wavelength in the medium. This is because, if the medium of low refractive index has a thickness nearly equal to the light wavelength, the electromagnetic wave exuded as an evanescent wave enters the substrate, leading to a reduction in the effect of the layer of low refractive index.

The technique for providing a diffraction grating at any interface where total reflection occurs or in any medium can highly improve the efficiency of light extraction. A diffraction grating turns light to a specific direction other than the refraction direction by Bragg diffraction (e.g., a primary diffraction or a secondary diffraction). This technique uses the diffraction grating provided at any interface or in any medium (e.g., in a transparent substrate or a transparent electrode), and achieves extraction of a light component emitted from the light-emitting layer, which would otherwise fail to be extracted to the outside due to the total reflection, to the outside by diffraction with the diffraction grating.

The diffraction grating used preferably has a two-dimensional periodic refractive index profile, for the following reasons. Because light is emitted in any directions randomly in the light-emitting layer, a common one-dimensional diffraction grating having a periodic refractive index profile in a specific direction diffracts light only in the specific direction, resulting in a low effect of improving the efficiency of light extraction.

In contrast, the diffraction grating having a two-dimensional diffractive index profile can diffract light in any directions and thus highly improve the efficiency of light extraction.

The diffraction grating may be provided at any interface or any medium (e.g., in a transparent substrate or a transparent electrode). Preferably, the diffraction grating is provided around the organic light-emitting layer, from which light is emitted. The pitch of the diffraction grating is preferably about a half to three times of the wavelength of light in the medium. The diffraction grating preferably has in a two-dimensionally repeated pattern, such as a square lattice,

triangular lattice, or honeycomb lattice pattern.

[Light condensing sheet]

In the organic electroluminescent element of the present invention, the supporting substrate (substrate) may be provided, on its side for light extraction, with a microlens array structure or a light condensing sheet, to collect light in a specific direction (e.g., in a front direction of a light emitting face of the element), thereby increasing luminance in the specific direction.
For example, the microlens array includes two-dimensionally arranged quadrangular pyramids each having a 30-μm side and a vertex angle of 90°, on the light-extraction side of the substrate. Each side of the quadrangular pyramid has a length of preferably 10 to 100 μm. A side having a length below this range leads to coloring caused by diffraction, whereas an excessively long side leads to an undesirable increase in thickness of the element.
The light condensing sheet may be, for example, a commercially available sheet used in an LED backlight of a liquid crystal display device. Examples of such a sheet include Brightness Enhancement Film (BEF) manufactured by Sumitomo 3M Ltd. The prism sheet may be composed of a base with triangular protrudent stripes having a vertex angle of 90°C which are arranged at pitches of 50 μm. The vertexes of the triangular protrudent stripes may be rounded, or the pitches may be randomly varied. The sheet may have any other structure.
In order to control the radiation angle of light from the organic EL element, the light condensing sheet may be used in combination with a light diffusing plate or film; for example, a diffusing film (LIGHT-UP, manufactured by KIMOTO Co., Ltd.).

[Application]

The organic EL element of the present invention may be used for display devices, displays, and various light sources.
Examples of light sources include, but are not limited to, lighting devices (e.g., household and in-vehicle lighting devices), backlight units of watches and liquid crystal displays, billboards, traffic signals, light sources for optical storage media, light sources for electrophotocopiers, light sources for optical communication processors, and light sources for optical sensors. In particular, the organic EL element can be effectively used for a backlight unit of a liquid crystal display device and a light source for illumination.
In the organic EL element of the present invention, the layers may optionally be patterned with a metal mask or by inkjet printing during formation of the layers. The patterning process may be performed on only the electrodes, both the electrodes and the light-emitting layer, or all the layers of the element. Any known process may be used for preparation of the element.
The color of light emitted from the organic EL element or compound according to the present invention is determined by applying values obtained with a spectroradiometer CS-1000 (manufactured by Konica Minolta Optics, Inc.) to the CIE chromaticity coordinate shown in Fig. 4.16 on page 108 of "Shinpen Shikisai Kagaku Handobukku (Handbook of Color Science, New Edition)" (edited by the Color Science Association of Japan, published from University of Tokyo Press, 1985).
The organic EL element of the present invention can be used as a white light-emitting element. In such a case, the term "white" refers to that when 2-degree viewing angle front luminance is determined by the aforementioned process, the chromaticity in the CIE 1931 Color Specification System at 1,000 cd/m$^2$ falls within a region of X=0.33±0.07 and Y=0.33±0.1.

<Display Device>

The display device of the present invention includes the organic EL element of the present invention. The display device of the present invention may be a monochromatic or multicolor display device. Now will be described a multicolor display device.
In the case of a multicolor display device, a shadow mask is provided only during formation of the light-emitting layer, and each of the layers may be formed over the entire surface by, for example, vacuum deposition, casting, spin coating, ink jetting, or printing.
Any process can be used for patterning of only the light-emitting layer. The patterning is preferably performed by vacuum deposition, ink jetting, spin coating, or printing.
The configuration of the organic EL element of the display device is optionally selected from the above-exemplified configurations.
The process of producing the organic EL element of the present invention is as described above in one embodiment.

If a DC voltage of about 2 to 40V is applied to the resultant multicolor display device (anode: positive electrode, cathode: negative electrode), light emission can be observed. In contrast, if a voltage is applied with reverse polarity, no current flows through the device, and light is not emitted at all. If an AC voltage is applied to the device, light is emitted only in the state where the anode is positive and the cathode is negative. The AC voltage to be applied may have any waveform.

The multicolor display device can be used for various display devices, displays or light sources. In the display device or display, full-color display is achieved with three types of organic EL elements; i.e., blue, red, and green-emitting elements.

Examples of the display device or display include television sets, personal computers, mobile devices, AV devices, teletext displays, and information displays in automobiles. In particular, the display device may be used for reproducing still images or moving images. The driving system used in the display device for reproducing moving images may be a simple matrix (passive matrix) type or an active matrix type.

Examples of the light source include, but are not limited to, household lighting devices, in-vehicle lighting devices, backlight units of watches and liquid crystal displays, billboards, traffic signals, light sources for optical storage media, light sources for electrophotocopiers, light sources for optical communication processors, and light sources for optical sensors.

Now will be described an example of the display device including the organic EL element of the present invention with reference to the drawings.

Fig. 5 is a schematic view of an exemplary display device including the organic EL element. Fig. 5 schematically illustrates a display for, for example, a mobile phone to display image information through light emission by the organic EL element.

The display 1 includes a display unit A having a plurality of pixels, a control unit B for image scanning on the display unit A on the basis of image information, and a wiring unit C which electrically connects the display unit A and the control unit B.

The control unit B, which is electrically connected to the display unit A via the wiring unit C, transmits scanning signals and image data signals to the respective pixels on the basis of external image information. The pixels in each scanning line sequentially emit light in response to the scanning signal on the basis of the image data signal to perform image scanning so that the image information is displayed on the display unit A.

Fig. 6 is a schematic view of an active matrix display device.

The display unit A has, on a substrate, a wiring unit C including a plurality of scanning lines 5 and data lines 6, and a plurality of pixels 3. The main components of the display unit A will be described below.

With reference to Fig. 6, light emitted from the pixels 3 is extracted to the direction shown by the white arrow (downward direction).

The scanning lines 5 and the data lines 6 of the wiring unit are composed of a conductive material and are orthogonal to each other to form a grid pattern. The scanning lines 5 and the data lines 6 are connected to the pixels 3 at orthogonal intersections (details are not illustrated).

If a scanning signal is applied to the scanning lines 5, the pixels 3 receive an image data signal from the data lines 6 and emit light in response to the received image data.

Full-color display is achieved by appropriately arranging red light-emitting, green light-emitting, and blue light-emitting pixels on a single substrate.

Now will be described the emission process of a pixel. Fig. 7 is a schematic view of a pixel circuit.

The pixel includes an organic EL element 10, a switching transistor 11, a driving transistor 12, and a capacitor 13. Full color display is achieved by using a plurality of pixels arranged on a single substrate, each of the pixels including red, green, and blue light-emitting organic EL elements 10.

With reference to Fig. 7, an image data signal from the control unit B is applied to the drain of the switching transistor 11 via the data line 6. If a scanning signal from the control unit B is applied to the gate of the switching transistor 11 via the scanning line 5, the switching transistor 11 is turned on, and the image data signal applied to the drain is transmitted to the gates of the capacitor 13 and the driving transistor 12.

The capacitor 13 is charged through transmission of the image data signal depending on the potential of the image data signal, and the driving transistor 12 is turned on. The drain and source of the driving transistor 12 are connected to a power source line 7 and the electrode of the organic EL element 10, respectively. Depending on the potential of the image data signal applied to the gate, a current is supplied from the power source line 7 to the organic EL element 10.

If the scanning signal is transmitted to the next scanning line 5 through sequential scanning by the control unit B, the switching transistor 11 is turned off. Because the capacitor 13 maintains the charged potential corresponding to the image data signal even after turning off of the switching transistor 11, the driving transistor 12 is maintained in an ON state, and the organic EL element 10 continues to emit light until application of the next scanning signal. Through application of the next scanning signal by sequential scanning, the driving transistor 12 is driven depending on the

potential of the subsequent image data signal in synchronization with the scanning signal, and the organic EL element 10 emits light.

To each of the organic EL elements 10 corresponding to the respective pixels 3, the switching transistor 11 and the driving transistor 12 serving as active elements are provided so that each of the organic EL elements 10 emits light. This light-emitting system is called "active matrix type."

Multi-tone light may be emitted from the organic EL element 10 in response to multi-valued image data signals having different gradient potentials. Alternatively, light with a specific intensity from the organic EL element 10 may be turned on or off in response to a binary image data signal. The potential of the capacitor 13 may be maintained until application of the subsequent scanning signal, or the capacitor 13 may be discharged immediately before application of the subsequent scanning signal.

In the present invention, the display device may be not only of the aforementioned active matrix type, but also of a passive matrix type, in which light is emitted from the organic EL element in response to the data signal only during application of the scanning signals.

Fig. 8 is a schematic view of a passive matrix display device. With reference to Fig. 8, a plurality of scanning lines 5 and a plurality of image data lines 6 are provided with the pixels 3 disposed theirbetween to form a grid pattern.

If a scanning signal is applied to a scanning line 5 through sequential scanning, the pixel 3 connected to the scanning line 5 emits light in response to the image data signal.

The passive matrix display device can reduce production cost, because no pixel 3 includes an active element.

The use of the organic EL element of the present invention realized a display device exhibiting improved emission efficiency.

<Lighting device>

The lighting device of the present invention will now be described. The lighting device of the present invention includes the aforementioned organic EL element.

The organic EL element of the present invention may have a resonator structure. Examples of the application of the organic EL element having a resonator structure include, but are not limited to, light sources for optical storage media, light sources for electrophotocopiers, light sources for optical communication processors, and light sources for optical sensors. Alternatively, the organic EL element of the present invention may be used for the aforementioned purposes by laser oscillation.

The organic EL element of the present invention may be used in a lamp, such as a lighting source or an exposure light source, or may be used in a projector for projecting images or a display device (display) for directly viewing still or moving images.

If the organic EL element is used in a display device for playback of moving images, the display device may be of a passive matrix type or an active matrix type. A full-color display device can be produced from two or more organic EL elements of the present invention which emits light of different colors.

The TADF compound and phosphorescent metal complex used in the present invention can be applied to an organic EL element which emits substantially white light as a lighting device. White light is produced by mixing light of different colors simultaneously emitted from a plurality of light-emitting materials (TADF compound and phosphorescent metal complex) . The combination of emission of different colors may include light of three primary colors (red, green, and blue) with three maximum emission wavelengths, or light of complementary colors (e.g., blue and yellow or blue-green and orange) with two maximum emission wavelengths.

For preparation of the organic EL element of the present invention, a mask is disposed only during formation of the light-emitting layer, the hole transporting layer, or the electron transporting layer such that a patterning process is performed simply through the mask. The other layers, which are common to one another, do not require any patterning process with a mask. Thus, an electrode film can be formed on the entire surface of such a layer through, for example, vacuum deposition, casting, spin coating, ink jetting, or printing, resulting in improved productivity.

The element produced by this process emits white light, unlike a white light-emitting organic EL device including arrayed light-emitting elements that emit light of a plurality of colors.

[Embodiment of lighting device of the present invention]

Now will be described an embodiment of the lighting device including the organic EL element of the present invention.

The non-light-emitting surface of the organic EL element of the present invention is covered with a glass casing, and a glass substrate having a thickness of 300 μm is used as a sealing substrate. An epoxy photocurable adhesive (LUXTRACK LC0629B, manufactured by Toagosei Co., Ltd.), serving as a sealing material, is applied to the periphery of the substrate, and the glass casing is placed from above the cathode and is attached to the transparent supporting

substrate, followed by curing of the adhesive by irradiation of the glass substrate with UV rays and sealing the glass casing. A lighting device shown in Fig. 9 or 10 is thereby produced.

Fig. 9 is a schematic view of the lighting device. The organic EL element 101 of the present invention is covered with a glass cover 102 (sealing with the glass casing is performed in a glove box under a nitrogen atmosphere (an atmosphere of nitrogen gas having a purity of 99.999% or more) for preventing the organic EL element 101 from being exposed to air).

Fig. 10 is a cross-sectional view of the lighting device. With reference to Fig. 10, reference numeral 105 denotes a cathode, 106 denotes an organic EL layer, and 107 denotes a glass substrate having a transparent electrode. The interior of the glass cover 102 is filled with nitrogen gas 108 and is provided with a water-collecting agent 109.

The use of the organic EL element of the present invention realized a lighting device exhibiting improved emission efficiency.

<Thin light-emitting film>

The thermally activated delayed fluorescent compound and phosphorescent metal complex used as light-emitting materials in the present invention can also be applied to a thin light-emitting film for an organic electroluminescent element.

Now will be described the thin light-emitting film for an organic electroluminescent element (hereinafter also referred to simply as "thin light-emitting film").

The thin light-emitting film for organic luminescent element disclosed herein contains two or more light-emitting materials having different emission mechanisms; i.e., a thermally activated delayed fluorescent compound and a phosphorescent metal complex.

The thin light-emitting film may be formed as a constituent film of the light-emitting layer during production of the organic EL element. Alternatively, the thin light-emitting film for the organic EL element may be independently formed before production of the organic EL element.

The thin light-emitting film can be formed as in the aforementioned light-emitting layer.

The thin light-emitting film can be formed by any known process, such as a vacuum deposition process or a wet process.

Examples of the wet process include spin coating, casting, ink jetting, printing, die coating, blade coating, roll coating, spray coating, curtain coating, and the Langmuir-Blodgett (LB) method. Preferred are processes highly suitable for a roll-to-roll system, such as die coating, roll coating, ink jetting, and spray coating, in view of easy formation of a thin homogeneous film and high productivity.

Examples of the liquid medium for dissolution or dispersion of the light-emitting materials used in the present invention include ketones, such as methyl ethyl ketone and cyclohexanone, fatty acid esters, such as ethyl acetate, halogenated hydrocarbons, such as dichlorobenzene, aromatic hydrocarbons, such as toluene, xylene, mesitylene, and cyclohexylbenzene, aliphatic hydrocarbons, such as cyclohexane, decalin, and dodecane, and organic solvents, such as DMF and DMSO.

Examples of the usable dispersion technique include ultrasonic dispersion, high shearing force dispersion, and medium dispersion.

Different films may be formed through different processes. If a film is formed through a deposition process, appropriate deposition conditions, which may vary depending on the type of a compound used, are as follows: a boat heating temperature of 50 to 450°C, a vacuum of $10^{-6}$ to $10^{-2}$ Pa, a deposition rate of 0.01 to 50 nm/second, a substrate temperature of -50 to 300°C, and a film thickness of 0.1 nm to 5 $\mu$m (preferably 5 to 200 nm).

Formation of the film through spin coating is preferably carried out with a spin coater (100 to 1,000 rpm) in a dry inert gas atmosphere for 10 to 120 seconds.

The thin light-emitting film can be applied to a display device or a lighting device.

The resultant display device or lighting device exhibits improved emission efficiency.

Examples

The present invention will now be described in detail by way of Examples, which should not be construed as limiting the invention thereto. Unless otherwise specified, the terms "part (s) " and "%" in the following description indicate "part(s) by mass" and "mass%," respectively.

In the Examples, the vol% of a compound is determined on the basis of the thickness of a layer composed of the compound measured by a quartz crystal microbalance technique, the calculated mass of the layer, and the specific weight of the compound.

TADF-3 was preliminarily dissolved in toluene, and the absolute photoluminescence (PL) quantum yield and emission lifetime of the compound were measured at 300 K.

The absolute PL quantum yield was measured with an absolute PL quantum yield analyzer C9920-02 (manufactured by Hamamatsu Photonics K.K.).

The emission lifetime of a solution sample was determined on the basis of transient PL characteristics. Transient PL characteristics were determined with a small fluorescence lifetime measuring apparatus (C11367-03, manufactured by Hamamatsu Photonics K.K.).

Specifically, a slow decay component was measured by an M9003-01 mode using a flash lamp as an excitation source, and a fast decay component was measured by a TCC900 mode using an LED (340 nm) as an excitation source. In this case, a fluorescence component is observed on the order of nanoseconds, and a delayed fluorescence component derived from phosphorescence and the triplet state is observed on the order of microseconds or milliseconds.

Two components having lifetimes of 5 ns and 270 $\mu$s were observed in an oxygen-free atmosphere, whereas only one component having a lifetime of 5 ns was observed in an oxygen atmosphere.

This phenomenon indicates that the triplet state affects emission of TADF-3. TADF-3, which has an emission lifetime on the order of microseconds at room temperature, was determined to be a thermally activated delayed fluorescent compound (TADF).

[Example 1] (not according to the invention)

(Formation of thin film 1-1)

A quartz substrate (50 mm$\times$50 mm, thickness: 0.7 mm) was ultrasonically washed with isopropyl alcohol, dried with dry nitrogen gas, and cleaned with UV ozone for five minutes. Thereafter, the transparent substrate was fixed onto a substrate holder of a commercially available vacuum deposition apparatus.

TADF-3 (TADF compound) and bis(2-(diphenylphosphino)phenyl)ether oxide (DPEPO) (host compound, shown below) were placed in vapor deposition crucibles in the vacuum deposition apparatus, respectively, in amounts suitable for preparation of an element. The crucibles were composed of molybdenum; i.e., a material for resistance heating.

The vacuum deposition apparatus was evacuated to a vacuum of $1\times10^{-4}$ Pa, and DPEPO and TADF-3 were co-deposited onto the substrate at a deposition rate of 0.1 nm/second, to form a thin film having a thickness of 30 nm and containing 90 vol% DPEPO and 10 vol% TADF-3.

[F65]

DPEPO

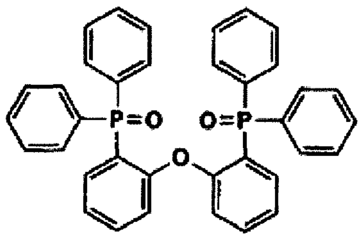

(Formation of thin film 1-2)

A thin film 1-2 was formed as in the thin film 1-1, except that DPEPO, TADF-3, and P-10 (phosphorescent metal complex) were co-deposited at a deposition rate of 0.1 nm/second such that the DPEPO, TADF-3, and P-10 contents of the film were 89.9 vol%, 10 vol%, and 0.1 vol%, respectively.

In this case, [$S_1$(TADF) - $T_1$(P)] was 0.79, and [$T_1$(TADF) - $T_1$(P)] was 0.47.

(Formation of thin film 1-3)

A thin film 1-3 was formed as in the thin film 1-2, except that P-10 was replaced with P-9 (phosphorescent material).

In this case, [$S_1$(TADF) - $T_1$(P)] was 1.29, and [$T_1$(TADF) - $T_1$(P)] was 0.97.

(Evaluation of thin films 1-1 to 1-3)

The PL spectra of the samples of the thin films 1-1 to 1-3 were measured. The PL spectra were measured with an absolute PL quantum yield analyzer C9920-02 (manufactured by Hamamatsu Photonics K.K.) at room temperature and an excitation wavelength of 350 nm. The thin film 1-1 exhibited emission derived from TADF-3 at 423 nm.

In the thin film 1-2, both a fluorescence spectrum of TADF-3 and an emission spectrum of P-10 were observed. The fluorescence intensity derived from TADF-3 was 1.10 times that of a thin film containing only TADF-3. In this case, a long-wavelength portion of the emission spectrum of TADF-3 overlaps with a short-wavelength portion of the emission spectrum of P-10. The overlap portion does not affect the peak wavelength of TADF-3, because the peaks of these emission spectra are away from each other.

In the case of the thin film 1-3, the fluorescence intensity of TADF-3 was low, and the spectrum of P-9 was dominant. The thin films 1-1, 1-2, and 1-3 exhibited absolute quantum yields of 0.80, 0.90, and 0.83, respectively. Table 4 shows the results.

[Table 4]

| Thin film | TADF compound | Phosphorescent metal complex | Host compound | $S_1$ (TADF)-$T_1$ (P) [eV] | $T_1$ (TADF)-$T_1$ (P) [eV] | TADF compound [Vol%] | Phosphorescent metal complex [Vol%] | Host compound [Vol%] | Absolute quantum yield | Emission intensity (relative value) | Note |
|---|---|---|---|---|---|---|---|---|---|---|---|
| 1-1 | TADF-3 | - | DPEPO | - | - | 10.00 | - | 90.00 | 0.80 | 100 | *1 |
| 1-2 | TADF-3 | P-10 | DPEPO | 0.79 | 0.47 | 10.00 | 0.10 | 89.90 | 0.90 | 110 | *1 |
| 1-3 | TADF-3 | P-9 | DPEPO | 1.29 | 0.97 | 10.00 | 0.10 | 89.90 | 0.83 | 104 | *1 |

*1 : Comparative Example

(Advantageous effects)

According to the results described above, in the thin film 1-2, the intersystem crossing from the triplet energy level to the singlet energy level of the photoexcited TADF compound is activated by the external heavy-atom effect of the phosphorescent material, and thus the PL intensity increases. In contrast, in the thin film 1-3, which contains a phosphorescent metal complex having an energy level greatly different from that of the TADF compound, the differences [$S_1$(TADF) - $T_1$(P)] and [$T_1$(TADF) - $T_1$(P)] are larger than those in the thin film 1-2, leading to dominant energy transfer from the TADF compound to the phosphorescent metal complex, resulting in reduced emission from the TADF compound.

[Example 2] (not according to the invention)

(Formation of thin film 2-1)

A thin film 2-1 having a thickness of 30 nm was formed on a quartz substrate as in the thin film 1-1, except that TADF-1 was used as a TADF compound. The PL spectrum of the thin film 2-1 was measured. The thin film 2-1 exhibited emission derived from TADF-1 at 421 nm.

(Formation of thin film 2-2)

A thin film 2-2 was formed as in the thin film 1-2, except that TADF-1 was used as a TADF compound and P-64 was used as a phosphorescent metal complex.

Table 5 shows the differences [$S_1$(TADF) - $T_1$(P)] and [$T_1$(TADF) - $T_1$(P)]. The PL spectrum of the thin film 2-2 was measured. The thin film 2-2 exhibited both emission derived from TADF-1 at 421 nm and emission derived from P-64 at 524 nm.

(Formation of thin films 2-3 to 2-6)

A thin film 2-3 or 2-4 was formed as in the thin film 2-2, except that the phosphorescent metal complex used for the thin film 2-2 was replaced with P-49 or P-108. A thin film 2-5 was formed as in the thin film 2-2, except that the phosphorescent metal complex used for the thin film 2-2 was replaced with P-108, and DPEPO, TADF-1, and P-108 were co-deposited at a deposition rate of 0.1 nm/second such that the DPEPO, TADF-1, and P-108 contents of the film were 89.7 vol%, 10 vol%, and 0.3 vol%, respectively. A thin film 2-6 was formed as in the thin film 2-2, except that the phosphorescent metal complex used for the thin film 2-2 was replaced with P-17, and DPEPO, TADF-1, and P-17 were co-deposited at a deposition rate of 0.1 nm/second such that the DPEPO, TADF-1, and P-17 contents of the film were 89.5 vol%, 10 vol%, and 0.5 vol%, respectively.

(Evaluation of thin films 2-1 to 2-6)

The PL spectra of the samples of the thin films 2-1 to 2-6 were measured as in the thin films 1-1 to 1-3.

(Evaluation of thin films 2-1 to 2-6)

Table 5 shows the results obtained through measurement of the PL spectra of the thin films 2-1 to 2-6.

The emission intensities derived from TADF-1 in the thin films 2-2 to 2-6 are shown relative to that in the thin film 2-1 (taken as 100).

[Table 5]

| Thin film | TADF compound | Phosphorescent metal complex | Host compound | $S_1$ (TADF)-$T_1$ (P) [eV] | $T_1$ (TADF)-$T_1$ (P) [eV] | TADF compound [Vol%] | Phosphorescent metal complex [Vol%] | Host compound [Vol%] | Emission intensity (relative value) | Note |
|---|---|---|---|---|---|---|---|---|---|---|
| 2-1 | TADF-1 | - | DPEPO | - | - | 10.00 | - | 90.00 | 100 | *2 |
| 2-2 | TADF-1 | P-64 | DPEPO | 0.93 | 0.39 | 10.00 | 0.10 | 89.90 | 112 | *2 |
| 2-3 | TADF-1 | P-49 | DPEPO | 0.86 | 0.32 | 10.00 | 0.10 | 89.90 | 115 | *2 |
| 2-4 | TADF-1 | P-108 | DPEPO | 0.66 | 0.12 | 10.00 | 0.10 | 89.90 | 119 | *2 |
| 2-5 | TADF-1 | P-108 | DPEPO | 0.66 | 0.12 | 10.00 | 0.30 | 89.70 | 122 | *2 |
| 2-6 | TADF-1 | P-17 | DPEPO | 0.63 | 0.09 | 10.00 | 0.50 | 89.50 | 125 | *2 |

*2 : Comparative Example

(Advantageous effects)

According to the results described above, combination of the TADF compound and the phosphorescent metal complex increases the emission intensity of the TADF compound, as compared with the case where only the TADF compound is used.

In some combinations prepared in this example, the emission peak wavelength of the TADF compound is nearly equal to that of the phosphorescent metal complex. In such a case, although fluorescence cannot be distinguished from phosphorescence, the phosphorescent material emits light while enhancing or maintaining emission from the TADF compound. Thus, the total emission intensity can be increased at the wavelength range.

[Example 3]

(Preparation of organic EL element 3-1)

An indium tin oxide (ITO) anode having a thickness of 150 nm was formed on a glass substrate (50 mm×50 mm, thickness: 0.7 mm), followed by patterning. Subsequently, the transparent substrate having the ITO transparent electrode was ultrasonically washed with isopropyl alcohol, dried with dry nitrogen gas, and cleaned with UV ozone for five minutes. Thereafter, the transparent substrate was fixed onto a substrate holder of a commercially available vacuum deposition apparatus.

Materials for layers were placed in vapor deposition crucibles in the vacuum deposition apparatus, respectively, in amounts suitable for preparation of an element. The crucibles were composed of molybdenum or tungsten; i. e. , a material for resistance heating.

The vacuum deposition apparatus was evacuated to a vacuum of $1\times10^{-4}$ Pa, and a vapor deposition crucible containing $\alpha$-NPD was heated by application of electricity. $\alpha$-NPD was deposited onto the ITO transparent electrode at a deposition rate of 0.1 nm/second, to form a hole injecting transporting layer having a thickness of 40 nm. Subsequently, a vapor deposition crucible containing 1,3-bis(9-carbazolyl)benzene (mCP) was heated by application of electricity, and mCP was deposited onto the hole transporting layer at a deposition rate of 0.1 nm/second, to form an intermediate layer having a thickness of 10 nm.

Subsequently, 2,8-bis(diphenylphosphoryl)dibenzo[b,d]thiophene (PPT) and 2CzPN (TADF) were co-deposited at a deposition rate of 0.1 nm/second, to form a light-emitting layer having a thickness of 20 nm and containing 95 vol% PPT and 5 vol% 2CzPN.

Thereafter, PPT was deposited at a deposition rate of 0.1 nm/second, to form an electron transporting layer having a thickness of 40 nm.

A lithium fluoride layer having a thickness of 0.8 nm was then formed, and aluminum was deposited onto the lithium fluoride layer, to form a cathode having a thickness of 100 nm.

The non-light-emitting surface of the element was covered with a cylindrical glass casing in an atmosphere of nitrogen gas having a purity of 99.999% or more, and lead wires for the electrodes were provided, to prepare an organic EL element 3-1.

(Preparation of organic EL element 3-2)

An organic EL element 3-2 was prepared as in the organic EL element 3-1, except that PPT, 2CzPN, and P-111 were co-deposited at a deposition rate of 0.1 nm/second, to form a light-emitting layer having a thickness of 20 nm and containing 94.5 vol% PPT, 5 vol% 2CzPN, and 0.5 vol% P-111. The phosphorescent metal complex P-111 emits phosphorescence at a low temperature, but does not emit light at room temperature.

The difference [$S_1$(TADF) - $T_1$(P)] was -0.02 eV.

(Evaluation of organic EL elements 3-1 and 3-2)

The organic EL elements 3-1 and 3-2 were evaluated as described below.

(Measurement of EL spectrum)

Each of the above-prepared organic EL elements was driven at room temperature (about 25°C) under application of a constant current of 2.5 mA/$cm^2$, and an EL spectrum immediately after light emission was measured with a spectroradiometer CS-2000 (manufactured by Konica Minolta Optics, Inc.) . Table 6 shows the results.

The organic EL element 3-2 exhibited strong emission derived from 2CzPN, and the emission intensity thereof was 1.18 times that of the organic EL element 3-1 containing only 2CzPN.

[Table 6]

| Organic EL element | TADF compound | Phosphorescent metal complex | Host compound | $S_1$ (TADF)-$T_1$ (P) [eV] | Light-emitting layer | | | Emission intensity (relative value) | Note |
|---|---|---|---|---|---|---|---|---|---|
| | | | | | TADf compound [Vol%] | Phosphorescent metal complex [Vol%] | Host compound (Vol%] | | |
| 3-1 | 2CzPN | - | PPT | - | 5.00 | - | 95.00 | 100 | Comparative Example |
| 3-2 | 2CzPN | P-111 | PPT | -0.02 | 5.00 | 0.50 | 94.50 | 118 | Example |

(Advantageous effects)

According to the results described above, in the organic EL element 3-2, the intersystem crossing from the triplet energy level to the singlet energy level of electrically excited 2CzPN (TADF compound) is activated by the external heavy-atom effect of the phosphorescent metal complex P-111, and thus the emission intensity increases. This indicates that a phosphorescent metal complex which does not emit light at room temperature exhibits an external heavy-atom effect on a TADF compound present in proximity to the phosphorescent metal complex.

[Example 4] (not according to the invention)

(Preparation of organic EL element 4-1)

An indium tin oxide (ITO) anode having a thickness of 150 nm was formed on a glass substrate (50 mm×50 mm, thickness: 0.7 mm), followed by patterning. Subsequently, the transparent substrate having the ITO transparent electrode was ultrasonically washed with isopropyl alcohol, dried with dry nitrogen gas, and cleaned with UV ozone for five minutes. Thereafter, the transparent substrate was fixed onto a substrate holder of a commercially available vacuum deposition apparatus.

Materials for layers were placed in vapor deposition crucibles in the vacuum deposition apparatus, respectively, in amounts suitable for preparation of an element. The crucibles were composed of molybdenum or tungsten; i.e., a material for resistance heating.

The vacuum deposition apparatus was evacuated to a vacuum of $1\times10^{-4}$ Pa, and a vapor deposition crucible containing α-NPD shown below was heated by application of electricity. α-NPD was deposited onto the ITO transparent electrode at a deposition rate of 0.1 nm/second, to form a hole injecting transporting layer having a thickness of 30 nm.

[F66]

PPT

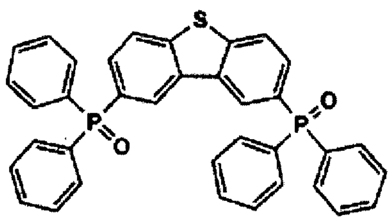

α-NPD

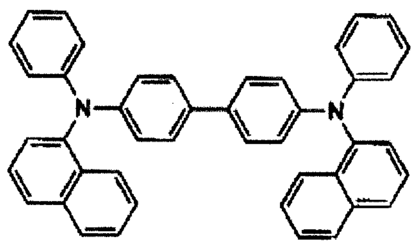

CBP

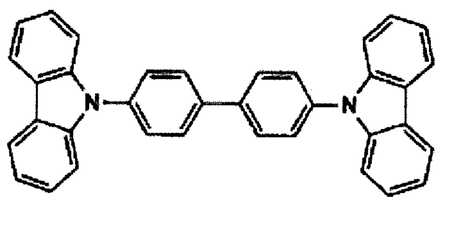

TPBi

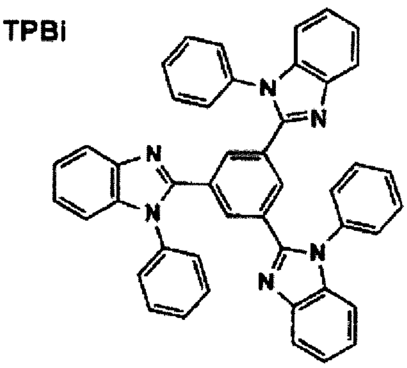

BCP

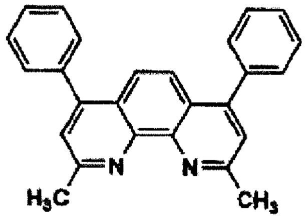

Subsequently, a vapor deposition crucible containing CBP (host compound) was heated by application of electricity, and CBP was deposited onto the hole transporting layer at a deposition rate of 0.1 nm/second, to form an

intermediate layer having a thickness of 10 nm.

Subsequently, CBP (host compound) and 4CzIPN (TADF) were co-deposited at a deposition rate of 0.1 nm/second, to form a light-emitting layer having a thickness of 35 nm and containing 95 vol% CBP and 5 vol% 4CzIPN.

Thereafter, TPBi was deposited at a deposition rate of 0.1 nm/second, to form an electron transporting layer having a thickness of 50 nm.

A lithium fluoride layer having a thickness of 0.8 nm was then formed, and aluminum was deposited onto the lithium fluoride layer to form a cathode having a thickness of 100 nm.

The non-light-emitting surface of the element was covered with a cylindrical glass casing in an atmosphere of nitrogen gas having a high purity of 99.999% or more, and lead wires for the electrodes were provided, to prepare an organic EL element 4-1.

(Preparation of organic EL element 4-2)

An indium tin oxide (ITO) anode having a thickness of 150 nm was formed on a glass substrate (50 mm×50 mm, thickness: 0.7 mm), followed by patterning. Subsequently, the transparent substrate having the ITO transparent electrode was ultrasonically washed with isopropyl alcohol, dried with dry nitrogen gas, and cleaned with UV ozone for five minutes. Thereafter, the transparent substrate was fixed onto a substrate holder of a commercially available vacuum deposition apparatus.

Materials for layers were placed in vapor deposition crucibles in the vacuum deposition apparatus, respectively, in amounts suitable for preparation of an element. The crucibles were composed of molybdenum or tungsten; i.e., a material for resistance heating.

The vacuum deposition apparatus was evacuated to a vacuum of $1\times10^{-4}$ Pa, and a vapor deposition crucible containing $\alpha$-NPD was heated by application of electricity. $\alpha$-NPD was deposited onto the ITO transparent electrode at a deposition rate of 0.1 nm/second, to form a hole transporting injecting layer having a thickness of 30 nm.

Subsequently, CBP (host compound) and P-9 (phosphorescent metal complex) were co-deposited at a deposition rate of 0.1 nm/second, to form a first light-emitting layer having a thickness of 10 nm and containing 99.75 vol% CBP and 0.25 vol% P-9.

Subsequently, CBP and 4CzIPN were co-deposited at a deposition rate of 0.1 nm/second, to form a second light-emitting layer having a thickness of 35 nm and containing 95 vol% CBP and 5 vol% 4CzIPN.

Thereafter, TPBi was deposited at a deposition rate of 0.1 nm/second, to form an electron transporting layer having a thickness of 50 nm.

A lithium fluoride layer having a thickness of 0.8 nm was then formed, and aluminum was deposited onto the lithium fluoride layer, to form a cathode having a thickness of 100 nm.

The non-light-emitting surface of the element was covered with a cylindrical glass casing in an atmosphere of nitrogen gas having a high purity of 99.999% or more, and lead wires for the electrodes were provided, to prepare an organic EL element 4-2.

(Preparation of organic EL elements 4-3 to 4-6)

Organic EL elements 4-3 to 4-6 were prepared as in the organic EL element 4-2, except that the host compound used in Example 4-1, the phosphorescent metal complex of the first light-emitting layer, and the TADF compound of the second light-emitting layer were replaced with compounds shown in Table 7, and these compounds were used in amounts (vol%) shown in Table 7.

(Evaluation)

These organic EL elements were evaluated as described below.

(Measurement of EL spectrum)

Each of the above-prepared organic EL elements was driven to emit light at room temperature (about 25°C) under application of a constant current of 2.5 mA/cm$^2$, and an EL spectrum immediately after light emission was measured with a spectroradiometer CS-2000 (manufactured by Konica Minolta Optics, Inc.) . Table 7 shows the emission intensities of the organic EL elements relative to the emission intensity (taken as 100) of the organic EL element 4-1, which is derived from the TADF compound 4CzIPN. Table 7 also shows the differences [$S_1$(TADF) - $T_1$(P)] and [$T_1$(TADF) - $T_1$(P)].

[Table 7]

| Organic EL element | TADF compound | Phosphorescent metal complex | Host compound | $S_1$ (TADF)-$T_1$ (P) [eV] | $T_1$ (TADF)-$T_1$ (P) [eV] | First lgiht-emitting layer | | | Second light-emitting layer | | | Emission intensity (relative value) | Note |
|---|---|---|---|---|---|---|---|---|---|---|---|---|---|
| | | | | | | TADF compound [Vol%] | Phosphorescent metal complex [Vol%] | Host compound [Vol%] | TADF compound [Vol%] | Phosphorescent metal complex [Vol%] | Host compound [Vol%] | | |
| 4-1 | 4CzIPN | - | CBP | - | - | 5.00 | - | 95.00 | - | - | - | 100 | *3 |
| 4-2 | 4GzIPN | P-9 | CBP | 0.44 | 0.35 | 0.00 | 0.25 | 99.75 | 5.00 | 0.00 | 95.00 | 106 | *3 |
| 4-3 | 4CzIPN | P-133 | CBP | 0.00 | -0.09 | 0.00 | 0.30 | 99.20 | 5.00 | 0.00 | 95.00 | 113 | *3 |
| 4-4 | 4CzIPN | P-134 | CBP | 0.06 | -0.03 | 0.00 | 1.00 | 99.00 | 5.00 | 0.00 | 95.00 | 114 | *3 |
| 4-5 | spiro-CN | P-9 | CBP | 0.29 | 0.23 | 0.00 | 0.30 | 99.70 | 5.00 | 0.00 | 95.00 | 102 | *3 |
| 4-6 | spiro-CN | P-134 | CBP | -0.09 | -0.15 | 0.00 | 1.00 | 99.00 | 5.00 | 0.00 | 96.00 | 105 | *3 |

*3: Comparative Example

The organic EL element 4-2 exhibited strong emission derived from 4CzIPN, and the emission intensity thereof was 1.06 times that of the organic EL element 4-1 containing only 4CzIPN.

(Advantageous effects)

According to the results described above, in the organic EL elements 4-2 to 4-6, the TADF function of 4CzIPN or spiro-CN is activated by the external heavy-atom effect of the phosphorescent metal complex incorporated into the adjacent layer, leading to an increase in emission intensity. This indicates that the phosphorescent metal complex exhibits an external heavy-atom effect on the TADF compound in proximity to the phosphorescent metal complex, even if the phosphorescent metal complex is not present in a layer containing the TADF compound, but present in a layer adjacent to the TADF-compound-containing layer.

[Example 5] (not according to the invention)

(Preparation of organic EL elements 4-1, 4-1a, 4-1b, and 4-2)

The organic EL elements 4-1 and 4-2 prepared in Example 4 were used. The light-emitting layer of the organic EL element 4-1, which contains no phosphorescent compound, is represented as "second light-emitting layer" in Table 8 for the sake of convenience.

An organic EL element 4-1a or 4-1b was prepared as in the organic EL element 4-1, except the thickness of the light-emitting layer (second light-emitting layer) was modified to 30 nm or 20 nm as shown in Table 8.

(Preparation of organic EL elements 5-1 to 5-5)

Organic EL elements 5-1 to 5-5 were prepared as in the organic EL element 4-2, except that the thickness of the second light-emitting layer was modified.

(Evaluation)

These organic EL elements were evaluated as described below.

(Measurement of EL spectrum)

Each of the above-prepared organic EL elements was driven to emit light at room temperature (about 25°C) under application of a constant current of 2.5 $mA/cm^2$, and an EL spectrum immediately after light emission was measured with a spectroradiometer CS-2000 (manufactured by Konica Minolta Optics, Inc.).

Table 8 shows the emission intensities of the organic EL elements relative to the emission intensity (taken as 100) of the organic EL element 4-1, which is derived from the TADF compound 4CzIPN.

[Table 8]

| Organic EL element | Thickness of first light-emitting layer [nm] | Thickness of second light-emitting layer [nm] | Emission intensity (relative value) | Note |
|---|---|---|---|---|
| 4-1 | - | 35 | 100 | Comparative Example |
| 4-1a | - | 30 | 74 | Comparative Example |
| 4-1b | - | 20 | 42 | Comparative Example |
| 4-2 | 10 | 35 | 106 | Comparative Example |
| 5-1 | 10 | 30 | 104 | Comparative Example |
| 5-2 | 10 | 25 | 102 | Comparative Example |

(continued)

| Organic EL element | Thickness of first light-emitting layer [nm] | Thickness of second light-emitting layer [nm] | Emission intensity (relative value) | Note |
|---|---|---|---|---|
| 5-3 | 10 | 20 | 100 | Comparative Example |
| 5-4 | 10 | 15 | 98 | Comparative Example |
| 5-5 | 10 | 10 | 96 | Comparative Example |

The organic EL elements 4-1a and 4-1b, in which the thickness of the second light-emitting layer is reduced in increments of 5 nm relative to that of the organic EL element 4-1, exhibit significantly reduced emission intensity. This is probably attributed to the fact that a decrease in thickness of the second light-emitting layer leads to a reduction in amount of the phosphorescent compound contained in the second light-emitting layer, resulting in low emission intensity of the organic EL element of Comparative Example.

In contrast, the organic EL elements 5-1 to 5-5 maintain their emission intensities, even if the thickness of the second light-emitting layer is reduced in increments of 5 nm relative to that of the organic EL element 4-2 (35 nm). This is probably attributed to the fact that the first light-emitting layer containing the phosphorescent compound is adjacent to the second light-emitting layer containing the TADF compound, and thus a decrease in thickness of the second light-emitting layer causes less reduction in emission intensity by the heavy-atom effect between the adjacent layers.

(Advantageous effects)

According to the results described above, activation of a TADF compound by an external heavy-atom effect leads to a reduction in thickness of an organic layer. This greatly contributes to a reduction in production cost of a device or a reduction in driving voltage of the device.

[Example 6]

(Preparation of organic EL element 6-1)

An indium tin oxide (ITO) anode having a thickness of 150 nm was formed on a glass substrate (50 mm×50 mm, thickness: 0.7 mm), followed by patterning. Subsequently, the transparent substrate having the ITO transparent electrode was ultrasonically washed with isopropyl alcohol, dried with dry nitrogen gas, and cleaned with UV ozone for five minutes. Thereafter, the transparent substrate was fixed onto a substrate holder of a commercially available vacuum deposition apparatus.

Materials for layers were placed in vapor deposition crucibles in the vacuum deposition apparatus, respectively, in amounts suitable for preparation of an EL element. The crucibles were composed of molybdenum or tungsten; i.e., a material for resistance heating.

The vacuum deposition apparatus was evacuated to a vacuum of $1\times10^{-4}$ Pa, and a vapor deposition crucible containing α-NPD was heated by application of electricity. α-NPD was deposited onto the ITO transparent electrode at a deposition rate of 0.1 nm/second, to form a hole injecting transporting layer having a thickness of 40 nm.

Subsequently, CBP (host compound) and 4CzTPN were co-deposited at a deposition rate of 0.1 nm/second, to form a light-emitting layer having a thickness of 35 nm and containing 95 vol% CBP and 5 vol% 4CzTPN.

Thereafter, BCP was deposited at a deposition rate of 0.1 nm/second, to form an electron transporting layer having a thickness of 45 nm.

A lithium fluoride layer having a thickness of 0.5 nm was then formed, and aluminum was deposited onto the lithium fluoride layer, to form a cathode having a thickness of 100 nm.

The non-light-emitting surface of the element was covered with a cylindrical glass casing in an atmosphere of nitrogen gas having a high purity of 99.999% or more, and lead wires for the electrodes were provided, to prepare an organic EL element 6-1.

(Preparation of organic EL element 6-2)

An indium tin oxide (ITO) anode having a thickness of 150 nm was formed on a glass substrate (50 mm×50

mm, thickness: 0.7 mm), followed by patterning. Subsequently, the transparent substrate having the ITO transparent electrode was ultrasonically washed with isopropyl alcohol, dried with dry nitrogen gas, and cleaned with UV ozone for five minutes. Thereafter, the transparent substrate was fixed onto a substrate holder of a commercially available vacuum deposition apparatus.

Materials for layers were placed in vapor deposition crucibles in the vacuum deposition apparatus, respectively, in amounts suitable for preparation of an element. The crucibles were composed of molybdenum or tungsten; i.e., a material for resistance heating.

The vacuum deposition apparatus was evacuated to a vacuum of $1 \times 10^{-4}$ Pa, and a vapor deposition crucible containing $\alpha$-NPD was heated by application of electricity. $\alpha$-NPD was deposited onto the ITO transparent electrode at a deposition rate of 0.1 nm/second, to form a hole transporting injecting layer having a thickness of 40 nm.

Subsequently, CBP (host compound), 4CzTPN, and P-13 were co-deposited at a deposition rate of 0.1 nm/second, to form a light-emitting layer having a thickness of 35 nm and containing 94.5 vol% CBP, 5 vol% 4CzTPN, and 0.5 vol% P-13.

Thereafter, BCP was deposited at a deposition rate of 0.1 nm/second, to form an electron transporting layer having a thickness of 45 nm.

A lithium fluoride layer having a thickness of 0.5 nm was then formed, and aluminum was deposited onto the lithium fluoride layer, to form a cathode having a thickness of 100 nm.

The non-light-emitting surface of the element was covered with a cylindrical glass casing in an atmosphere of nitrogen gas having a high purity of 99.999% or more, and lead wires for the electrodes were provided, to prepare an organic EL element 6-2.

(Preparation of organic EL element 6-3)

An organic EL element 6-3 was prepared as in the organic EL element 6-2, except that the phosphorescent metal complex used in the organic EL element 6-2 was replaced with a compound shown in Table 9.

(Preparation of organic EL element 6-4)

CBP (95 mg), Cu(dnbp) (DPEPhos)$BF_4$ (5 mg), and P-14 (0.5 mg) were dissolved in tetrafluoro-2-propanol (20 mL), and a hole transporting layer was coated with the solution at 1,000 rpm, to form a light-emitting layer having a thickness of 35 nm.

Thereafter, BCP was deposited at a deposition rate of 0.1 nm/second, to form an electron transporting layer having a thickness of 45 nm.

A lithium fluoride layer having a thickness of 0.5 nm was then formed, and aluminum was deposited onto the lithium fluoride layer, to form a cathode having a thickness of 100 nm.

The non-light-emitting surface of the element was covered with a cylindrical glass casing in an atmosphere of nitrogen gas having a high purity of 99.999% or more, and lead wires for the electrodes were provided, to prepare an organic EL element 6-4.

(Preparation of organic EL elements 6-5 to 6-7)

Organic EL elements 6-5 to 6-7 were prepared as in the organic EL element 6-4, except that the amounts of the host compound, phosphorescent metal complex, and TADF compound used in the organic EL element 6-4 were modified as shown in Table 9.

(Evaluation)

These organic EL elements 6-1 to 6-7 were evaluated as described below.

(Measurement of luminance)

Each of the above-prepared organic EL elements was driven to emit light at room temperature (about 25°C) under application of a constant current of 2.5 mA/$cm^2$, and a luminance immediately after light emission was measured with a spectroradiometer CS-2000 (manufactured by Konica Minolta Optics, Inc.).

Subsequently, the relative luminance of the organic EL element was determined on the basis of the luminance (taken as 100) of the organic EL element 6-1 of Comparative Example. The determined relative luminance was used as an indicator of emission efficiency (external quantum efficiency). A larger relative luminance indicates a higher emission efficiency.

(Measurement of initial driving voltage)

The luminance of each sample was measured at room temperature (about 25°C) with a spectroradiometer CS-2000 (manufactured by Konica Minolta Sensing, Inc.), and the initial driving voltage at a luminance of 1,000 cd/$m^2$ was determined. Table shows the results.

Table 9 shows the initial driving voltages of the organic EL elements 6-2 to 6-7 relative to the initial driving voltage (taken as 100) of the organic EL element 6-1. In Table 9, a smaller relative value indicates a lower initial driving voltage.

(Evaluation of continuous driving stability (half-life))

Each sample was wound around a cylinder having a radius of 5 cm, and the wound sample was continuously driven. The luminance of the sample was measured with a spectroradiometer CS-2000, to determine a half-life of luminance (LT50).

Each sample was driven under application of a current such that the luminance at initiation of continuous driving was 4,000 cd/$m^2$.

The relative LT50 of each organic EL element was determined on the basis of the LT50 (taken as 100) of the organic EL element 6-1. The determined relative value was used as an indicator of continuous driving stability. Table shows the results of evaluation. In Table 9, a larger relative value indicates a higher continuous driving stability (longer lifetime).

Table 9 shows the difference [$S_1$(TADF) - $T_1$(P)] or [$T_1$(TADF) - $T_1$(P)] together with the results of evaluation.

[Table 9]

| Organic EL element | TADF compound | Phosphorascent metal complex | Host compound | $S_1$ (TADF)-$T_1$ (P) [eV] | $T_1$ (TADF)-$T_1$ (P) [eV] | Light-emitting layer | | | External quantum efficiency (relative value) | Initial driving voltage (relative value) | Half-life (relative value) | Note |
|---|---|---|---|---|---|---|---|---|---|---|---|---|
| | | | | | | TADF compound [Vol%] | Phosphorescent metal complex [Vol%] | Host compound [Vol%] | | | | |
| 6-1 | 4CzTPN | - | CBP | - | - | 5.00 | - | 95.00 | 100 | 100 | 100 | *5 |
| 6-2 | 4CzTPN | P-13 | CBP | 0.13 | - | 5.00 | 0.50 | 94.50 | 125 | 93 | 111 | Example |
| 6-3 | 4GzTPN | P-135 | CBP | -0.08 | - | 5.00 | 0.50 | 94.50 | 123 | 94 | 117 | Example |
| 6-4 | *4 | P-14 | CBP | - | 0.04 | 5.00 | 0.50 | 94.50 | 112 | 92 | 124 | Example |
| 6-5 | *4 | P-14 | CBP | - | 0.04 | 5.00 | 1.00 | 94.00 | 117 | 91 | 128 | Example |
| 6-6 | *4 | P-83 | CBP | - | 0.16 | 5.00 | 0.80 | 94.20 | 111 | 95 | 126 | Example |
| 6-7 | *4 | P-70 | CBP | - | 0.15 | 5.00 | 0.80 | 94.20 | 115 | 94 | 122 | Example |

*4 : Cu (dndp) (DPEPhos) BF4
*5 : Comparative Example

(Advantageous effects)

With reference to Table 9, the organic EL elements 6-2 to 6-7 exhibit high external quantum efficiency, low driving voltage, and improved lifetime. In particular, the phosphorescent metal complex used in the present invention, which has a specific structure, significantly contributes to these effects. That is, the phosphorescent metal complex used in the organic EL elements 6-2 to 6-7 exhibits a significant external heavy-atom effect, because it has very high stability and quantum yield.
This effect is more pronounced if the difference [$S_1$(TADF) - $T_1$(P)] or [$T_1$(TADF) - $T_1$(P)] is smaller, which is probably attributed to a good balance between emission from the phosphorescent material caused by energy of thermal deactivation from $T_1$ of the TADF compound and activation of the TADF compound by the external heavy-atom effect.

[Example 7]

(Preparation of organic EL elements 6-1 and 6-2)

The organic EL elements 6-1 and 6-2 prepared in Example 6 were used.

(Preparation of organic EL elements 6-1a and 6-1b)

An organic EL element 6-1a or 6-1b was prepared as in the organic EL element 6-1, except that the thickness of the light-emitting layer was modified to 20 nm or 10 nm as shown in Table 10.

(Preparation of organic EL elements 7-1 to 7-5)

Organic EL elements 7-1 to 7-5 were prepared as in the organic EL element 6-2, except that the thickness of the light-emitting layer was modified.

(Evaluation)

The prepared organic EL elements were evaluated as described below.

(Measurement of EL spectrum)

Each of the above-prepared organic EL elements was driven to emit light at room temperature (about 25°C) under application of a constant current of 2.5 mA/$cm^2$, and an EL spectrum immediately after light emission was measured with a spectroradiometer CS-2000 (manufactured by Konica Minolta Optics, Inc.) . Table 10 shows the emission intensities of the organic EL elements relative to the emission intensity (taken as 100) of the organic EL element 6-1, which is derived from the TADF compound 4CzPN.
In the organic EL elements 6-1, 6-1a, and 6-1b (Comparative Example), which contain no phosphorescent compound in the light-emitting layer, a decrease in thickness of the light-emitting layer leads to a significant reduction in emission intensity. In contrast, in the organic EL elements 6-2 and 7-1 to 7-5, high emission intensity is maintained even if the thickness of the light-emitting layer is one half or less of that of the light-emitting layer of the organic EL element 6-1, although emission intensity is slightly reduced with a decrease in thickness of the light-emitting layer in increments of 5 nm. This is probably attributed to the fact that the phosphorescent compound exhibits a heavy-atom effect on the TADF compound, which is present with the phosphorescent compound in a single light-emitting layer.

[Table 10]

| Organic EL element | Thickness of light-emitting layer [nm] | Emission intensity (relative value) | Note |
|---|---|---|---|
| 6-1 | 35 | 100 | Comparative Example |
| 6-1a | 20 | 81 | Comparative Example |
| 6-1b | 10 | 40 | Comparative Example |

(continued)

| Organic EL element | Thickness of light-emitting layer [nm] | Emission intensity (relative value) | Note |
|---|---|---|---|
| 6-2 | 35 | 122 | Example |
| 7-1 | 30 | 115 | Example |
| 7-2 | 25 | 109 | Example |
| 7-3 | 20 | 104 | Example |
| 7-4 | 15 | 99 | Example |
| 7-5 | 10 | 95 | Example |

(Advantageous effects)

According to the results described above, activation of a TADF compound by an external heavy-atom effect leads to a reduction in thickness of an organic layer. This greatly contributes to a reduction in production cost of a device or a reduction in driving voltage of the device.

[Example 8]

Organic EL elements 8-1 to 8-5 were prepared as in Example 3, except that the compounds for the organic EL elements 4-2 to 4-6 of Example 4 were used in amounts (vol%) shown in Table 11.

(Evaluation)

The prepared organic EL elements were evaluated as described below.

(Measurement of EL spectrum)

Each of the above-prepared organic EL elements was driven to emit light at room temperature (about 25°C) under application of a constant current of 2.5 $mA/cm^2$, and a luminance immediately after light emission was measured with a spectroradiometer CS-2000 (manufactured by Konica Minolta Optics, Inc.).

Subsequently, the relative luminance of the organic EL element was determined on the basis of the luminance (taken as 100) of the organic EL element 4-2. The determined relative luminance was used as an indicator of emission efficiency (external quantum efficiency). Table 11 shows the results together with the luminances of the organic EL elements 4-2 to 4-6 of Example 4.

[Table 11]

| Organic EL element | Organic EL element of corresponding Example 4 | TADF compound | Phosphorescent metal complex | Host compound | $S_1$ (TADF)-$T_1$ (P) [eV] | $T_1$ (TADF)-$T_1$ (P) [eV] | Light-emitting layer | | | External quantum efficiency | | Note |
|---|---|---|---|---|---|---|---|---|---|---|---|---|
| | | | | | | | TADF compound [Vol%] | Phosphorescent metal complex [Vol%] | Host compound [Vol%] | (Example 8) (Relative value) | (Example 4) (Relative value) | |
| 8-1 | 4-2 | 4CzIPN | P-9 | CBP | 0.44 | 0.35 | 5.00 | 0.08 | 94.92 | 105 | 100 | Example |
| 8-2 | 4-3 | 4CzIPN | P-133 | CBP | 0.00 | -0.09 | 5.00 | 0.27 | 94.73 | 112 | 107 | Example |
| 8-3 | 4-4 | 4CzIPN | P-134 | CBP | 0.06 | -0.03 | 5.04 | 0.33 | 94.67 | 113 | 108 | Example |
| 8-4 | 4-5 | spiro-CN | P-9 | CBP | 0.29 | 0.23 | 5.00 | 0.10 | 94.90 | 107 | 96 | Example |
| 8-5 | 4-6 | spiro-CN | P-134 | CBP | -0.09 | -0.15 | 5.00 | 0.33 | 94.67 | 109 | 99 | Example |

(Advantageous effects)

In the organic EL elements 8-1 to 8-5, the TADF compound and the phosphorescent metal complex are present in a single layer, and thus a component thermally deactivated from $T_1$ of the TADF compound is more effectively trapped through energy transfer by the Dexter mechanism in addition to energy transfer by the Foerster mechanism, resulting in improved emission efficiency.

Comparison between Examples 4 and 8 indicates that better effects are achieved if the concentration of the phosphorescent metal complex, which is present together with the TADF compound in a single layer, is lower than that in the case where the phosphorescent metal complex is contained in a layer adjacent to the layer containing the TADF compound.

[Example 9]

(Preparation of organic EL elements 9-1 to 9-3)

Organic EL elements 9-1 to 9-3 were prepared as in the organic EL element 8-1 of Example 8, except that the TADF compound and the phosphorescent metal complex were replaced with those shown in Table 12, and the amount (vol%) of the phosphorescent metal complex used was modified as shown in Table 12.

(Evaluation)

The prepared organic EL elements were evaluated as described below.

(Measurement of EL spectrum)

Each of the above-prepared organic EL elements was driven to emit light at room temperature (about 25°C) under application of a constant current of 2.5 mA/cm$^2$, and a luminance immediately after light emission was measured with a spectroradiometer CS-2000 (manufactured by Konica Minolta Optics, Inc.).

Subsequently, the relative luminance of the organic EL element was determined on the basis of the luminance (taken as 100) of the organic EL element 8-1 of Example 8. The determined relative luminance was used as an indicator of emission efficiency (external quantum efficiency).

[Table 12]

| Organic EL element | TADF compound | Phosphorescent metal complex | Host compound | $S_1$(TADF) $-T_1$(P) [eV] | Light-emitting layer | | | External quantum efficiency (relative value) | Note |
|---|---|---|---|---|---|---|---|---|---|
| | | | | | TADF compound [Vol%] | Phosphorescent metal complex [Vol%] | Host compound [Vol%] | | |
| 8-1 | 4CzIPN | P-9 | CBP | 0.44 | 5.00 | 0.08 | 94.92 | 100 | Example |
| 9-1 | 4CzPN | P-60 | CBP | -0.04 | 5.00 | 0.33 | 94.67 | 108 | Example |
| 9-2 | 4CzPN | P-88 | CBP | -0.09 | 5.00 | 0.27 | 94.73 | 106 | Example |
| 9-3 | 4CzPN | P-70 | CBP | -0.15 | 5.00 | 0.22 | 94.78 | 105 | Example |

(Advantageous effects)

In the organic EL elements 9-1 to 9-3, the TADF compound and the phosphorescent metal complex are present in a single layer, and thus a component thermally deactivated from $T_1$ of the TADF compound is more effectively trapped through energy transfer by the Dexter mechanism in addition to energy transfer by the Foerster mechanism, resulting in improved emission efficiency. In particular, the phosphorescent metal complex used in the present invention, which has a specific structure, significantly contributes to these effects. That is, the phosphorescent metal complex used in the organic EL elements 9-1 to 9-3 exhibits a significant external heavy-atom effect, because it has very high stability and quantum yield.

[Example 10]

(Preparation of organic EL element 10-1)

An indium tin oxide (ITO) anode having a thickness of 150 nm was formed on a glass substrate (50 mm×50 mm, thickness: 0.7 mm), followed by patterning. Subsequently, the transparent substrate having the ITO transparent electrode was ultrasonically washed with isopropyl alcohol, dried with dry nitrogen gas, and cleaned with UV ozone for five minutes. Thereafter, the transparent substrate was fixed onto a substrate holder of a commercially available vacuum deposition apparatus.

Materials for layers were placed in vapor deposition crucibles in the vacuum deposition apparatus, respectively, in amounts suitable for preparation of an element. The crucibles were composed of molybdenum or tungsten; i.e. , a material for resistance heating.

The vacuum deposition apparatus was evacuated to a vacuum of $1\times10^{-4}$ Pa, and a vapor deposition crucible containing α-NPD was heated by application of electricity. α-NPD was deposited onto the ITO transparent electrode at a deposition rate of 0.1 nm/second, to form a hole injecting transporting layer having a thickness of 40 nm.

Subsequently, DEPEO (host compound) and TADF-3 (TADF) were co-deposited at a deposition rate of 0.1 nm/second, to form a light-emitting layer having a thickness of 35 nm and containing 90 vol% DEPEO and 10 vol% TADF-3. DEPEO was then deposited at a deposition rate of 0.1 nm/second, to form a first electron transporting layer having a thickness of 10 nm.

Thereafter, TPBi was deposited at a deposition rate of 0.1 nm/second, to form a second electron transporting layer having a thickness of 30 nm.

A lithium fluoride layer having a thickness of 0.5 nm was then formed, and aluminum was deposited onto the lithium fluoride layer, to form a cathode having a thickness of 100 nm.

The non-light-emitting surface of the element was covered with a cylindrical glass casing in an atmosphere of nitrogen gas having a high purity of 99.999% or more, and lead wires for the electrodes were provided, to prepare an organic EL element 10-1.

(Preparation of organic EL elements 10-2 to 10-19)

Organic EL elements 10-2 to 10-19 were prepared as in the organic EL element 10-1, except that TADF-3 and a phosphorescent metal complex were co-deposited at a deposition rate of 0.1 nm/second, to form a light-emitting layer having a thickness of 35 nm and containing TADF-3 and the phosphorescent metal complex in amounts (vol%) shown in Table 13.

(Evaluation)

The organic EL elements 10-1 to 10-19 were evaluated as described below.

(Measurement of luminance)

Each of the above-prepared organic EL elements was driven to emit light at room temperature (about 25°C) under application of a constant current of 2.5 mA/$cm^2$, and a luminance immediately after light emission was measured with a spectroradiometer CS-2000 (manufactured by Konica Minolta Optics, Inc.).

Subsequently, the relative luminance of the organic EL element was determined on the basis of the luminance (taken as 100) of the organic EL element 10-1. The determined relative luminance was used as an indicator of emission efficiency (external quantum efficiency). A larger relative luminance indicates a higher emission efficiency.

(Measurement of initial driving voltage)

The luminance of each sample was measured at room temperature (about 25°C) with a spectroradiometer CS-2000 (manufactured by Konica Minolta Sensing, Inc.), and the initial driving voltage at a luminance of 1,000 cd/$m^2$ was determined. Table 13 shows the results.

Table 13 shows the initial driving voltages of the organic EL elements 10-2 to 10-19 relative to the initial driving voltage (taken as 100) of the organic EL element 10-1. In Table 13, a smaller relative value indicates a lower initial driving voltage.

(Evaluation of continuous driving stability (half-life))

Each sample was wound around a cylinder having a radius of 5 cm, and the wound sample was continuously driven. The luminance of the sample was measured with a spectroradiometer CS-2000, to determine a half-life of luminance (LT50) . Each sample was driven under application of a current such that the luminance at initiation of continuous driving was 4,000 cd/$m^2$.

The relative LT50 of each organic EL element was determined on the basis of the LT50 (taken as 100) of the organic EL element 10-1. The determined relative value was used as an indicator of continuous driving stability. Table shows the results. In Table 13, a larger relative value indicates a higher continuous driving stability (longer lifetime).

Table 13 shows the differences [$S_1$(TADF) - $T_1$(P)] and [$T_1$(TADF) - $T_1$(P)] together with the results of evaluation.

[Table 13]

| Organic EL element | TADF compound | Phosphorescent metal complex | Host compound | $S_1$ (TADF)-$T_1$ (P) [eV] | $T_1$ (TADF)-$T_0$ (P) [eV] | Light-emitting layer: TADF compound [Vol%] | Light-emitting layer: Phosphorescent metal complex [Vol%] | Light-emitting layer: Host compound [Vol%] | External quantum efficiency (relative value) | Initial driving voltage (relative value) | Half-life (relative value) | Note |
|---|---|---|---|---|---|---|---|---|---|---|---|---|
| 10-1 | TADF-3 | - | DEPEO | - | - | 10 | - | 90.00 | 100 | 100 | 100 | *6 |
| 10-2 | TADF-3 | P-99 | DEPEO | 0.58 | 0.26 | 10 | 0.20 | 89.80 | 114 | 98 | 115 | Example |
| 10-3 | TADF-3 | P-93 | DEPEO | 0.49 | 0.17 | 10 | 0.24 | 89.76 | 119 | 97 | 118 | Example |
| 10-4 | TADF -3 | P-50 | DEPEO | 0.59 | 0.27 | 10 | 0.20 | 89.80 | 113 | 96 | 124 | Example |
| 10-5 | TADF-3 | P-2 | DEPEO | 0.43 | 0.11 | 10 | 0.25 | 89.75 | 110 | 98 | 112 | Example |
| 10-6 | CC2TA | - | DEPEO | - | - | 6 | - | 94.00 | 95 | 104 | 123 | *6 |
| 10-7 | CC2TA | P-26 | DEPEO | 0.25 | 0.19 | 6 | 0.41 | 93.59 | 107 | 96 | 134 | Example |
| 10-8 | CC2TA | P-18 | DEPEO | 0.14 | 0.08 | 6 | 0.50 | 93.50 | 112 | 98 | 129 | Example |
| 10-9 | CC2TA | P-46 | DEPEO | 0.21 | 0.15 | 6 | 0.43 | 93.57 | 110 | 96 | 135 | Example |
| 10-10 | CC2TA | P-122 | DEPEO | 0.23 | 0.17 | 6 | 0.42 | 93.58 | 109 | 98 | 127 | Example |
| 10-11 | CC2TA | P-33 | DEPEO | 0.25 | 0.19 | 6 | 0.41 | 93.59 | 108 | 95 | 137 | Example |
| 10-12 | CC2TA | P-9 | DEPEO | 0.90 | 0.84 | 6 | 0.01 | 93.99 | 97 | 99 | 124 | Example |
| 10-13 | 4CzIPN | - | DEPEO | - | - | 5 | - | 95.00 | 118 | 98 | 135 | *6 |
| 10-14 | 4CzIPN | P-130 | DEPEO | 0.04 | -0.05 | 5 | 0.62 | 94.38 | 139 | 93 | 141 | Example |
| 10-15 | 4CzIPN | P-110 | DEPEO | -0.08 | 0.17 | 5 | 0.10 | 94.90 | 136 | 93 | 139 | Example |
| 10-16 | 4CzIPN | P-61 | DEPEO | 0.09 | 0.00 | 5 | 0.84 | 94.16 | 148 | 91 | 147 | Example |
| 10-17 | TADF-3 | P-9 | DEPEO | 1.29 | 0.97 | 10 | 0.08 | 89.92 | 102 | 99 | 103 | Example |
| 10-18 | TADF-3 | P-9 | DEPEO | 1.29 | 0.97 | 10 | 0.01 | 89.99 | 107 | 97 | 108 | Example |
| 10-19 | TADF-3 | P-13 | DEPEO | 1.11 | 0.79 | 10 | 0.01 | 89.99 | 108 | 98 | 111 | Exampe |

*6 : Comparative Example

(4) Advantageous effects

With reference to Table 13, the organic EL elements 10-2 to 10-5, 10-7 to 10-12, and 10-14 to 10-19 exhibit high external quantum efficiency, low driving voltage, and improved lifetime, as compared with the case where only the TADF compound is used. In particular, the phosphorescent metal complex used in the present invention, which has a specific structure, significantly contributes to these effects. That is, the phosphorescent metal complex used in the organic EL elements 10-2 to 10-5, 10-7 to 10-12, and 10-14 to 10-19 exhibits a significant external heavy-atom effect, because it has very high stability and quantum yield (see Fig. 4). This effect is more pronounced if $\Delta$ [$T_1$(TADF) - $T_1$(P)] is smaller, which is probably attributed to a balance between emission from the phosphorescent material caused by energy of thermal deactivation from $T_1$ of the TADF compound and activation of the TADF compound by the external heavy-atom effect.

INDUSTRIAL APPLICABILITY

The present invention can provide an organic EL element exhibiting improved emission efficiency. The organic EL element can be suitably used for display devices, displays, household lighting devices, in-vehicle lighting devices, backlight units of watches and liquid crystal displays, billboards, traffic signals, light sources for optical storage media, light sources for electrophotocopiers, light sources for optical communication processors, light sources for optical sensors, and light sources for, for example, common household electric appliances requiring display devices.

REFERENCE SIGNS LIST

1: display
3: pixel
5: scanning line
6: data line
7: power source line
10: organic EL element
11: switching transistor
12: driving transistor
13: capacitor
101: organic EL element
102: glass casing
105: cathode
106: organic EL layer
107: glass substrate having transparent electrode
108: nitrogen gas
109: water-collecting agent
A: display unit
B: control unit
C: wiring unit

## Claims

**1.** An organic electroluminescent element comprising:

a pair of electrodes; and
one or more organic layers disposed between the paired electrodes,
wherein each of a thermally activated delayed fluorescent compound, and a heavy atom compound which exhibits an external heavy-atom effect of promoting an intersystem crossing of the thermally activated delayed fluorescent compound from a triplet excitation state to a singlet excitation state and enhancing fluorescence emission, is contained in any of the organic layers,
**characterized in that** the heavy atom compound is a phosphorescent metal complex and the phosphorescent metal complex is contained in an amount of 0.05 mass% to 25 mass%, relative to the entire amount of the thermally activated delayed fluorescent compound, and

the thermally activated delayed fluorescent compound and the phosphorescent metal complex are contained in a single light-emitting layer.

2. The organic electroluminescent element of claim 1, wherein the thermally activated delayed fluorescent compound and the heavy atom compound are in proximity to each other within a range of a distance in which the external heavy-atom effect is achieved.

3. The organic electroluminescent element of claim 1, wherein the thermally activated delayed fluorescent compound emits fluorescence, and the phosphorescent metal complex emits phosphorescence.

4. The organic electroluminescent element of any one of claims 1 to 3, wherein a difference between a lowest excited singlet energy level of the thermally activated delayed fluorescent compound ($S_1$(TADF)) and a lowest excited triplet energy level of the phosphorescent metal complex ($T_1$(P)) satisfies Expression (1):

$$\text{Expression (1): } -0.2 \text{ eV} \leq [S_1(\text{TADF}) - T_1(\text{P})] \leq 1.0 \text{ eV.}$$

5. The organic electroluminescent element of any one of claims 1 to 4, wherein a difference between a lowest excited singlet energy level of the thermally activated delayed fluorescent compound ($S_1$(TADF)) and a lowest excited triplet energy level of the phosphorescent metal complex ($T_1$(P)) satisfies Expression (2):

$$\text{Expression (2): } 0 \text{ eV} \leq [S_1(\text{TADF}) - T_1(\text{P})] \leq 0.2 \text{ eV.}$$

6. The organic electroluminescent element of any one of claims 1 to 5, wherein a difference between a lowest excited triplet energy level of the thermally activated delayed fluorescent compound ($T_1$(TADF)) and a lowest excited triplet energy level of the phosphorescent metal complex ($T_1$(P)) satisfies Expression (3):

$$\text{Expression (3): } -0.2 \text{ eV} \leq [T_1(\text{TADF}) - T_1(\text{P})] \leq 0.5 \text{ eV.}$$

7. The organic electroluminescent element of any one of claims 1 to 6, wherein a difference between a lowest excited triplet energy level of the thermally activated delayed fluorescent compound ($T_1$(TADF)) and a lowest excited triplet energy level of the phosphorescent metal complex ($T_1$(P)) satisfies Expression (4):

$$\text{Expression (4): } 0 \text{ eV} \leq [T_1(\text{TADF}) - T_1(\text{P})] \leq 0.1 \text{ eV.}$$

8. The organic electroluminescent element of any one of claims 1 to 7, wherein a lowest excited triplet energy level of the thermally activated delayed fluorescent compound ($T_1$(TADF)) falls within a range of 2.4 to 3.5 eV.

9. The organic electroluminescent element of any one of claims 1 to 8, wherein the phosphorescent metal complex has a structure represented by Formula (I):

[F1]

Formula(I)

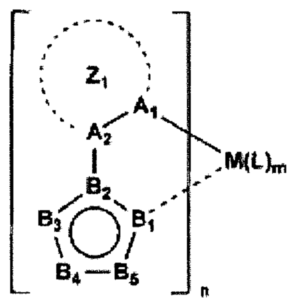

wherein M represents Ir, Pt, Rh, Ru, Ag, Cu, or Os; $A_1$ and $A_2$ each represent a carbon or nitrogen atom; $Z_1$ represents a 6-membered aromatic hydrocarbon ring or 5- or 6-membered aromatic heterocyclic ring including $A_1$ and $A_2$; $B_1$ to $B_5$ are atoms forming a 5-membered aromatic heterocyclic group, each of which represents a carbon, nitrogen, oxygen, or sulfur atom optionally having a substituent; the ring $Z_1$ optionally has one or more substituents optionally forming a condensed ring structure; ligands are optionally linked together through bonding of substituents of the ligands; L represents a monoanionic bidentate ligand coordinating to M; m represents an integer of 0 to 2; n represents an integer of 1 to 3; m+n is 2 or 3; and, if m or n is 2 or more, the ring $Z_1$, the aromatic heterocyclic group represented by $B_1$ to $B_5$, and L are identical to or different from one another.

**10.** A lighting device comprising the organic electroluminescent element of any one of claims 1 to 9.

**11.** A display device comprising the organic electroluminescent element of any one of claims 1 to 9.

**Patentansprüche**

**1.** Organisches Elektrolumineszenzelement, umfassend:

ein Elektrodenpaar; und
eine oder mehrere organische Schichten, welche zwischen den gepaarten Elektroden angeordnet sind,
wobei eine thermisch aktivierte, verzögerte Fluoreszenz emittierende Verbindung und eine Schweratomverbindung, welche einen externen Schweratomeffekt in Form einer Förderung eines Intersystem Crossings der thermisch aktivierte, verzögerte Fluoreszenz emittierenden Verbindung von einem angeregten Triplett-Zustand zu einem angeregten Singulett-Zustand sowie einer Erhöhung der Fluoreszenzemission ausübt, in jeder der organischen Schichten enthalten sind,
**dadurch gekennzeichnet, dass** es sich bei der Schweratomverbindung um einen phosphoreszierenden Metallkomplex handelt und der phosphoreszierende Metallkomplex in einer Menge von 0.05 Masse% bis 25 Masse%, bezogen auf die Gesamtmenge der thermisch aktivierte, verzögerte Fluoreszenz emittierenden Verbindung, enthalten ist, und
die thermisch aktivierte, verzögerte Fluoreszenz emittierende Verbindung und der phosphoreszierende Metallkomplex in einer einzelnen lichtemittierenden Schicht enthalten sind.

**2.** Organisches Elektrolumineszenzelement gemäß Anspruch 1, wobei die thermisch aktivierte, verzögerte Fluoreszenz emittierende Verbindung und die Schweratomverbindung in einem Abstandsbereich, in welchem der externe Schweratomeffekt erzielt wird, voneinander entfernt sind.

**3.** Organisches Elektrolumineszenzelement gemäß Anspruch 1, wobei die thermisch aktivierte, verzögerte Fluoreszenz emittierende Verbindung Fluoreszenz emittiert und der phosphoreszierende Metallkomplex Phosphoreszenz emittiert.

**4.** Organisches Elektrolumineszenzelement gemäß einem der Ansprüche 1 bis 3, wobei die Differenz zwischen dem niedrigsten angeregten Singulett-Energieniveau der thermisch aktivierte, verzögerte Fluoreszenz emittierenden Verbindung ($S_1$(TADF)) und dem niedrigsten angeregten Triplett-Energieniveau des phosphoreszierenden Metallkomplexes ($T_1$(P)) den Ausdruck (1) erfüllt:

$$\text{Ausdruck (1): } -0.2 \text{ eV} \leq [S_1(\text{TADF}) - T_1(\text{P})] \leq 1.0 \text{ eV.}$$

**5.** Organisches Elektrolumineszenzelement gemäß einem der Ansprüche 1 bis 4, wobei die Differenz zwischen dem niedrigsten angeregten Singulett-Energieniveau der thermisch aktivierte, verzögerte Fluoreszenz emittierenden Verbindung ($S_1$(TADF)) und dem niedrigsten angeregten Triplett-Energieniveau des phosphoreszierenden Metallkomplexes ($T_1$(P)) den Ausdruck (2) erfüllt:

$$\text{Ausdruck (2): } 0 \text{ eV} \leq [S_1(\text{TADF}) - T_1(\text{P})] \leq 0.2 \text{ eV.}$$

**6.** Organisches Elektrolumineszenzelement gemäß einem der Ansprüche 1 bis 5, wobei die Differenz zwischen dem

niedrigsten angeregten Triplett-Energieniveau der thermisch aktivierte, verzögerte Fluoreszenz emittierenden Verbindung ($T_1$(TADF)) und dem niedrigsten angeregten Triplett-Energieniveau des phosphoreszierenden Metallkomplexes ($T_1$(P)) den Ausdruck (3) erfüllt:

$$\text{Ausdruck (3): } -0.2\ \text{eV} \leq [T_1(\text{TADF}) - T_1(\text{P})] \leq 0.5\ \text{eV}.$$

7. Organisches Elektrolumineszenzelement gemäß einem der Ansprüche 1 bis 6, wobei die Differenz zwischen dem niedrigsten angeregten Triplett-Energieniveau der thermisch aktivierte, verzögerte Fluoreszenz emittierenden Verbindung ($T_1$(TADF)) und dem niedrigsten angeregten Triplett-Energieniveau des phosphoreszierenden Metallkomplexes ($T_1$(P)) den Ausdruck (4) erfüllt:

$$\text{Ausdruck (4): } 0\ \text{eV} \leq [T_1(\text{TADF}) - T_1(\text{P})] \leq 0.1\ \text{eV}.$$

8. Organisches Elektrolumineszenzelement gemäß einem der Ansprüche 1 bis 7, wobei das niedrigste angeregte Triplett-Energieniveau der thermisch aktivierte, verzögerte Fluoreszenz emittierenden Verbindung ($T_1$(TADF)) in einen Bereich von 2.4 bis 3.5 eV fällt.

9. Organisches Elektrolumineszenzelement gemäß einem der Ansprüche 1 bis 8, wobei der phosphoreszierende Metallkomplex eine durch die Formel (I) dargestellte Struktur aufweist:

[F1]

**Formel (I)**

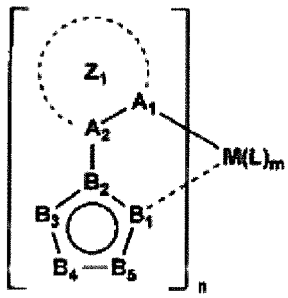

worin M für Ir, Pt, Rh, Ru, Ag, Cu oder Os steht; $A_1$ und $A_2$ jeweils für ein Kohlenstoff- oder Stickstoffatom stehen; $Z_1$ für einen $A_1$ und $A_2$ beinhaltenden 6-gliedrigen aromatischen Kohlenwasserstoffring oder 5- oder 6-gliedrigen aromatischen, heterozyklischen Ring steht; $B_1$ bis $B_5$ Atome darstellen, welche eine 5-gliedrige aromatische, heterozyklische Gruppe ausbilden, wobei jedes hiervon für ein Kohlenstoff-, Stickstoff-, Sauerstoff- oder Schwefelatom steht, das gegebenenfalls einen Substituenten aufweist; der Ring $Z_1$ gegebenenfalls einen oder mehrere Substituenten aufweist, welche gegebenenfalls eine kondensierte Ringstruktur ausbilden; Liganden gegebenenfalls durch eine Verknüpfung von Substituenten der Liganden miteinander verbunden sind; L für einen monoanionischen, zweizähnigen Liganden steht, welcher an M koordiniert; m für eine ganze Zahl von 0 bis 2 steht; n für eine ganze Zahl von 1 bis 3 steht; m+n für 2 oder 3 steht; und, wenn m oder n für 2 oder mehr steht, der Ring $Z_1$, die die durch $B_1$ bis $B_5$ dargestellte aromatische, heterozyklische Gruppe und L identisch sind oder sich voneinander unterscheiden.

10. Beleuchtungsvorrichtung, welche das organische Elektrolumineszenzelement gemäß einem der Ansprüche 1 bis 9 umfasst.

11. Anzeigevorrichtung, welche das organische Elektrolumineszenzelement gemäß einem der Ansprüche 1 bis 9 umfasst.

## Revendications

1. Elément électroluminescent organique comprenant :

   une paire d'électrodes ; et
   une ou plusieurs couches organiques disposées entre les électrodes appariées,
   dans lequel chacun d'un composé à fluorescence retardée à activation thermique, et d'un composé à atome lourd qui présente un effet d'atome lourd externe consistant à favoriser un croisement intersystème du composé à fluorescence retardée à activation thermique d'un état d'excitation triplet à un état d'excitation singulet et à amplifier une émission de fluorescence, est contenu dans l'une quelconque des couches organiques,
   **caractérisé en ce que** le composé à atome lourd est un complexe métallique phosphorescent et le complexe de métal phosphorescent est contenu dans une quantité de 0,05 % en masse à 25 % en masse, rapporté à la quantité totale du composé à fluorescence retardée à activation thermique, et
   le composé à fluorescence retardée à activité thermique et le complexe métallique phosphorescent sont contenus dans une seule couche électroluminescente.

2. Elément électroluminescent organique selon la revendication 1, dans lequel le composé à fluorescence retardée à activation thermique et le composé à atome lourd sont à proximité l'un de l'autre dans une plage d'une distance dans laquelle l'effet d'atome lourd externe est accompli.

3. Elément électroluminescent organique selon la revendication 1, dans lequel le composé à fluorescence retardée à activation thermique émet de la fluorescence, et le complexe métallique phosphorescent émet de la phosphorescence.

4. Elément électroluminescent organique selon l'une quelconque des revendications 1 à 3, dans lequel une différence entre un niveau d'énergie singulet excité le plus bas du composé à fluorescence retardée à activation thermique ($S_1$(TADF)) et un niveau d'énergie triplet excité le plus bas du complexe métallique phosphorescent ($T_1$(P)) satisfait l'Expression (1) :

$$\text{Expression (1) : } -0{,}2\ \text{eV} \leq [S_1(\text{TADF}) - T_1(\text{P})] \leq 1{,}0\ \text{eV.}$$

5. Elément électroluminescent organique selon l'une quelconque des revendications 1 à 4, dans lequel une différence entre un niveau d'énergie singulet excité le plus bas du composé à fluorescence retardée à activation thermique ($S_1$(TADF)) et un niveau d'énergie triplet excité le plus bas du complexe métallique phosphorescent ($T_1$(P)) satisfait l'Expression (2) :

$$\text{Expression (2) : } 0\ \text{eV} \leq [S_1(\text{TADF}) - T_1(\text{P})] \leq 0{,}2\ \text{eV.}$$

6. Elément électroluminescent organique selon l'une quelconque des revendications 1 à 5, dans lequel une différence entre un niveau d'énergie triplet excité le plus bas du composé à fluorescence retardée à activation thermique ($T_1$(TADF)) et un niveau d'énergie triplet excité le plus bas du complexe métallique phosphorescent ($T_1$(P)) satisfait l'Expression (3) :

$$\text{Expression (3) : } -0{,}2\ \text{eV} \leq [T_1(\text{TADF}) - T_1(\text{P})] \leq 0{,}5\ \text{eV.}$$

7. Elément électroluminescent organique selon l'une quelconque des revendications 1 à 6, dans lequel une différence entre un niveau d'énergie triplet excité le plus bas du composé à fluorescence retardée à activation thermique ($T_1$(TADF)) et un niveau d'énergie triplet excité le plus bas du complexe métallique phosphorescent ($T_1$(P)) satisfait l'Expression (4) :

$$\text{Expression (4) : } 0\ \text{eV} \leq [T_1(\text{TADF}) - T_1(\text{P})] \leq 0{,}1\ \text{eV.}$$

8. Elément électroluminescent organique selon l'une quelconque des revendications 1 à 7, dans lequel un niveau

d'énergie triplet excité le plus bas du composé à fluorescence retardée à activation thermique ($T_1$(TADF)) se situe dans une plage de 2,4 à 3,5 eV.

**9.** Elément électroluminescent organique selon l'une quelconque des revendications 1 à 8, dans lequel le complexe métallique phosphorescent a une structure représentée par la Formule (I) :

[F1]

Formule (I)

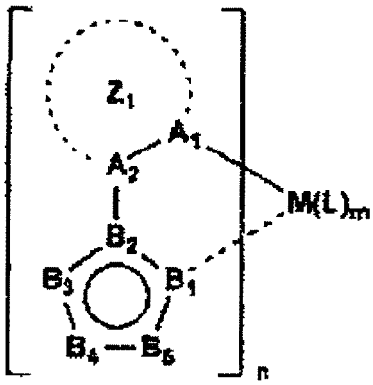

dans laquelle M représente Ir, Pt, Rh, Ru, Ag, Cu, ou Os ; $A_1$ et $A_2$ représentent chacun un atome de carbone ou d'azote ; $Z_1$ représente un cycle hydrocarboné aromatique à 6 chaînons ou un cycle hétérocyclique aromatique à 5 ou à 6 chaînons comportant $A_1$ et $A_2$ ; $B_1$ à $B_5$ sont des atomes formant un groupe hétérocyclique aromatique à 5 chaînons, dont chacun représente un atome de carbone, d'azote, d'oxygène, ou de soufre comportant facultativement un substituant ; le cycle $Z_1$ comporte facultativement un ou plusieurs substituants formant facultativement une structure de cycle condensée ; des ligands sont facultativement reliés ensemble par liaison de substituants des ligands; L représente un ligand bidentate monoanionique se coordinant à M ; m représente un entier de 0 à 2 ; n représente un entier de 1 à 3 ; m + n vaut 2 ou 3 ; et, si m ou n vaut 2 ou plus, le cycle $Z_1$, le groupe hétérocyclique aromatique représenté par $B_1$ à $B_5$, et L sont identiques ou différents les uns des autres.

**10.** Dispositif d'éclairage comprenant l'élément électroluminescent organique selon l'une quelconque des revendications 1 à 9.

**11.** Dispositif d'affichage comprenant l'élément électroluminescent organique selon l'une quelconque des revendications 1 à 9.

# FIG.1

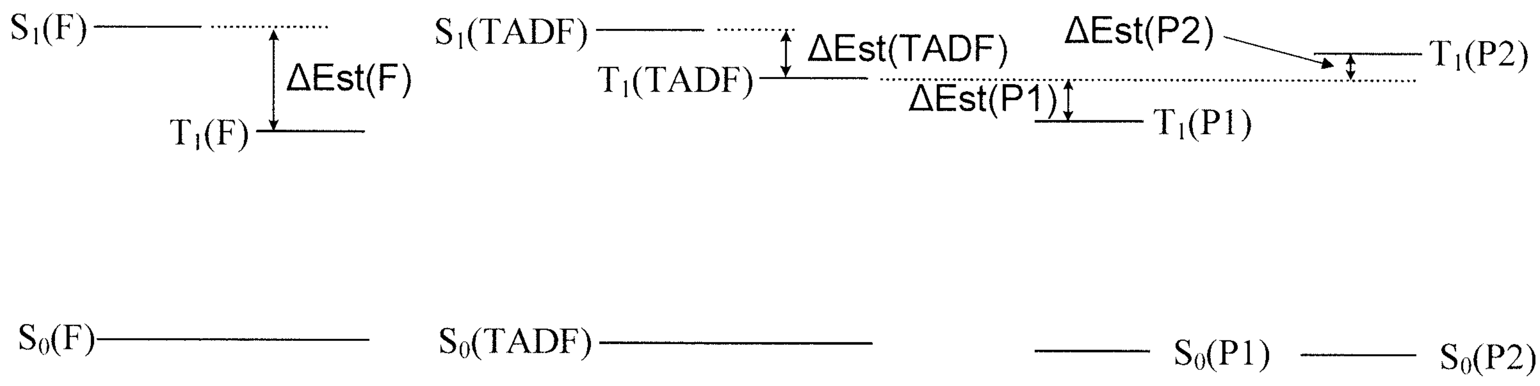


COMMON FLUORESCENT MATERIAL

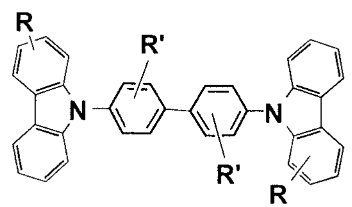

TYPICAL TADF COMPOUND

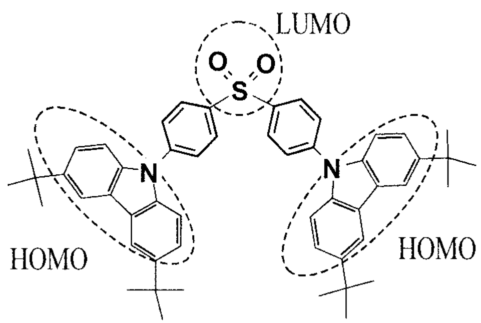


PHOSPHORESCENT METAL COMPLEX P1

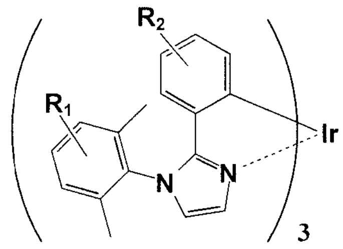

PHOSPHORESCENT METAL COMPLEX P2

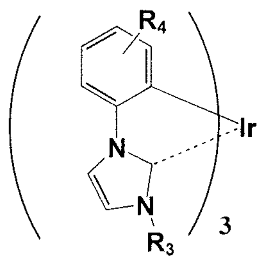

FIG.2

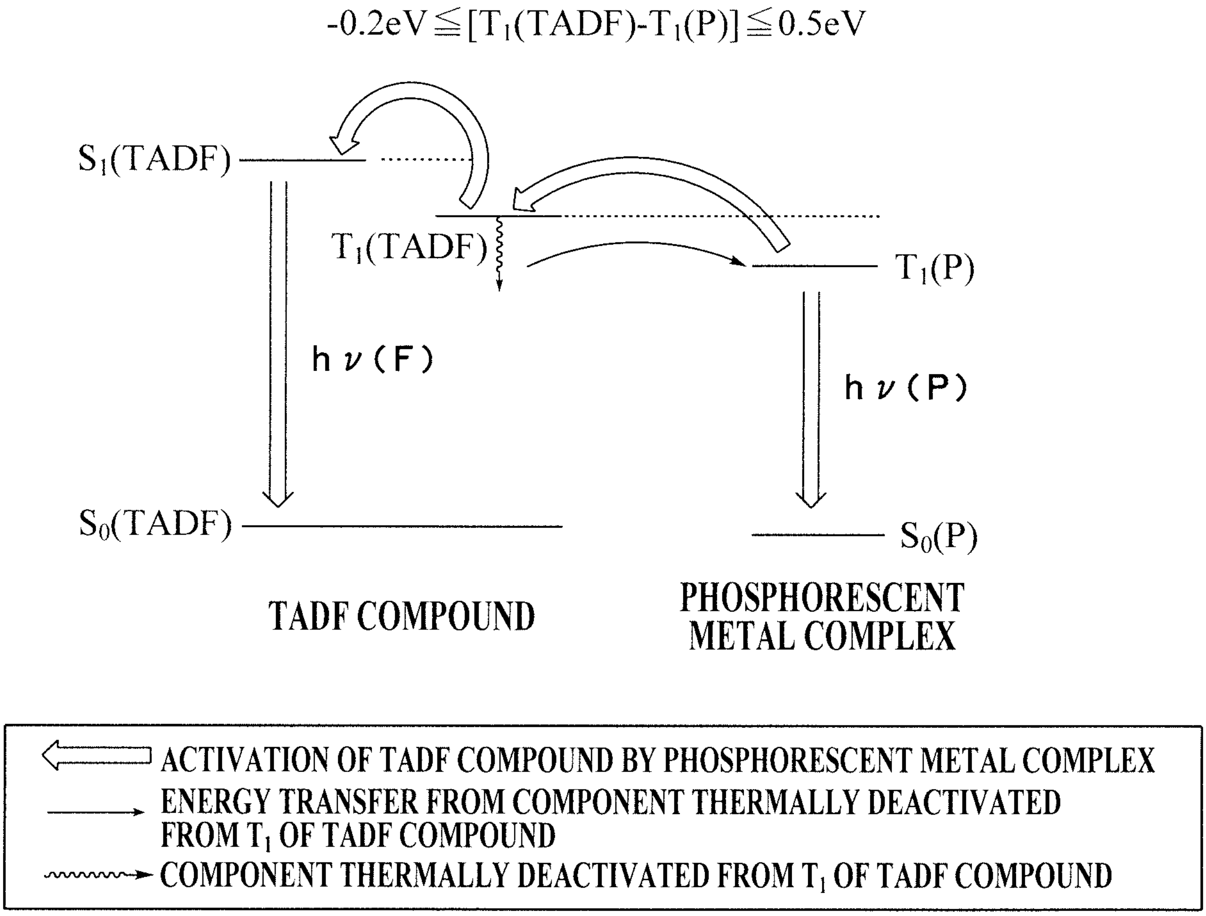
-0.2eV≦[T1(TADF)-T1(P)]≦0.5eV
S1(TADF)
T1(TADF)
T1(P)
hν(F)
hν(P)
S0(TADF)
S0(P)
TADF COMPOUND
PHOSPHORESCENT METAL COMPLEX
ACTIVATION OF TADF COMPOUND BY PHOSPHORESCENT METAL COMPLEX
ENERGY TRANSFER FROM COMPONENT THERMALLY DEACTIVATED FROM T1 OF TADF COMPOUND
COMPONENT THERMALLY DEACTIVATED FROM T1 OF TADF COMPOUND

FIG.3

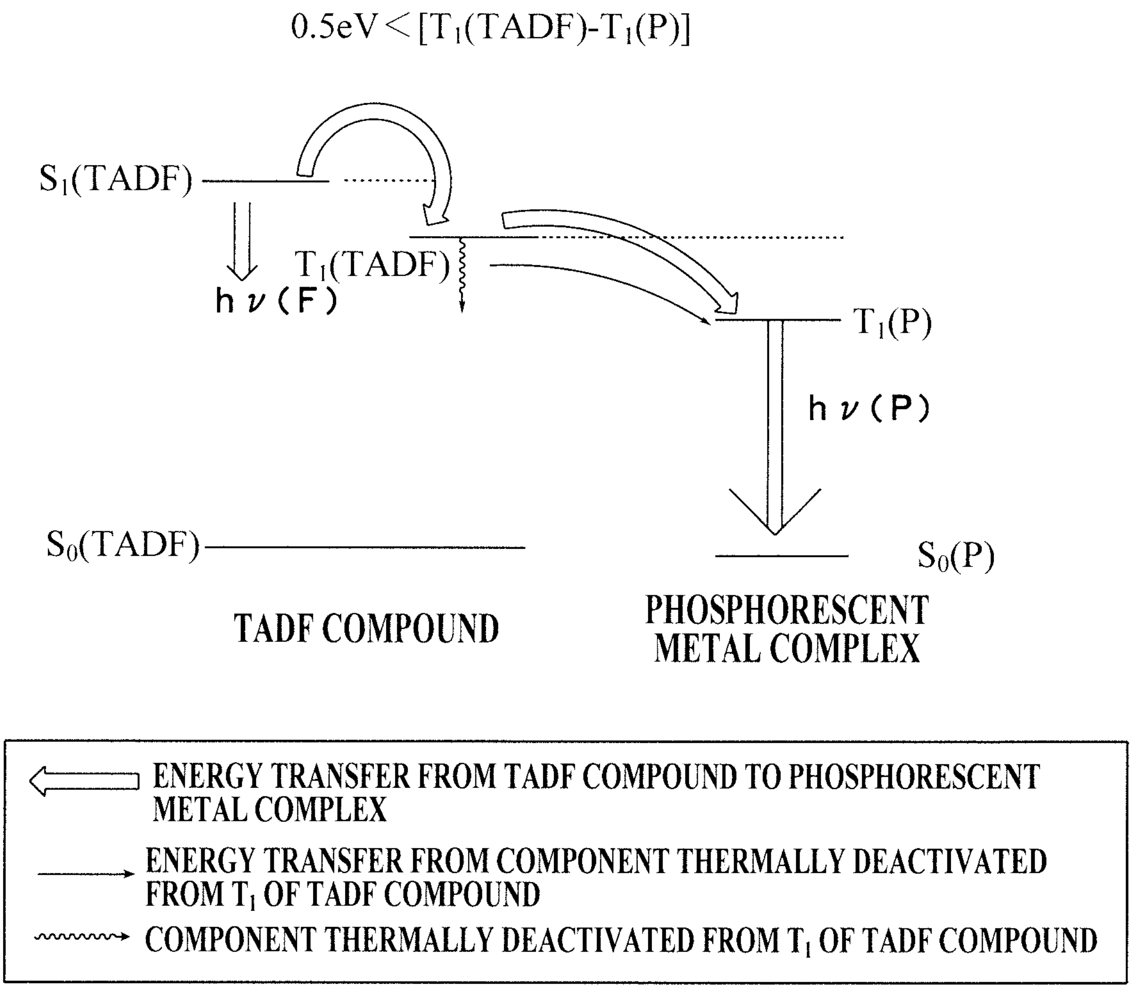
0.5eV < [T1(TADF)-T1(P)]
S1(TADF)
T1(TADF)
hν(F)
T1(P)
hν(P)
S0(TADF)
S0(P)
TADF COMPOUND
PHOSPHORESCENT METAL COMPLEX
ENERGY TRANSFER FROM TADF COMPOUND TO PHOSPHORESCENT METAL COMPLEX
ENERGY TRANSFER FROM COMPONENT THERMALLY DEACTIVATED FROM T1 OF TADF COMPOUND
COMPONENT THERMALLY DEACTIVATED FROM T1 OF TADF COMPOUND

FIG.4

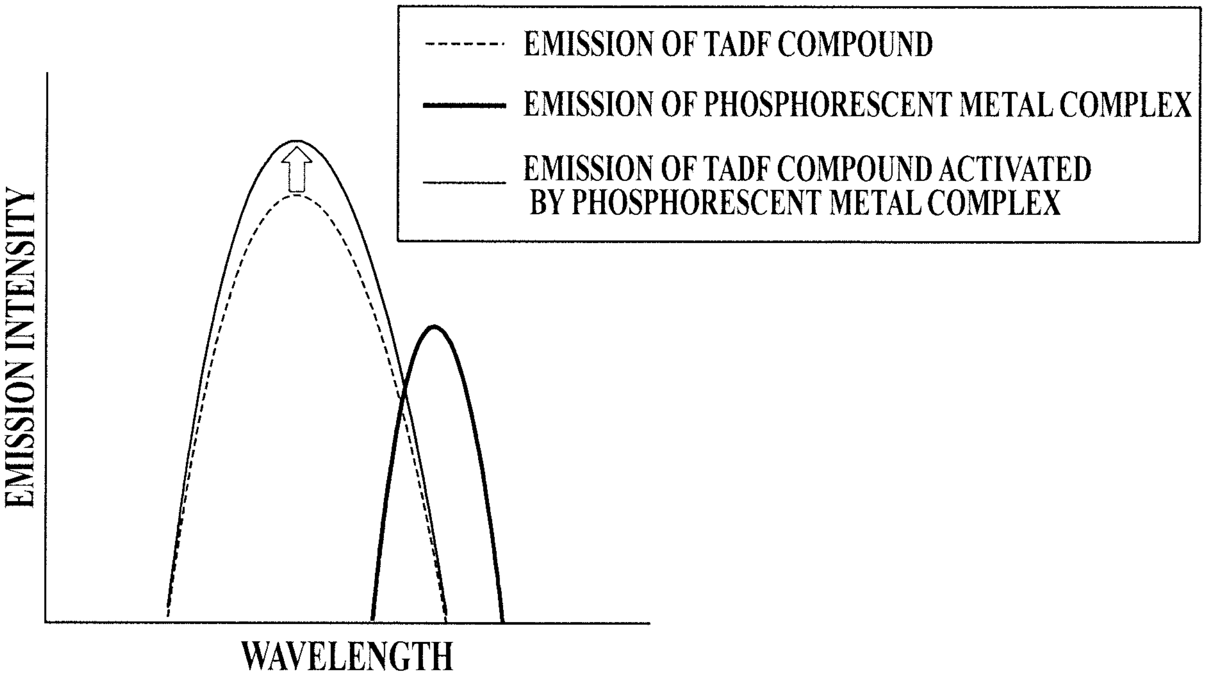
EMISSION OF TADF COMPOUND
EMISSION OF PHOSPHORESCENT METAL COMPLEX
EMISSION OF TADF COMPOUND ACTIVATED BY PHOSPHORESCENT METAL COMPLEX
EMISSION INTENSITY
WAVELENGTH

FIG.5

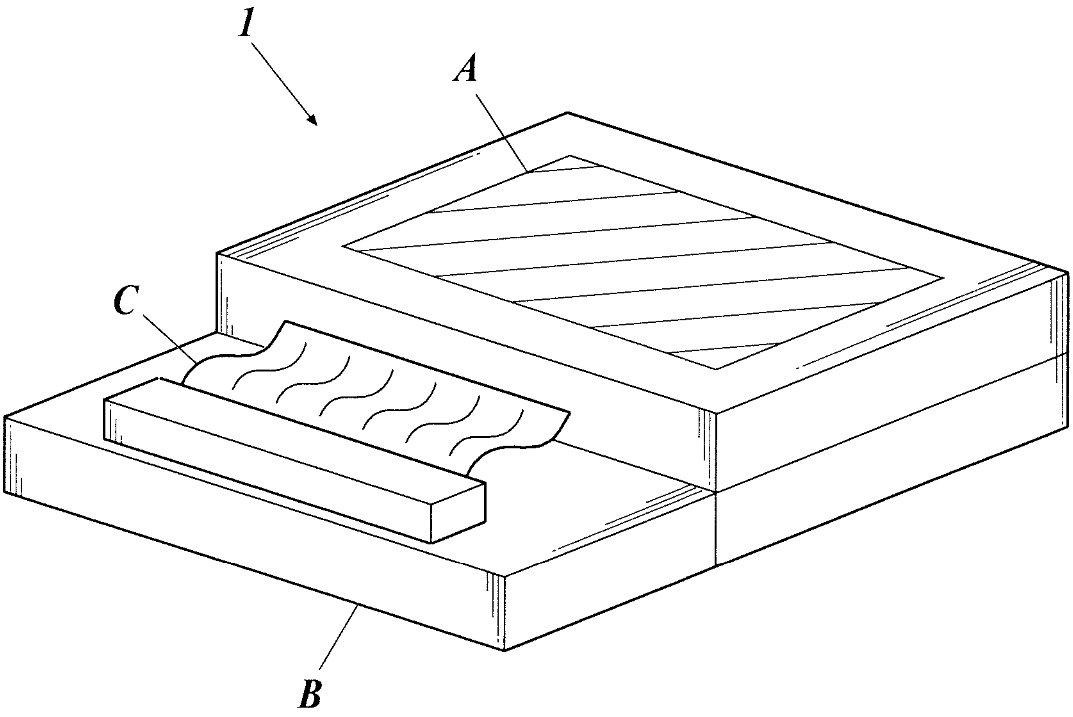
1
A
C
B

FIG.6

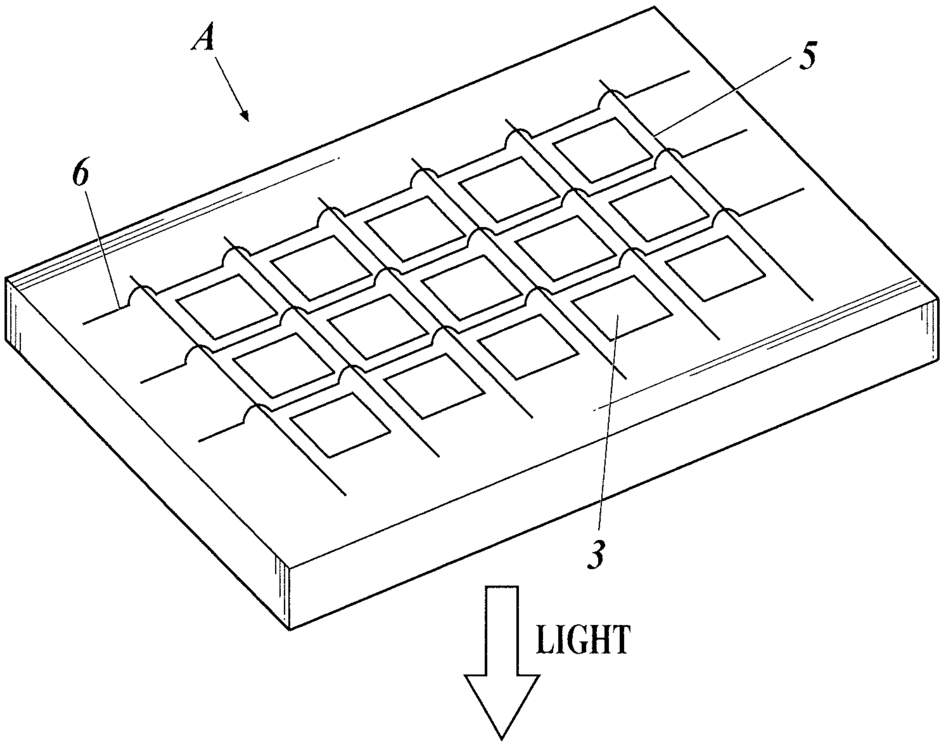


FIG.7

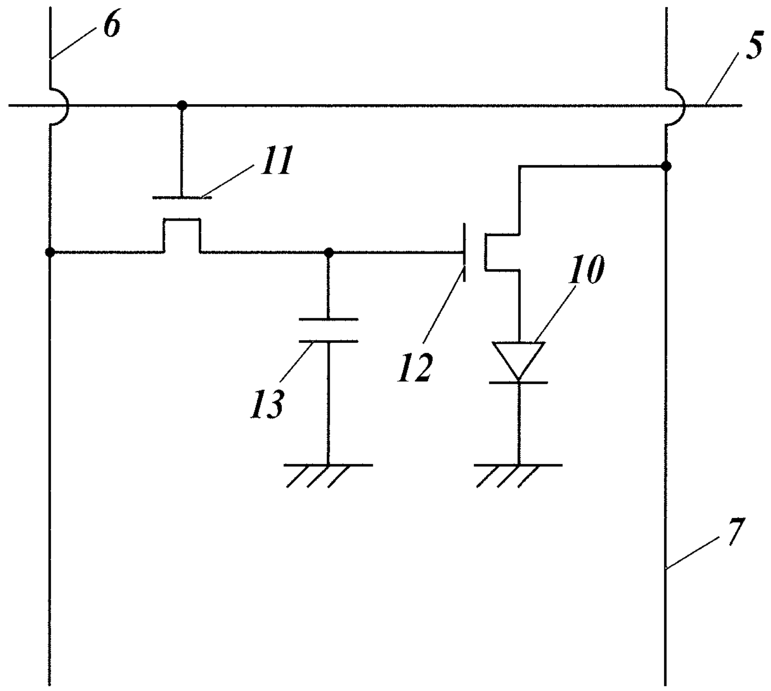

FIG.8

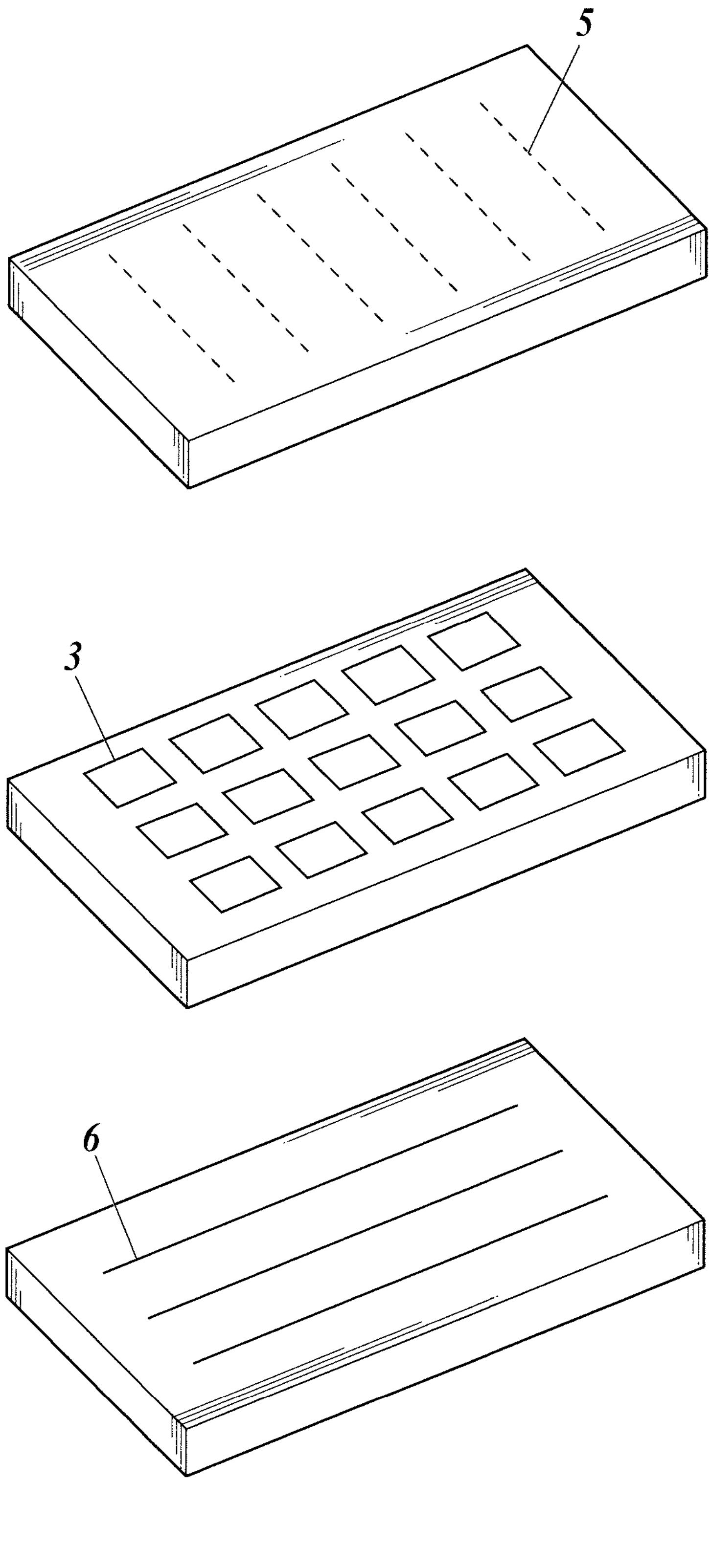

FIG.9

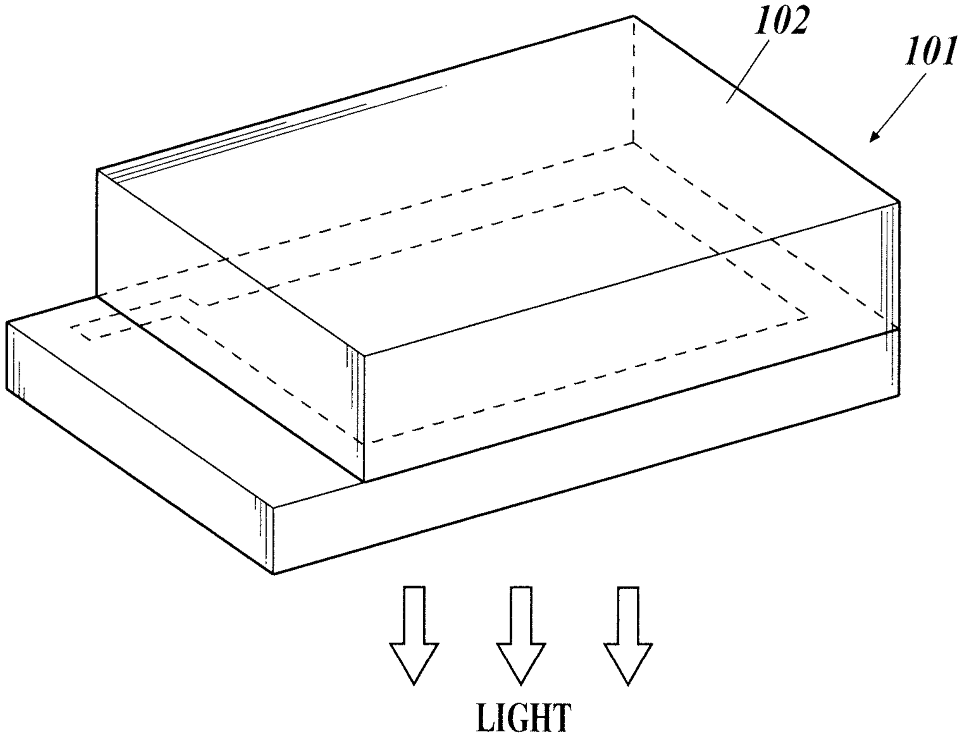


FIG.10

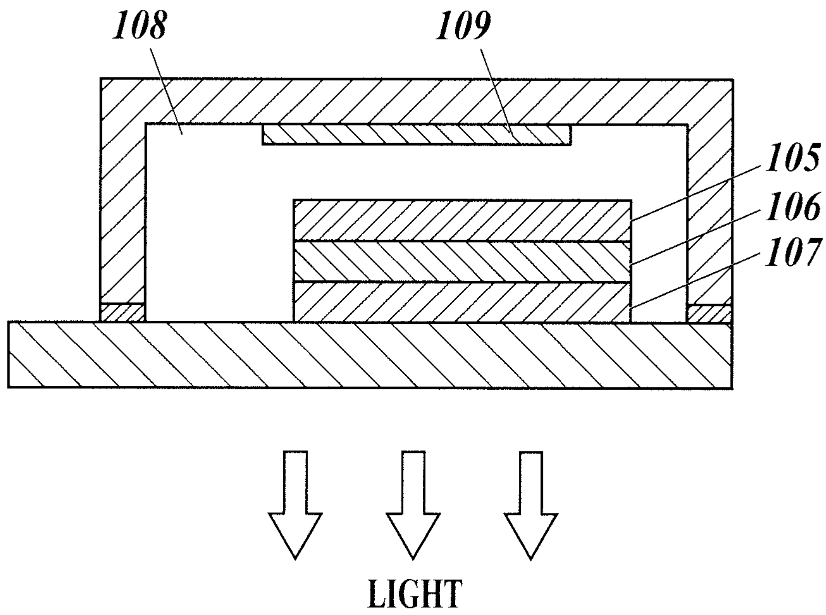

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2012133188 A1
- WO 2011161425 A1
- JP 2011213643 A
- JP 2010114070 A
- US 6337492 B
- US 7420203 B
- US 7473923 B
- US 6872472 B
- US 6107734 A
- WO 2005009087 A
- JP 2006228712 A
- JP 2006024791 A
- JP 2006049393 A
- JP 2006049394 A
- JP 2006049396 A
- JP 2011096679 A
- JP 2005340187 A
- JP 4711424 B
- JP 3496681 B
- JP 3884564 B
- JP 4213169 B
- JP 2010192719 A
- JP 2009076929 A
- JP 2008078414 A
- JP 2007059848 A
- JP 2003272860 A
- JP 2003045676 A
- WO 2005094130 A
- JP H4297076 B
- JP H10270172 B
- JP 2000196140 A
- JP 2001102175 A
- US 6528187 B
- US 7230107 B
- US 20050025993 A
- US 20040036077 A
- US 20090115316 A
- US 20090101870 A
- US 20090179554 A
- WO 2003060956 A
- WO 2008132085 A
- US 7964293 B
- US 2009030202 A
- WO 2004080975 A
- WO 2004063159 A
- WO 2005085387 A
- WO 2006067931 A
- WO 2007086552 A
- WO 2008114690 A
- WO 2009069442 A
- WO 2009066779 A
- WO 2009054253 A
- WO 2011086935 A
- WO 2010150593 A
- WO 2010047707 A
- EP 2311826 A
- JP 2010251675 A
- JP 2009209133 A
- JP 2009124114 A
- JP 2008277810 A
- JP 2006156445 A
- JP 2005340122 A
- JP 2003045662 A
- JP 2003031367 A
- JP 2003282270 A
- WO 2012115034 A
- JP H6325871 B
- JP H917574 B
- JP H1074586 B
- JP 2003519432 W
- JP 2006135145 A
- JP H11251067 B
- US 20030162053 A
- US 20020158242 A
- US 20060240279 A
- US 20080220265 A
- US 5061569 A
- WO 2007002683 A
- WO 2009018009 A
- EP 650955 A
- US 20080124572 A
- US 20070278938 A
- US 20080106190 A
- US 20080018221 A
- US 585981 A
- JP H945479 B
- JP H9260062 B
- JP H8288069 B
- JP 2004068143 A
- US 4774435 A
- JP S63314795 B
- JP H1220394 B
- JP S62172691 B
- JP 2001202827 A
- JP HLL283751 B

**Non-patent literature cited in the description**


- Syoumei ni Muketa Rinkou Yuki EL Gizyutu no Kaihatsu (Development of phosphorescent organic EL technology for lighting). *Oyo Butsuri (Applied Physics),* 2011, vol. 80 (4
- **H. UOYAMA et al.** *Nature,* 2012, vol. 492, 234-238
- **S. Y. LEE et al.** *Applied Physics Letters,* 2012, vol. 101, 093306-093309
- **Q. ZHANG et al.** *J. Am. Chem. Soc.,* 2012, vol. 134, 14706-14709
- **T. NAKAGAWA et al.** *Chem. Commun.,* 2012, vol. 48, 9580-9582
- **A. ENDO et al.** *Adv. Mater.,* 2009, vol. 21, 4802-4806
- *Proceedings of Organic EL Symposium of Japan 10th Meeting,* 2010, 11-12
- *J. Appl. Phys.,* 2004, vol. 95, 5773
- *Appl. Phys. Lett.,* 1999, vol. 75, 4
- *Appl. Phys. Lett.,* 2001, vol. 79, 449
- *Appl. Phys. Lett.,* 2002, vol. 81, 162
- *Appl. Phys. Lett.,* 2001, vol. 79, 156
- Denkyoku Zairyo (Electrode Materials). Yuki EL Soshi to Sono Kogyoka Saizensen (Organic EL element and its forefront of industrialization). NTS Corporation, 30 November 1998, 123-166
- **J. HUANG et al.** *Applied Physics Letters,* 2002, vol. 80, 139
- *Appl. Phys. Lett.,* 1996, vol. 69, 2160
- *J. Lumin.,* 1997, vol. 72-74, 985
- *Appl. Phys. Lett.,* 2001, vol. 78, 673
- *Appl. Phys. Lett.,* 2007, vol. 90, 183503
- *Appl. Phys. Lett.,* 1987, vol. 51, 913
- *Synth. Met.,* 1997, vol. 87, 171
- *Synth. Met.,* 1997, vol. 91, 209
- *Synth. Met.,* 2000, vol. 111, 421
- *SID Symposium Digest,* 2006, vol. 37, 923
- *J. Mater. Chem.,* 1993, vol. 3, 319
- *Adv. Mater.,* 1994, vol. 6, 677
- *Chem. Mater.,* 2003, vol. 15, 3148
- Shinpen Shikisai Kagaku Handobukku (Handbook of Color Science, New Edition). University of Tokyo Press, 1985, 108